# EUROPEAN PATENT APPLICATION

(11) **EP 4 592 753 A2**
(43) Date of publication of application: **30.07.2025**
(21) Application number: 25152751.1
(22) Date of filing: 20.01.2025
(51) Int. Cl.: G03F 7/09, G03F 7/40

(54) **COMPOSITION FOR FORMING METAL-CONTAINING FILM AND PATTERNING PROCESS**

(30) Priority: 23.01.2024 JP 2024008318
(71) Applicant: SHIN-ETSU CHEMICAL CO., LTD., Tokyo 1000005 (JP)
(72) Inventor: Kobayashi, Naoki, Niigata (JP); Ishiwata, Kenta, Niigata (JP); Takizawa, Kanata, Niigata (JP)
(74) Representative: Sonnenhauser, Thomas Martin

(57) **Abstract**

The present invention aims to provide: a composition for forming a metal-containing film having not only excellent dry etching resistance but also high filling/planarizing properties as compared with conventional organic underlayer film materials; and a patterning process using the composition as a resist underlayer film material. Provided is a composition for forming a metal-containing film contains (A) a resin, (B) a metal source, and (C) an organic solvent, wherein the resin (A) contains no phenolic hydroxyl group, and the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

## Description

### TECHNICAL FIELD

The present invention relates to: a composition for forming a metal-containing film usable for fine patterning by a multilayer resist method during semiconductor apparatus manufacturing processes; and a patterning process using the composition.

### BACKGROUND ART

As higher integration and speed are achieved in LSI, miniaturization of pattern size progresses rapidly. Along with this miniaturization, lithography techniques have achieved formation of a fine pattern by shortening a wavelength of a light source and appropriately selecting a resist composition corresponding thereto. A positive photoresist composition used in a single layer has been the key to this achievement. This single-layer positive photoresist composition contains a resist resin, which has a skeleton having etching resistance against dry etching with chlorine or fluorine gas plasma and has a switching mechanism to cause dissolution of an exposed portion, such that an exposed portion is dissolved to form a pattern and a substrate to be processed is processed by dry etching while using the remaining resist pattern as an etching mask.

However, miniaturing, that is, reducing pattern width, while maintaining film thickness of a photoresist film for use has caused a problem of degraded resolution performance of the photoresist film, and pattern development of the photoresist film with a developer has caused a problem of a so-called high aspect ratio, resulting in pattern collapse. Therefore, thickness of the photoresist film has been decreased as the pattern has been miniaturized.

Meanwhile, commonly used for processing a substrate to be processed is a method of processing a substrate by dry etching while using a photoresist film having a formed pattern as an etching mask. However, in reality, there is no dry etching method capable of securing complete etch selectivity between the photoresist film and the substrate to be processed. Hence, there has been a problem that the photoresist film is also damaged and collapses during processing of the substrate, making it impossible to accurately transfer the resist pattern to the substrate to be processed. Accordingly, as miniaturization of a pattern has progressed, higher dry etching resistance has been required for a photoresist composition. On the other hand, a resin used in the photoresist composition has been required to absorb less light at an exposure wavelength to enhance resolution. Therefore, as exposure light has been changed to the one having a shorter wavelength, such as i-line, KrF, and ArF, the resin also has been changed to a novolak resin, polyhydroxystyrene, and a resin having an aliphatic polycyclic skeleton. However, in reality, an etch rate has been increasing under dry etching conditions during processing of a substrate, and recent photoresist compositions having high resolution tend to have rather weak etching resistance.

Accordingly, a substrate to be processed should be processed by dry etching with a thinner photoresist film having weaker etching resistance, and it has become an urgent matter to secure a material and a process for this processing step.

One of methods to solve such problems is a multilayer resist method. This method includes: interposing a resist middle layer film having different etch selectivity from that of a photoresist film (i.e. a resist upper layer film) between the resist upper layer film and a substrate to be processed; giving a pattern in the resist upper layer film, followed by transferring the pattern to the resist middle layer film by dry etching while using the resist upper layer film pattern as a dry etching mask; and further transferring the pattern to the substrate to be processed by dry etching while using the resist middle layer film as a dry etching mask.

One of the multilayer resist methods is a three-layer resist method that can be performed by using a common resist composition used in a single-layer resist method. In this three-layer resist method, for example, an organic film of a novolak resin or the like is deposited on a substrate to be processed as a resist underlayer film; a silicon-containing resist middle layer film is deposited thereon as a resist middle layer film; and a common organic photoresist film is formed thereon as a resist upper layer film. When dry etching is performed with fluorine gas plasma, the organic resist upper layer film can have good etch selectivity to the silicon-containing resist middle layer film and thus, the resist upper layer film pattern can be transferred to the silicon-containing resist middle layer film by dry etching with the fluorine gas plasma. According to this method, the pattern can be transferred to the silicon-containing resist middle layer film (resist middle layer film) even by using a resist composition which makes it difficult to form a pattern having film thickness sufficient for directly processing the substrate to be processed or a resist composition having dry etching resistance insufficient for processing the substrate. Subsequently transferring the pattern by dry etching with oxygen or hydrogen gas plasma can yield an organic film (resist underlayer film) pattern of the novolak resin or the like having dry etching resistance sufficient for processing the substrate. As the aforementioned resist underlayer film, many materials such as those described in Patent Document 1, for example, have already been known.

On the other hand, in recent years, with the rapid miniaturization of a DRAM memory, there is a growing need for further improvement in dry etching resistance, as well as a need for a resist underlayer film having excellent filling and planarizing properties. A coating-type organic underlayer film material having excellent filling and planarizing properties has been disclosed in Patent Document 2, etc., for example. However, in view of state-of-the-art application thereof, there is a concern about dry etching resistance, and the application of the conventional coating-type organic underlayer film materials is approaching the limit.

To address the above problems, development of the use of a material containing metal elements for a resist underlayer film has been studied. Patent Document 3 has disclosed that a material using a Ti compound exhibits excellent dry etching resistance to CHF₃/CF₄ gas and CO₂/N₂ gas.

On the other hand, a problem with the use of a metal compound for a resist underlayer film is a filling property. Although the filling property is not mentioned in Patent Document 3, a metal oxide compound generally undergoes large thermal shrinkage during baking and induces significant degradation of the filling property after baking at a high temperature. Therefore, there is a concern that such a compound is not good enough as a resist underlayer film material for which high planarizing and filling properties and heat resistance are required. Patent Documents 4 and 5 have disclosed that a metal compound modified with a specific ligand has an excellent filling property. However, the baking temperature was a low temperature of 150°C in the performed filling property evaluation, and there is a concern that the compound is not good enough as a resist underlayer film for which heat resistance is required (for example, a property against heat treatment which may be performed after formation of the resist underlayer film).

On this matter, a composition for forming a metal oxide film in which a high carbon polymer is added to metal oxide nanoparticles has been proposed (Patent Documents 5, 6). Patent Document 5 has disclosed that by using metal oxide nanoparticles having less thermal shrinkage in a metal oxide compound, a filling property of the metal oxide compound can be improved. However, since a film formed using metal nanoparticles has crystallinity, there is a risk of degraded line width roughness (LWR) of a pattern during etching of a substrate to be processed if nanoparticles are used in the resist underlayer film material.

In Patent Documents 7 and 8, resist materials with a metal salt or an organic metal complex added thereto have been considered. For these materials, phenolic resins are mentioned for the purpose of facilitating crosslinking of the resist materials. However, a phenolic hydroxyl group has a problem of stability with the metal salt and the organic metal complex. Additionally, performances such as heat resistance, filling/planarizing properties, and dry etching resistance are required for the resist underlayer film, and thus different material design from the above is necessary.

### CITATION LIST

### PATENT LITERATURE

Patent Document 1: JP 2004-205685 A
Patent Document 2: JP 6714493 B
Patent Document 3: JP 6342998 B
Patent Document 4: JP 5756134 B
Patent Document 5: JP 7008075 B
Patent Document 6: JP 6587516 B
Patent Document 7: JP 5708521 B
Patent Document 8: JP 5708522 B

### SUMMARY OF INVENTION

### TECHNICAL PROBLEM

In view of the above circumstances, the present invention aims to provide: a composition for forming a metal-containing film having not only excellent dry etching resistance but also high filling/planarizing properties as compared with conventional organic underlayer film materials; and a patterning process using the composition as a resist underlayer film material.

### SOLUTION TO PROBLEM

To achieve the above object, the present invention provides a composition for forming a metal-containing film, containing (A) a resin, (B) a metal source, and (C) an organic solvent,
wherein the resin (A) contains no phenolic hydroxyl group, and
the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

Such composition for forming a metal-containing film can provide a resist underlayer film material that has excellent dry etching resistance, undergoes small volume shrinkage during baking, and has excellent planarizing/filling properties even after baking at high temperature. Furthermore, since the resin (A) contains no phenolic hydroxyl group, the composition can provide a resist under layer film material excellent in storage stability.

Additionally, the resin (A) preferably contains one or more crosslinking groups selected from a substituted or unsubstituted vinyl group, allyl group, allyloxy group, ethynyl group, propargyl group, propargyloxy group, epoxy group, or oxetanyl group.

Such composition for forming a metal-containing film enables to achieve both of thermal flowability and a thermosetting property at high level, thereby providing a resist underlayer film material exhibiting more excellent planarizing/filling properties.

Additionally, the resin (A) preferably contains an aromatic ring, an alicyclic hydrocarbon, or a heteroaromatic ring, and contains any crosslinking group represented by the following formulae (1), 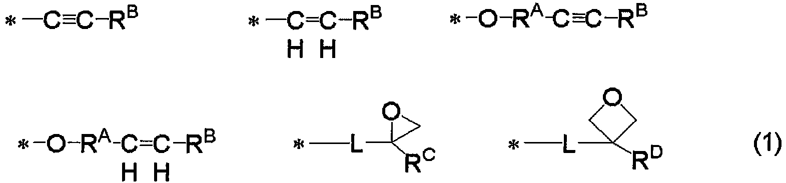 wherein * represents a bonding position to the aromatic ring, the alicyclic hydrocarbon, or the heteroaromatic ring; R^{A} represents a divalent organic group having 1 to 10 carbon atoms; R^{B} represents a hydrogen atom or a monovalent organic group having 1 to 10 carbon atoms; R^{C} and R^{D} represent any of a hydrogen atom, a hydroxyl group, an alkyl group having 1 to 10 carbon atoms, an aryl group having 1 to 10 carbon atoms, and an alkoxy group having 1 to 10 carbon atoms; and L represents a divalent organic group having 1 to 10 carbon atoms.

Such composition for forming a metal-containing film enables to achieve both of thermal flowability and a thermosetting property at high level, thereby providing a resist underlayer film material exhibiting more excellent planarizing/filling properties.

The metal source (B) is preferably a salt of the metal with a monovalent to tetravalent carboxylic acid having 1 to 30 carbon atoms.

The composition for forming a metal-containing film that contains such metal source (B) enables to form a resist underlayer film having more excellent dry etching resistance. Furthermore, it is preferable from the viewpoints of solubility in a solvent and availability of raw materials.

Additionally, the metal source (B) preferably has a structure represented by the following formula (B-1), 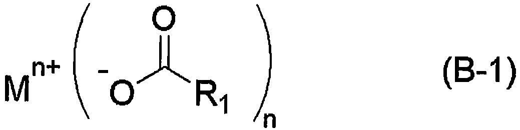 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.

The composition for forming a metal-containing film that contains such metal source (B) can ensure to form a resist underlayer film having excellent dry etching resistance. Furthermore, it is preferable from the viewpoints of solubility in a solvent and availability of raw materials.

Additionally, the metal of the metal source (B) is preferably Sn.

The composition for forming a metal-containing film that contains such metal source (B) is preferable because it can provide a composition for forming a resist underlayer film capable of contributing to sensitivity enhancement while keeping LWR of an upper layer resist.

Additionally, the resin (A) preferably contains at least one of constitutional units represented by the following general formulae (G-1) to (G-5), 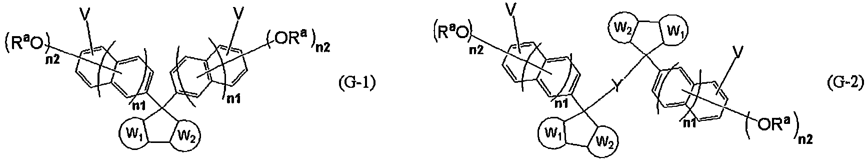 wherein W₁ and W₂ each independently represents a benzene ring or a naphthalene ring, a hydrogen atom in the benzene ring and the naphthalene ring optionally being substituted with a hydrocarbon group having 1 to 6 carbon atoms; R^{a} is represented by the following general formulae (Z-1); Y represents any group represented by the following general formulae (Z-2); "n₁" represents 0 or 1; "n₂" represents 1 or 2; and V each independently represents a hydrogen atom or an attachment point; 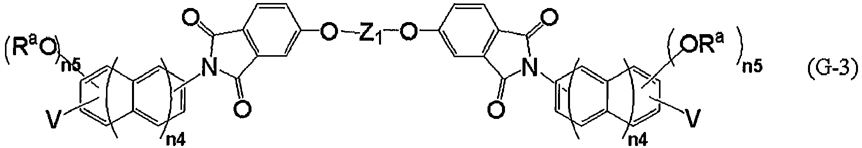 wherein Z₁ represents any group represented by the following general formulae (Z-3); R^{a} is represented by the following general formulae (Z-1); "n₄" represents 0 or 1; "n₅" represents 1 or 2; and V each independently represents a hydrogen atom or an attachment point; 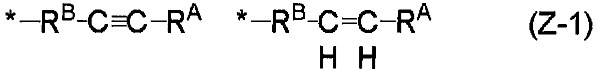 wherein * represents a bonding position to an oxygen atom; R^{B} represents a divalent organic group having 1 to 10 carbon atoms; and R^{A} represents a hydrogen atom or a monovalent organic group having 1 to 10 carbon atoms; 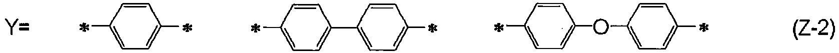 wherein * represents a bonding arm; 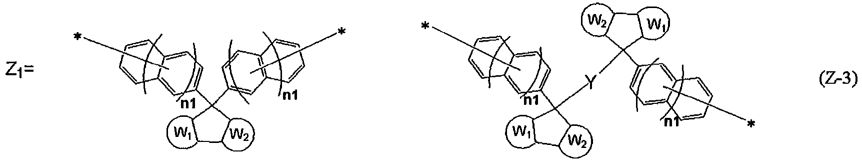 wherein * represents a bonding arm; and W₁, W₂, Y, and "n₁" are as defined above; 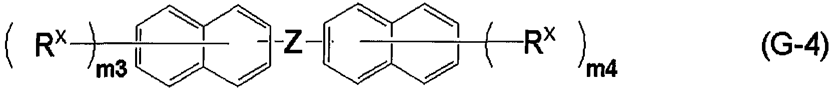 wherein "m₃" and "m₄" represent 1 or 2; Z represents a single bond or any structure represented by the following general formulae (Z-4); and R^{x} represents any structure represented by the following general formulae (Z-5); 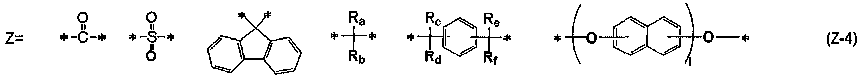 wherein * represents a bonding arm; "l" represents an integer of 0 to 3; Rₐ to R_{f} each independently represents a hydrogen atom or an optionally fluorinated alkyl group having 1 to 10 carbon atoms, phenyl group, or phenylethyl group, where Rₐ and R_{b} optionally bond together to form a cyclic compound; 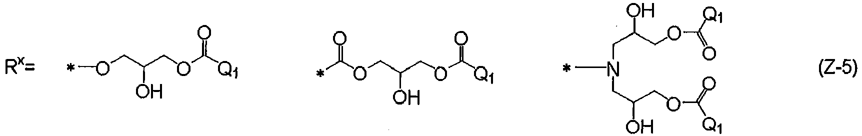 wherein * represents a bonding position to an aromatic ring; and Q₁ represents a linear saturated hydrocarbon group having 1 to 30 carbon atoms, or a structure represented by the following general formula (Z-6); 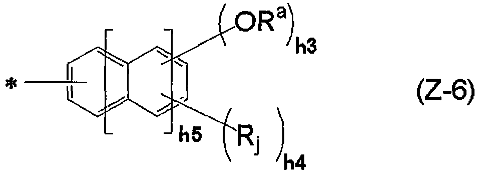 wherein * represents a bonding position to a carbonyl group; R^{a} is represented by the general formulae (Z-1); Rⱼ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; "hs" and "h₄" represent the number of substituents on an aromatic ring, and each represents an integer of 0 to 7, provided that h₃+h₄ is 0 or more and 7 or less; and "hs" represents 0 to 2; 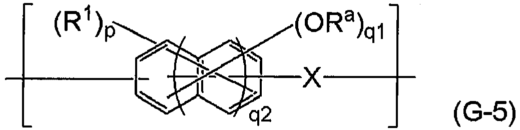 wherein R¹ represents a saturated monovalent organic group having 1 to 30 carbon atoms, or an unsaturated monovalent organic group having 2 to 30 carbon atoms; X represents a divalent organic group having 1 to 30 carbon atoms; R^{a} is represented by the general formulae (Z-1); "p" represents an integer of 0 to 5, "q₁" represents an integer of 1 to 6, and p+q₁ equals an integer of 1 or more and 6 or less; and "q₂" represents 0 or 1.

In such composition for forming a metal-containing film, thermal flowability thereof can be further enhanced, leading to enhanced properties of filling and planarizing a stepped substrate. Furthermore, when using the composition directly below a resist upper layer film, it is possible to form a resist underlayer film excellent in adhesiveness to the resist upper layer film.

Additionally, the composition can further contain one or more of (D) a crosslinking agent, (E) an acid generator, (F) a surfactant, and (G) a colorant.

To the composition for forming a metal-containing film of the present invention, these components can be added as necessary.

The organic solvent (C) is preferably a mixture of one or more kinds of organic solvents having a boiling point of less than 180°C and one or more kinds of organic solvents having a boiling point of 180°C or higher ((C') a high-boiling-point solvent).

Since addition of the high-boiling-point solvent imparts flowability to the above composition for forming a metal-containing film, it is possible to prevent application defects due to dryness of the composition for forming a metal-containing film.

The present invention also provides a patterning process for forming a pattern in a substrate to be processed, including steps of:
(I-1) applying the above composition for forming a metal-containing film on the substrate to be processed and thereafter performing heat treatment to form a metal-containing film;
(1-2) forming a resist upper layer film on the metal-containing film using a photoresist material;
(I-3) forming a pattern in the resist upper layer film by developing the resist upper layer film using a developer after pattern exposure;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process with the above two-layer resist process is capable of forming a fine pattern in a workpiece (substrate to be processed).

The present invention also provides a patterning process for forming a pattern in a substrate to be processed, including steps of:
(II-1) applying the above composition for forming a metal-containing film on the substrate to be processed and thereafter performing heat treatment to form a metal-containing film;
(II-2) forming a silicon-containing resist middle layer film on the metal-containing film;
(II-3) forming a resist upper layer film on the silicon-containing resist middle layer film using a photoresist material;
(II-4) forming a pattern in the resist upper layer film by developing the resist upper layer film using a developer after pattern exposure;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

The patterning process with the above three-layer resist process is capable of forming a fine pattern in a workpiece with high precision.

The present invention also provides a patterning process for forming a pattern in a substrate to be processed, including steps of:
(III-1) applying the above composition for forming a metal-containing film on the substrate to be processed and thereafter performing heat treatment to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film using a photoresist material;
(III-5) forming a pattern in the resist upper layer film by developing the resist upper layer film using a developer after pattern exposure;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process with the above four-layer resist process is capable of forming a fine pattern in a workpiece with high precision.

The present invention also provides a patterning process for forming a pattern in a substrate to be processed, including steps of:
(IV-1) applying the above composition for forming a metal-containing film on the substrate to be processed and thereafter performing heat treatment to form a metal-containing film;
(IV-2) forming an organic middle layer film on the metal-containing film;
(IV-3) forming a silicon-containing resist middle layer film or a combination of an inorganic hard mask middle layer film selected from a silicon oxide film, a silicon nitride film, and a silicon oxynitride film and an organic thin film on the organic middle layer film;
(IV-4) forming a resist upper layer film on the silicon-containing resist middle layer film or the organic thin film using a photoresist material;
(IV-5) forming a pattern in the resist upper layer film by developing the resist upper layer film using a developer after pattern exposure;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film as a mask; and
(IV-9) processing the substrate to be processed while using the metal-containing film having the formed pattern as a mask to form the pattern in the substrate to be processed.

The patterning process with the above multilayer resist process is capable of forming a fine pattern in a workpiece with high precision.

The present invention also provides a patterning process for forming a tone-reversal pattern in a substrate to be processed, including steps of:
(V-1) forming a resist underlayer film on the substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film using a photoresist material;
(V-4) forming a pattern in the resist upper layer film by developing the resist upper layer film using a developer after pattern exposure;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the above composition for forming a metal-containing film on the resist underlayer film having the formed pattern, and thereafter performing heat treatment to cover with the metal-containing film and fill an in-between space in the pattern of the resist underlayer film with the metal-containing film; (V-8) etching back the metal-containing film covering over the resist underlayer film having the formed pattern by a chemical stripper or dry etching to expose an upper surface of the resist underlayer film having the formed pattern;
(V-9) removing the resist middle layer film or the hard mask middle layer film remaining on the upper surface of the resist underlayer film by dry etching;
(V-10) removing the resist underlayer film having the formed pattern with its surface exposed by dry etching to form a reverse pattern of an original pattern, the reverse pattern being formed of the metal-containing film; and
(V-11) processing the substrate to be processed while using the metal-containing film having the formed reverse pattern as a mask to form the reverse pattern in the substrate to be processed.

The patterning process with the above reverse process is capable of forming a fine pattern in a workpiece with even higher precision.

Additionally, the pattern exposure is preferably performed using EUV light in the step (I-3).

Additionally, the pattern exposure is preferably performed using EUV light in the step (II-4).

Additionally, the pattern exposure is preferably performed using EUV light in the step (III-5).

Additionally, the pattern exposure is preferably performed using EUV light in the step (IV-5).

Additionally, the pattern exposure is preferably performed using EUV light in the step (V-4).

Since the composition for forming a metal-containing film of the present invention contains a metal atom with high optical absorption, it enables to form a resist underlayer film capable of contributing to sensitivity enhancement while keeping LWR of an upper layer resist in EUV lithography.

### ADVANTAGEOUS EFFECTS OF INVENTION

Such composition for forming a metal-containing film can provide a resist underlayer film with a high metal content, because the metal salt structure is decomposed by heat treatment to cause metal ion desorption, thereby forming a metal oxide. Additionally, since the composition is mixed with the resin (A), it is possible to provide a resist underlayer film material that undergoes small volume shrinkage during baking and has excellent planarizing/filling properties even after baking at high temperature. Furthermore, since the resin (A) contains no phenolic hydroxyl group, it is possible to provide the composition for forming a metal-containing film excellent in stability.

Additionally, since the resist underlayer film formed using the composition for forming a metal-containing film of the present invention contains a large number of metal atoms with high optical absorption, it has a feature that a sensitizing effect can be expected due to secondary electrons generated from these metal atoms during exposure in EUV lithography. Furthermore, since the above metal atom has a large atomic weight, it has features of a high suppression effect on acid diffusion from the upper layer resist into the resist underlayer film, and ability to increase sensitivity while maintaining the inherent LWR performance of the resist upper layer film.

Furthermore, since high etch selectivity between a resist underlayer film and an organic material can be obtained, a formed photoresist pattern can successively be transferred from a metal-containing resist underlayer film to an organic underlayer film or a CVD organic hard mask by using a dry etching process. Particularly, in recent semiconductor apparatus manufacturing processes that progress toward miniaturization, film thickness of a photoresist film tends to be decreased in order to prevent pattern collapse after development, thereby making it difficult to transfer a pattern to a resist underlayer film. However, by using the composition for forming a metal-containing film of the present invention, it is possible to suppress deformation of a photoresist pattern during dry etching while using even a thin photoresist film as an etching mask, and transfer this pattern to a substrate with high precision.

### BRIEF DESCRIPTION OF DRAWINGS

FIG. 1 is a diagram illustrating a patterning process according to an embodiment of the present invention (three-layer resist process);
FIG. 2 is a diagram illustrating a patterning process according to an embodiment of the present invention (tone-reversal patterning process);
FIG. 3 is a diagram illustrating an evaluation method of a filling property; and
FIG. 4 is a diagram illustrating an evaluation method of a planarizing property.

### DESCRIPTION OF EMBODIMENTS

As described above, it has been demanded to develop: a composition for forming a metal-containing film excellent in filling and planarizing properties, the composition being used for forming a resist underlayer film that enables to transfer a resist pattern to a substrate to be processed with higher precision in a fine patterning process with a multilayer resist method; a compound for forming a metal-containing film useful for the composition; and a patterning process using the composition.

The present inventors focused on a metal material exhibiting more excellent etching resistance than conventional resist underlayer film materials, and made an intensive investigation. Meanwhile, conventional metal compounds for forming a resist underlayer film have poor heat resistance and undergo rapid volume shrinkage during baking, making it difficult to fill and planarize steps of a substrate to be processed after baking at high temperature.

The present inventors have considered that a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone undergoes small volume shrinkage during baking, and a combination thereof with a resin enables to fill steps of a substrate to be processed with no generation of voids after baking at high temperature. Furthermore, the present inventors have found that if the resin has a structure containing no phenolic hydroxyl group, it is possible to provide a composition for forming a metal-containing film excellent in storage stability, and completed the present invention.

Thus, the present invention is a composition for forming a metal-containing film, containing (A) a resin, (B) a metal source, and (C) an organic solvent, wherein the resin (A) contains no phenolic hydroxyl group, and the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

Hereinafter, the present invention will be described in detail. However, the present invention is not limited thereto.

### <Composition for Forming Metal-Containing Film>

The composition for forming a metal-containing film of the present invention contains (A) a resin, (B) a metal source, and (C) an organic solvent, wherein the resin (A) contains no phenolic hydroxyl group, and the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

### <(A) Resin>

The resin (A) contained in the composition for forming a metal-containing film of the present invention is a resin containing no phenolic hydroxyl group.

The composition for forming a metal-containing film that contains such resin can provide a composition for forming a metal-containing film excellent in storage stability.

Furthermore, the resin (A) preferably contains one or more crosslinking groups selected from a substituted or unsubstituted vinyl group, allyl group, allyloxy group, ethynyl group, propargyl group, propargyloxy group, epoxy group, or oxetanyl group.

It is possible to enhance a thermosetting property of the resin by containing such crosslinking groups. When using this resin in the composition for forming a metal-containing film, it is possible to reduce volume shrinkage during baking at high temperature, and provide a resist underlayer film material having excellent filling/planarizing properties.

Preferably, the resin (A) contains an aromatic ring, an alicyclic hydrocarbon, or a heteroaromatic ring, and contains any crosslinking group represented by the following formulae (1), 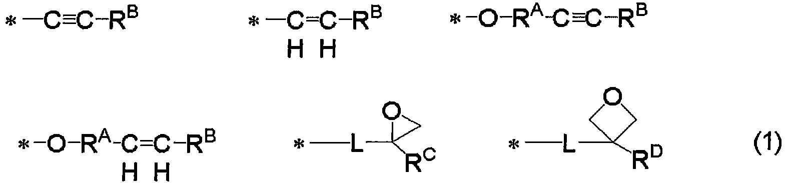 wherein * represents a bonding position to the aromatic ring, the alicyclic hydrocarbon, or the heteroaromatic ring; R^{A} represents a divalent organic group having 1 to 10 carbon atoms; R^{B} represents a hydrogen atom or a monovalent organic group having 1 to 10 carbon atoms; R^{C} and R^{D} represent any of a hydrogen atom, a hydroxyl group, an alkyl group having 1 to 10 carbon atoms, an aryl group having 1 to 10 carbon atoms, and an alkoxy group having 1 to 10 carbon atoms; and L represents a divalent organic group having 1 to 10 carbon atoms.

In the above formulae, R^{A} represents a divalent organic group having 1 to 10 carbon atoms, more preferably an alkylene group having 1 to 10 carbon atoms, and further preferably a methylene group. R^{B} represents a hydrogen atom or a monovalent organic group having 1 to 10 carbon atoms, preferably a hydrogen atom or any structure represented by the following formulae (R^{B}-1) from the viewpoints of a thermosetting property and flowability. R^{C} and R^{D} preferably represent any of a hydrogen atom, a hydroxyl group, an alkyl group having 1 to 10 carbon atoms, an aryl group having 1 to 10 carbon atoms, and an alkoxy group having 1 to 10 carbon atoms, more preferably represent an alkyl group having 1 to 10 carbon atoms, and further preferably represent a methyl group or an ethyl group. L represents a divalent organic group having 1 to 10 carbon atoms, more preferably any structure represented by the following formulae (L-1). 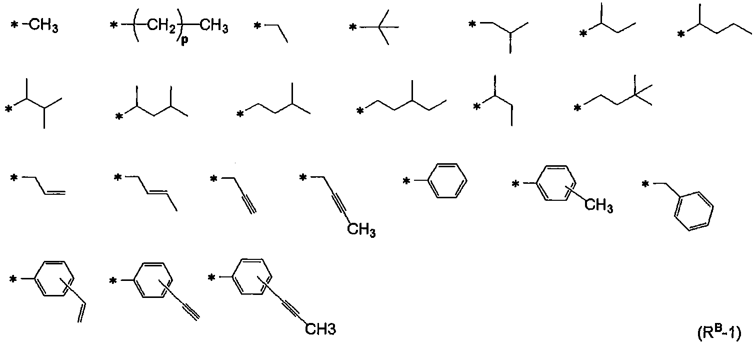 (In the above formulae, "p" represents an integer of 0 to 9; and * represents a bonding position.) 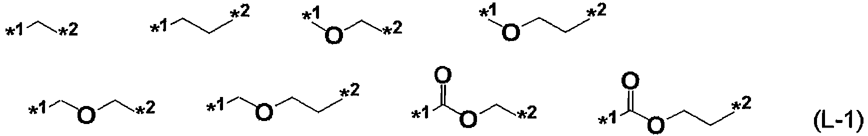 (In the above formulae, *¹ represents a bonding position to the aromatic ring, the alicyclic hydrocarbon, or the heteroaromatic ring; and *² represents a bonding position to a carbon atom of an epoxy ring and an oxetane ring.)

The resin (A) contains an aromatic ring, an alicyclic hydrocarbon, or a heteroaromatic ring such that the resin has enhanced heat resistance. When using this resin in the composition for forming a metal-containing film, it is possible to reduce volume shrinkage during baking at high temperature, and provide a resist underlayer film material having excellent filling/planarizing properties. Furthermore, the resin has an enhanced thermosetting property by containing the above crosslinking groups. When using this resin in the composition for forming a metal-containing film, it is possible to further reduce volume shrinkage during baking at high temperature, and provide a resist underlayer film material having excellent filling/planarizing properties.

Examples of the aromatic ring, alicyclic hydrocarbon, or heteroaromatic ring contained in the resin (A) include the following structures, 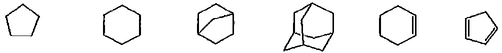 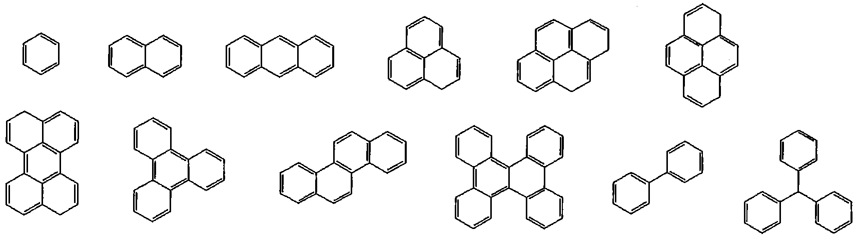 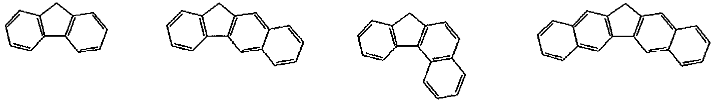 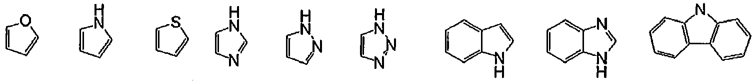 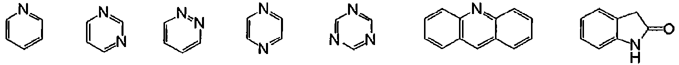 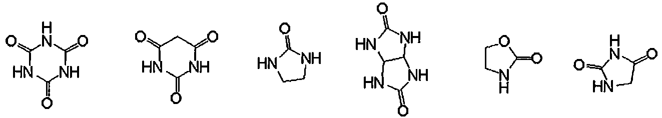 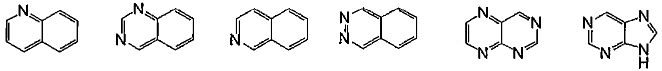 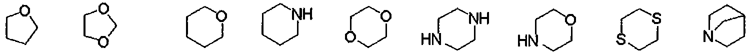 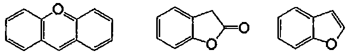 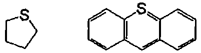 wherein a hydrogen atom may be substituted with a monovalent organic group having 1 to 20 carbon atoms.

The above resin (A) has a ratio Mw/Mn (i.e. dispersity) of a weight average molecular weight Mw to a number average molecular weight Mn as determined by a gel permeation chromatography method in terms of polystyrene, that falls within a range of preferably 1.00≤Mw/Mn≤1.25, further preferably 1.00≤Mw/Mn≤1.10. By definition, Mw/Mn is 1.00 in a case of a monomolecular compound, but a measured value may exceed 1.00 for reasons of separativeness in GPC. Generally, it is extremely difficult to bring Mw/Mn close to 1.00 in a polymer having a repeating unit unless a special polymerization method is used, and Mw/Mn becomes a value greater than 1 with a distribution of Mw. In the present invention, 1.00≤Mw/Mn≤1.10 is defined as an index indicating a monomolecular property in order to distinguish between a monomolecular compound and a polymer.

The compound having the dispersity within this range can impart more favorable thermal flowability to the composition for forming a metal-containing film. Thus, by using this compound in the composition for forming a metal-containing film, it is possible to provide a resist underlayer film material having excellent filling/planarizing properties.

The above resin (A) is preferably a polymer having a weight average molecular weight of 1,000 to 12,000 in terms of polystyrene determined by a gel permeation chromatography method, and further preferably Mw is 2,000 to 10,000.

The molecular weight within such range can secure solubility in an organic solvent, and prevent generation of sublimates during baking. Furthermore, the composition for forming a metal-containing film exhibits favorable thermal flowability. Thus, by using this compound in the composition for forming a metal-containing film, it is possible to provide a resist underlayer film material having excellent filling/planarizing properties.

The resin (A) preferably contains at least one of constitutional units represented by the following general formulae (G-1) to (G-5).

### (Constitutional Units: G-1, G-2, and G-3)

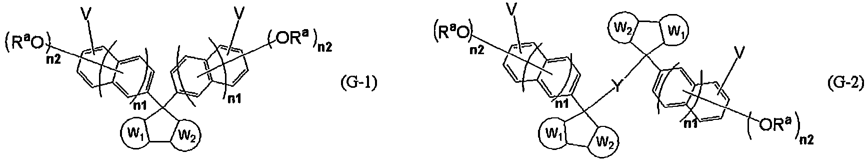

(In the formulae, W₁ and W₂ each independently represents a benzene ring or a naphthalene ring, a hydrogen atom in the benzene ring and the naphthalene ring optionally being substituted with a hydrocarbon group having 1 to 6 carbon atoms; R^{a} is represented by the following general formulae (Z-1); Y represents any group represented by the following general formulae (Z-2); "n₁" represents 0 or 1; "n₂" represents 1 or 2; and V each independently represents a hydrogen atom or an attachment point.)

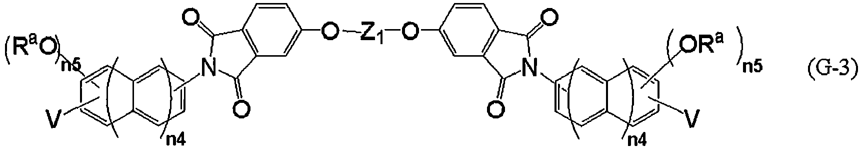

(In the formula, Z₁ represents any group represented by the following general formulae (Z-3); R^{a} is represented by the following general formulae (Z-1); "n₄" represents 0 or 1; "n₅" represents 1 or 2; and V each independently represents a hydrogen atom or an attachment point.)

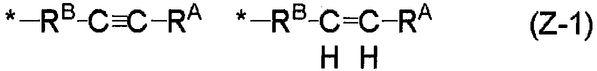

(In the formulae, * represents a bonding position to an oxygen atom; R^{B} represents a divalent organic group having 1 to 10 carbon atoms; and R^{A} represents a hydrogen atom or a monovalent organic group having 1 to 10 carbon atoms.) 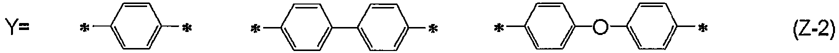 (* represents a bonding arm.) 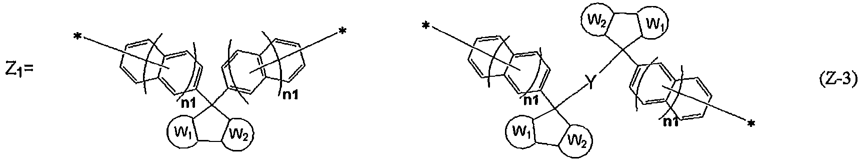 (In the formulae, W₁, W₂, Y, and "n₁" are as defined above.)

In the resin having the constitutional units represented by the above general formulae (G-1), (G-2), and (G-3), a condensed carbon ring containing a cardo structure with a high carbon density is introduced. Thus, the resin enables to form a resist underlayer film having excellent dry etching resistance and heat resistance.

In the above general formulae (G-1), (G-2), and (G-3), the R^{a} is represented by the above general formulae (Z-1), and the general formulae (Z-1) preferably have any structure of the following general formulae (2-A). 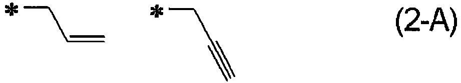 (* represents a bonding position to an oxygen atom.)

Since the organic groups represented by the above general formulae (Z-1), particularly the organic groups represented by the above general formulae (2-A) are contained in the above general formulae (G-1), (G-2), and (G-3), thermal flowability can be more enhanced and a resist underlayer film having excellent filling and planarizing properties can be formed.

The resin having the constitutional units represented by the above general formulae (G-1), (G-2), and (G-3) reduces intermolecular interaction and imparts solubility in an organic solvent due to action of the cardo structure introduced into its molecule, thereby enhancing film formability during forming a coating film. Additionally, since a plurality of condensed carbon rings with a high carbon density is introduced, it is possible to form a resist underlayer film having excellent heat resistance and dry etching resistance.

The resin containing the constitutional units represented by the above general formulae (G-1), (G-2), and (G-3) can be a compound represented by the following general formula (g-1) and/or (g-2) and/or (g-3). 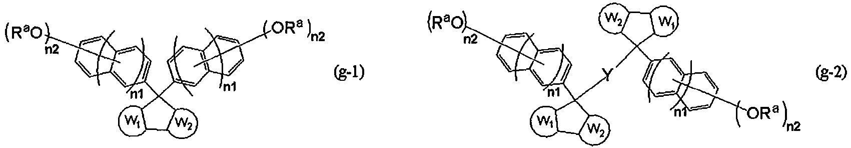 (In the above general formulae (g-1) and (g-2), W₁, W₂, R^{a}, Y, "n₁", and "n₂" are as defined above.) 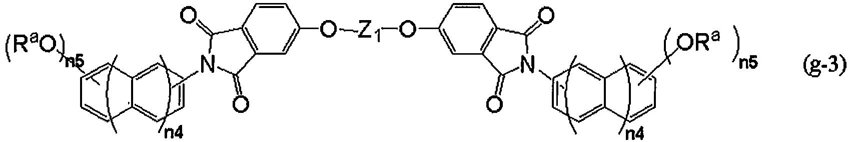 (In the above general formula (g-3), Z₁, R^{a}, "n₄", and "n₅" are as defined above.)

Specific examples of the resin having the constitutional units represented by the above general formulae (g-1), (g-2), and (g-3) include the following compounds, but are not limited thereto.

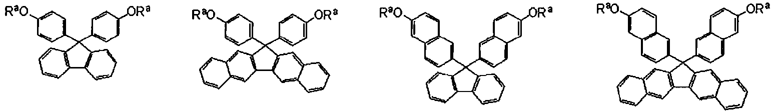

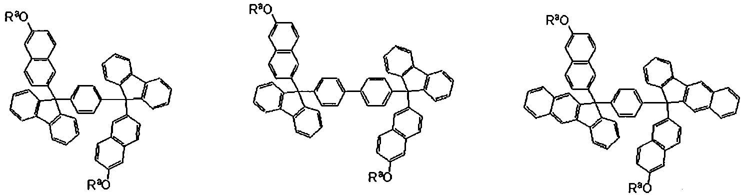

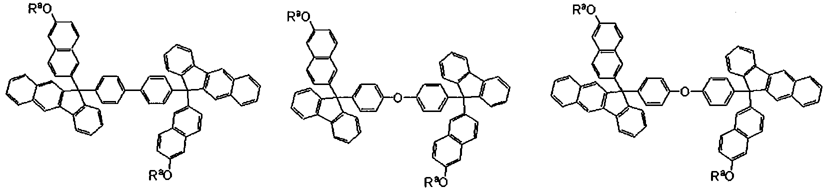

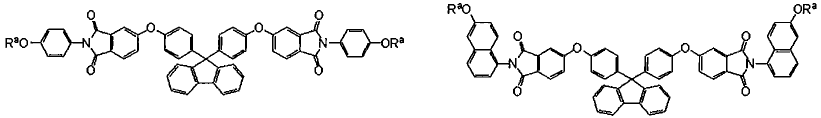

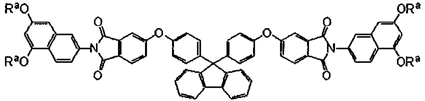

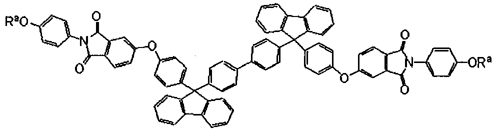

The above resins (g-1), (g-2), and (g-3) have a ratio Mw/Mn (i.e. dispersity) of a weight average molecular weight Mw to a number average molecular weight Mn as determined by a gel permeation chromatography method in terms of polystyrene, that falls within a range of preferably 1.00≤Mw/Mn≤1.25, further preferably 1.00≤Mw/Mn≤1.10.

The compound having the dispersity within this range can impart more favorable thermal flowability to the composition for forming a metal-containing film.

The resin containing the constitutional units represented by the above general formulae (G-1), (G-2), and (G-3) can be a polymer containing a repeating unit represented by the following general formula (g-4) and/or (g-5) and/or (g-6). 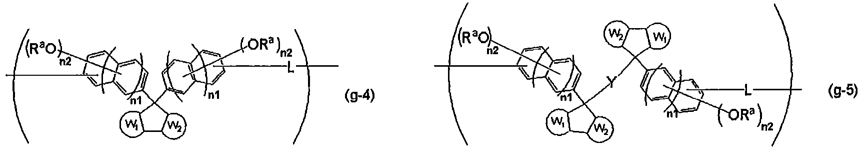 (In the above general formulae (g-4) and (g-5), W₁, W₂, R^{a}, Y, "n₁", and "n₂" are as defined above; and L represents a divalent organic group having 1 to 40 carbon atoms.) 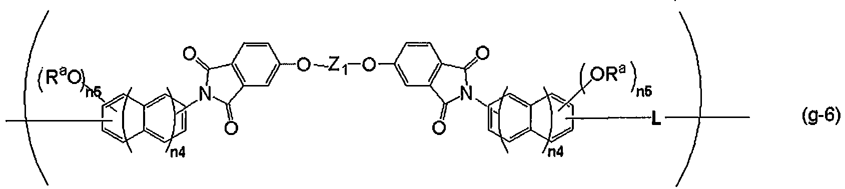 (In the above general formula (g-6), Z₁, R^{a}, "n₄", and "n₅" are as defined above; and L represents a divalent organic group having 1 to 40 carbon atoms.)

These are polymers obtained by using the compounds represented by the above general formulae (g-1), (g-2), and (g-3), and have excellent dry etching resistance and heat resistance because of the use of the compounds. Additionally, since they are not monomers but polymers containing repeating units, the amount of an outgas composition is small; and since they are polymers having a molecular weight distribution, crystallinity is alleviated and improved film formability can also be expected.

L as a linking group constituting the repeating units represented by the above general formulae (g-4), (g-5), and (g-6) is a divalent organic group having 1 to 40 carbon atoms. Specific examples thereof are illustrated below.

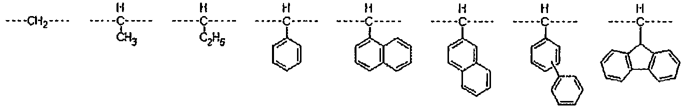

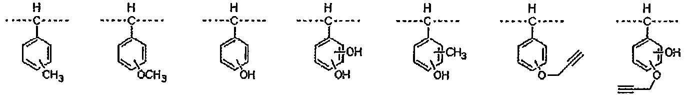

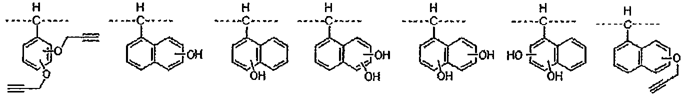

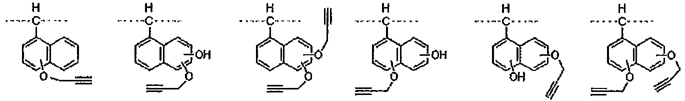

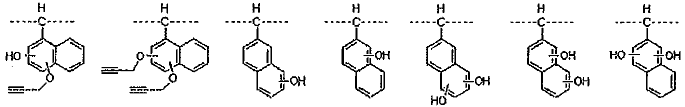

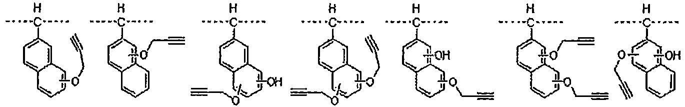

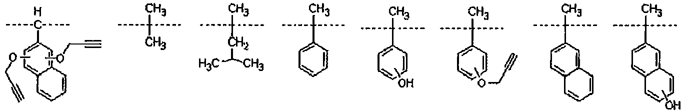

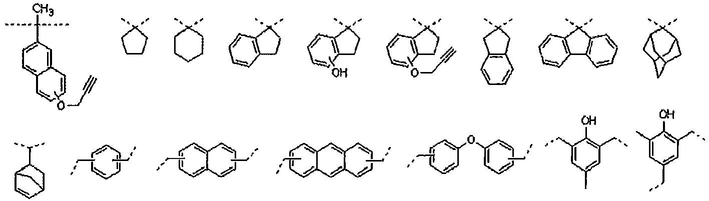

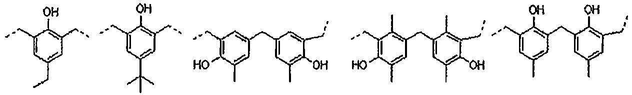

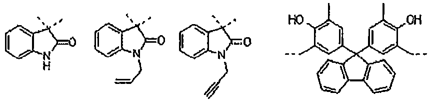

Furthermore, the linking group L of the above polymer is preferably represented by the following general formula (10), 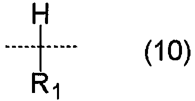 in the above general formula (10), R₁ represents a hydrogen atom or an organic group having 1 to 20 carbon atoms and containing an aromatic ring; and a broken line represents a bonding arm.

Specific examples of the above general formula (10) are illustrated below, among which a methylene group is preferred from the viewpoint of availability of raw materials, that is, R₁ preferably represents a hydrogen atom.

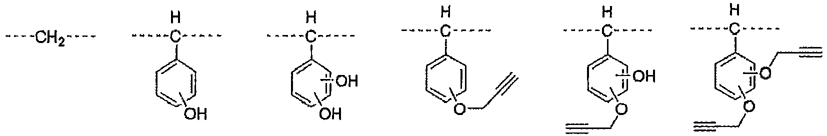

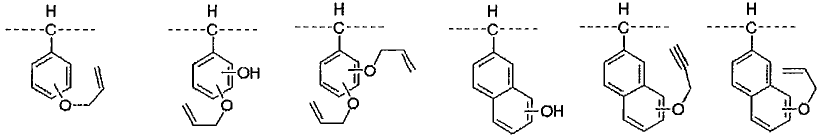

Furthermore, the polymer containing the repeating structural units represented by the above general formulae (g-4), (g-5), and (g-6) preferably has a weight average molecular weight Mw of 1,000 to 12,000, and further preferably has Mw of 2,000 to 10,000 as determined by a gel permeation chromatography method in terms of polystyrene.

The molecular weight within such range can secure solubility in an organic solvent, and prevent generation of sublimates during baking. Furthermore, the composition for forming a metal-containing film exhibits favorable thermal flowability.

The resin containing the constitutional units represented by the above general formulae (G-1), (G-2), and (G-3) has a skeleton structure containing a cardo structure, and thus has a high carbon density. Accordingly, the composition for forming a metal-containing film that contains such compound exhibits high dry etching resistance and excellent heat resistance. Furthermore, since the resin contains the organic groups represented by the above general formulae (Z-1) that contribute to enhancing thermal flowability, a resist underlayer film having excellent filling and planarizing properties can be formed. When the compound having the structures respectively represented by the above general formulae (g-1), (g-2), and (g-3) is used, the composition for forming a metal-containing film exhibits more favorable thermal flowability. On the other hand, the polymer containing the constitutional units having the structures respectively represented by the above general formulae (g-4), (g-5), and (g-6) can prevent generation of sublimates during baking, thereby providing the composition for forming a metal-containing film with excellent film thickness uniformity. By mixing the compound having the structures respectively represented by the above general formulae (g-1), (g-2), and (g-3) with the polymer containing the constitutional units respectively represented by the above general formulae (g-4), (g-5), and (g-6), it is possible to provide the composition for forming a metal-containing film according to required properties.

### (Constitutional Unit: G-4)

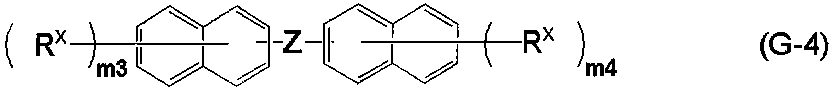

(In the formula, "m₃" and "m₄" represent 1 or 2; Z represents a single bond or any structure represented by the following general formulae (Z-4); and R^{x} represents any structure represented by the following general formulae (Z-5).) 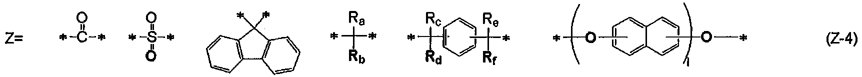 (In the formulae, * represents a bonding arm; "l" represents an integer of 0 to 3; Rₐ to R_{f} each independently represents a hydrogen atom or an optionally fluorinated alkyl group having 1 to 10 carbon atoms, phenyl group, or phenylethyl group, where Rₐ and R_{b} optionally bond together to form a cyclic compound.) 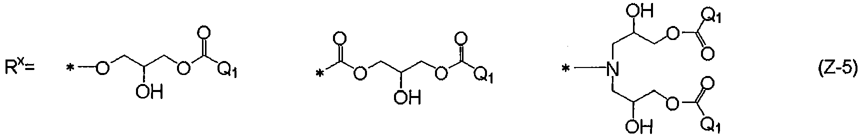 (In the formulae, * represents a bonding position to an aromatic ring; and Q₁ represents a linear saturated hydrocarbon group having 1 to 30 carbon atoms, or a structure represented by the following general formula (Z-6).) 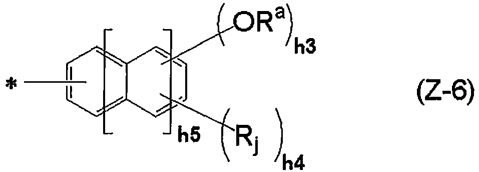 (In the formula, * represents a bonding position to a carbonyl group; R^{a} is represented by the general formulae (Z-1); Rⱼ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; "hs" and "h₄" represent the number of substituents on an aromatic ring, and each represents an integer of 0 to 7, provided that h₃+h₄ is 0 or more and 7 or less; and "h₅" represents 0 to 2.)

From the viewpoints of dry etching resistance and heat resistance, Z in the above general formula (G-4) preferably represents a single bond or any structure represented by the following general formulae (4A), 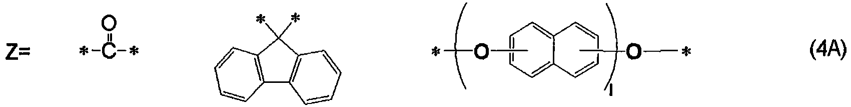 wherein * represents a bonding arm; and "l" is as defined in the above formulae (Z-4).

In the above general formulae (Z-5), * represents a bonding position to an aromatic ring, and Q₁ represents a linear saturated hydrocarbon group having 1 to 30 carbon atoms, or a structure represented by the following general formula (Z-6). When Q₁ represents a linear hydrocarbon group having 1 to 30 carbon atoms, a methylene group of Q₁ may be substituted with an oxygen atom or a carbonyl group. From the viewpoints of dry etching resistance and heat resistance, Q₁ preferably represents the structure represented by the above general formula (Z-6).

The above general formula (G-4) includes the organic groups represented by the above general formulae (Z-1), particularly the organic groups represented by the above general formulae (2-A), so that thermal flowability can further be enhanced.

The compound containing the constitutional unit represented by the above general formula (G-4) has a structure with an aromatic ring linked by a single bond or any of the general formulae (Z-4), and thus has a high carbon density. Accordingly, the composition for forming a metal-containing film containing such compound exhibits high dry etching resistance and excellent heat resistance. Furthermore, the structure of the linking group Z can be selected as appropriate from various linking groups according to desired performances, as shown in the formulae (Z-4). Particularly, by introducing any structure represented by the above formulae (4A) as Z, heat resistance/etching resistance can be provided without impairing film formability. Additionally, since the compound has the highly flexible terminal moiety R^{x}, a thick resist underlayer film can be formed without generating defects such as cracks, even though the compound has a rigid aromatic ring structure. Furthermore, the terminal moiety R^{x} contains the terminal group Q₁ that provides thermal flowability. As the terminal group Q₁, it is possible to introduce a flexible hydrocarbon structure that contributes to enhancing thermal flowability and a rigid aromatic ring structure that contributes to etching resistance and heat resistance in any proportions according to required performances. As described above, the composition for forming a metal-containing film using these compounds can achieve both of film formability and heat resistance/etching resistance at high level, and can form a thick film according to required properties.

### (Constitutional Unit: G-5)

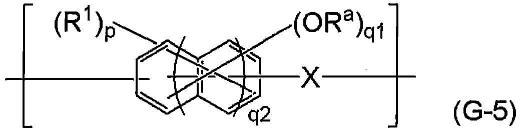

(In the formula, R¹ represents a saturated monovalent organic group having 1 to 30 carbon atoms, or an unsaturated monovalent organic group having 2 to 30 carbon atoms; X represents a divalent organic group having 1 to 30 carbon atoms; R^{a} is represented by the general formulae (Z-1); "p" represents an integer of 0 to 5, "q₁" represents an integer of 1 to 6, and p+q₁ equals an integer of 1 or more and 6 or less; and "q₂" represents 0 or 1.)

Examples of the divalent organic group having 1 to 30 carbon atoms represented by X in the above general formula (G-5) include: alkanediyl groups such as methylene group, ethanediyl group, propanediyl group, butanediyl group, pentanediyl group, hexanediyl group, octanediyl group, and decanediyl group; monocyclic cycloalkanediyl groups such as cyclopropanediyl group, cyclobutanediyl group, cyclopentanediyl group, cyclohexanediyl group, cycloheptanediyl group, cyclooctanediyl group, cyclodecanediyl group, methylcyclohexanediyl group, and ethylcyclohexanediyl group; polycyclic cycloalkanediyl groups such as bicyclo[2.2.1]heptanediyl group, bicyclo[2.2.2] octanediyl group, tricyclo[5.2.1.0^{2,6}]decanediyl group (dicyclopentylene group), tricyclo[3.3.1.1^{3,7}]decanediyl group, tetracyclo[6.2.1.1^{3,6}.0^{2,7}]dodecanediyl group, and adamantanediyl group; arenediyl groups such as phenylene group and naphthylene group; and the like.

Additionally, X may represent an alkanediyloxy group or a cycloalkanediyloxy group. Examples of the alkanediyloxy group represented by the above X include groups containing a combination of the above alkanediyl group and an oxygen atom. Additionally, examples of the cycloalkanediyloxy group represented by the above X include groups containing a combination of the above cycloalkanediyl group and an oxygen atom.

Some or all of hydrogen atoms contained in the above alkanediyl groups, cycloalkanediyl groups, alkanediyloxy groups, cycloalkanediyloxy groups, and arenediyl groups, etc. may be substituted, and examples of the substituent include the same groups as the exemplary substituents that may be contained in the organic group represented by the above R^{a}, etc.

Examples of the organic group represented by the above X include groups represented by the following formulae, etc. 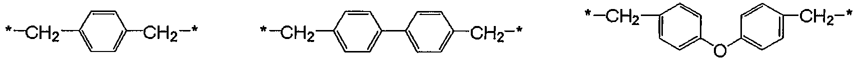 (In the above formulae, * represents a bonding arm.)

As the above X, a methylene group is preferred from the viewpoint of availability of raw materials.

Specific examples of the resin having the structural unit represented by the above general formula (G-5) are illustrated below. 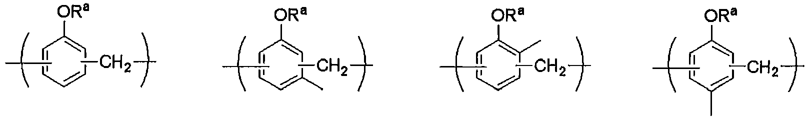 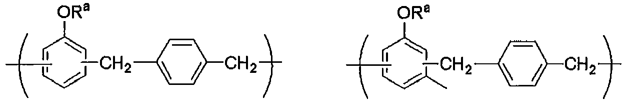 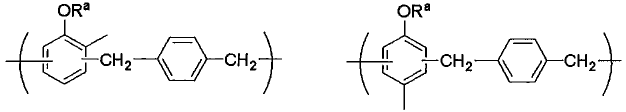 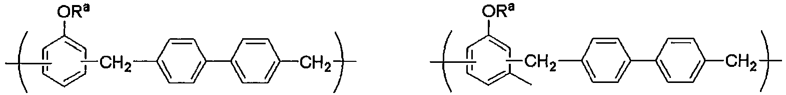 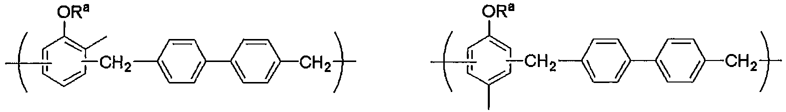 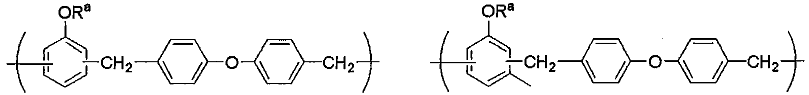 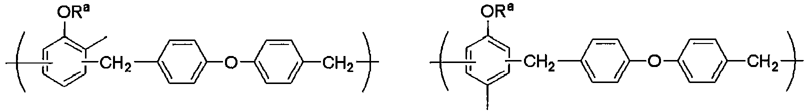 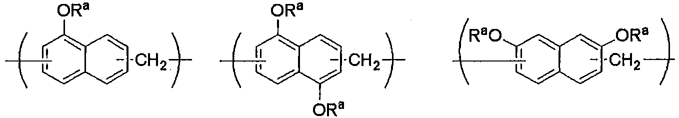 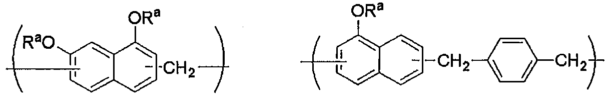 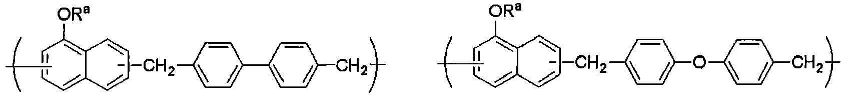 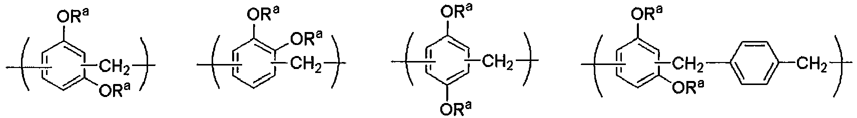 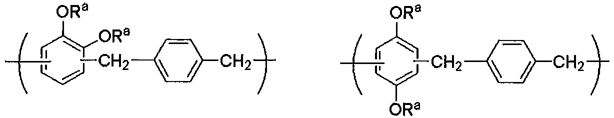 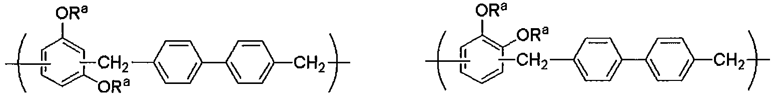 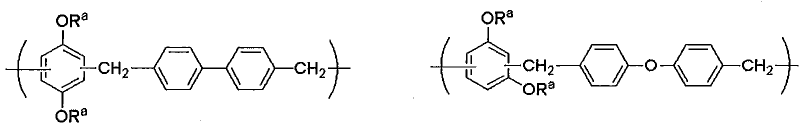 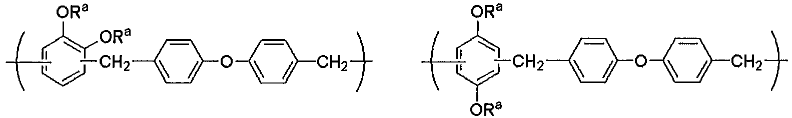 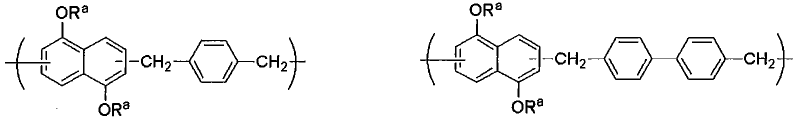 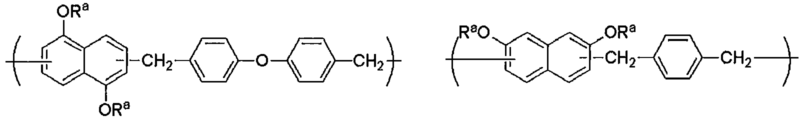 (In the above formulae, R^{a} is as defined above.)

The polymer containing the constitutional unit represented by the above general formula (G-5) has a structure with an aromatic ring linked by the organic group (X), and thus has a high carbon density. Accordingly, the composition for forming a metal-containing film containing such resin exhibits high dry etching resistance and excellent heat resistance, thereby enabling to form a resist underlayer film with less generation of sublimates. Furthermore, the organic group having the structure represented by the above general formula (Z-1) that contributes to enhancing thermal flowability is bonded directly to an aromatic ring via an oxygen atom, the aromatic ring being a mother nucleus structure of the resin. Therefore, the composition for forming a metal-containing film using such polymer can achieve both of film formability and heat resistance/etching resistance at high level. Additionally, the aromatic ring structure of the mother nucleus is not excessively rigid, and forms a repeating structure through the organic group (X) as a linking group; therefore, it enables to form a thick resist underlayer film without generating defects such as cracks. As described above, the composition for forming a metal-containing film using such polymer can achieve both of film formability and heat resistance/etching resistance at high level, and can form a thick film according to required properties.

In the composition for forming a metal-containing film of the present invention, the blending amount of the resin (A) is not particularly limited. For example, it is 0.1 to 50 parts by mass, preferably 1 to 20 parts by mass, and more preferably 2 to 10 parts by mass relative to 100 parts by mass of the organic solvent (C) as described later.

### <(B) Metal Source>

The metal source (B) contained in the composition for forming a metal-containing film of the present invention is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

Preferred examples of the carboxylic acid salt are illustrated below.

| | | | | |
|---|---|---|---|---|
| Ti⁴⁺(R¹COO⁻)₄ | Ti⁴⁺(R²(COO⁻)₂)₂ | Ti⁴⁺R⁴(COO⁻)₄ | | |
| Cr²⁺(R¹COO⁻)₂ | Cr²⁺ R²(COO⁻)₂ | | | |
| Cr³⁺(R¹COO⁻)₃ | (Cr³⁺)₂(R²(COO⁻)₂)₃ | Cr³⁺(R¹COO⁻)(OH)₂ | (Cr³⁺)₂(R³(COO⁻)₃)₂ | |
| Mn²⁺(R¹COO⁻)₂ | Mn²⁺R²(COO⁻)₂ | Mn³⁺(R¹COO⁻)₃ | (Mn3⁺)₂(R²(COO⁻)₂)₃ | |
| Fe²⁺R²(COO⁻)₂ | Fe³⁺(R¹COO⁻)₃ | (Fe³⁺)₂(R²(COO⁻)₂)₃ | Fe³⁺R³(COO⁻)₃ | Fe²⁺(R¹COO⁻)₂ |
| CO²⁺(R¹COO⁻)₂ | Co²⁺R²(COO⁻)₂ | | | |
| Ni²⁺(R¹COO⁻)₂ | Ni²⁺R²(COO⁻)₂ | | | |
| Cu⁺R¹COO⁻ | (Cu⁺)₂R²(COO⁻)₂ | CU²⁺(R¹COO⁻)₂ | Cu²⁺R²(COO⁻)₂ | |
| Zn⁺R¹COO⁻ | (Zn⁺)₂ R²(COO⁻)₂ | Zn²⁺(R¹COO⁻)₂ | | |
| Zr⁴⁺(R¹COO⁻)₄ | Zr⁴⁺(R²(COO⁻)₂)₂ | Zr⁴⁺R⁴(COO⁻)₄ | | |
| Mo⁴⁺(R¹COO⁻)₄ | | | | |
| In³⁺(R¹COO⁻)₃ | (In³⁺)₂(R²(COO⁻)₂)₃ | In³⁺R³(COO⁻)₃ | | |
| Sn²⁺(R¹COO⁻)₂ | Sn²⁺R²(COO⁻)₂ | Sn⁴⁺(R¹COO⁻)₄ | Sn⁴⁺(R²(COO⁻)₂)₂ | Sn⁴⁺R⁴(COO⁻)₄ |
| Hf⁴⁺(R¹COO⁻)₄ | Hf⁴⁺(R²(COO⁻)₂)₂ | Hf⁴⁺R⁴(COO⁻)₄ | | |
| Bi³⁺(R¹COO⁻)₃ | (Bi³⁺)₂ (R²(COO⁻)₂)₃ | Bi³⁺R³(COO⁻)₃ | | |

(In the formulae, R¹ may be identical to or different from each other, and represents hydrogen atom, linear, branched, or cyclic alkyl group having 1 to 30 carbon atoms, preferably 1 to 20 carbon atoms, alkenyl group having 2 to 30 carbon atoms, preferably 2 to 20 carbon atoms, alkynyl group having 2 to 30 carbon atoms, preferably 2 to 20 carbon atoms, or aryl group having 6 to 30 carbon atoms, preferably 6 to 20 carbon atoms, each of these optionally having a hydroxy group, ether group, ester group, amino group, amide group, sulfonic acid ester group, halogen atom, cyano group, nitro group, carbonate group, carbamate group, thiol group, sulfide group, thioketone group, or heteroaromatic ring; R² represents a single bond, or a linear, branched, or cyclic alkylene group, alkenylene group, or alkynylene group each having 1 to 30 carbon atoms, preferably 1 to 20 carbon atoms, or an arylene group having 6 to 30 carbon atoms, preferably 6 to 20 carbon atoms, each of these optionally having a hydroxy group, ether group, ester group, amino group, amide group, sulfonic acid ester group, halogen atom, cyano group, nitro group, carbonate group, carbamate group, thiol group, sulfide group, thioketone group, or heteroaromatic ring; R³ represents a group obtained by removing one hydrogen atom from the alkylene group, arylene group, alkenylene group, or alkynylene group of the R²; and R⁴ represents a group obtained by removing two hydrogen atoms from the alkylene group, arylene group, alkenylene group, or alkynylene group of the R².)

Specific examples of carboxylic acid ions for forming the carboxylic acid salt in the above general formulae are illustrated below.

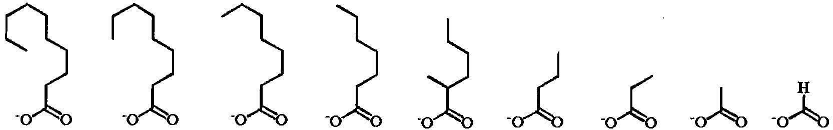

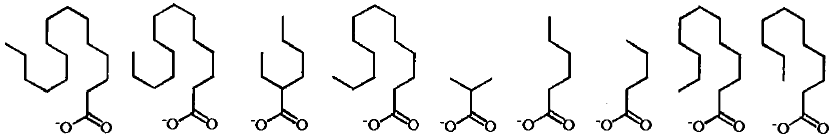

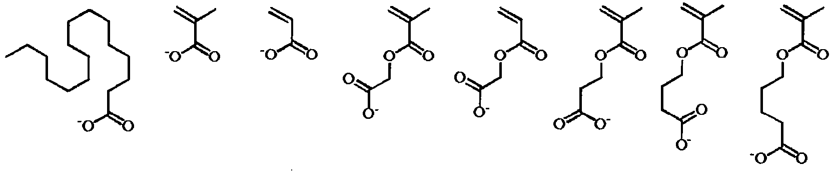

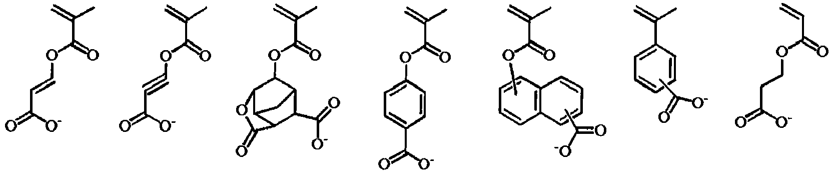

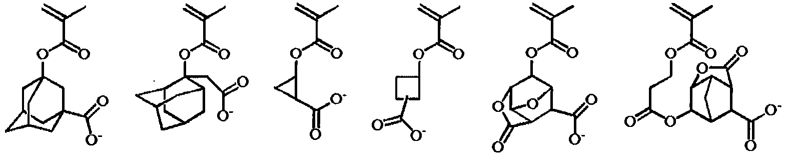

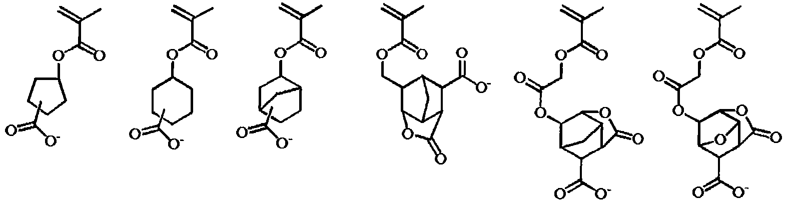

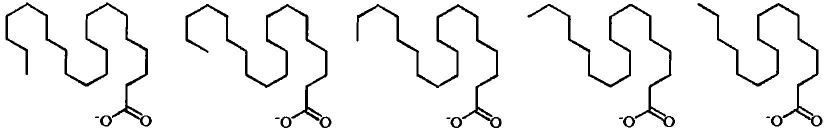

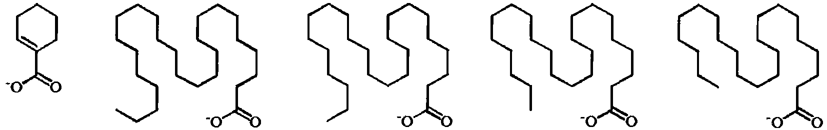

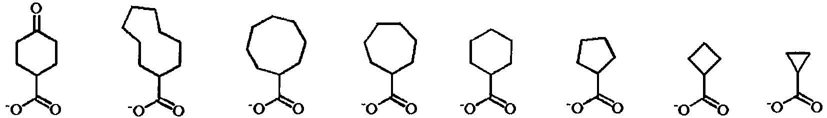

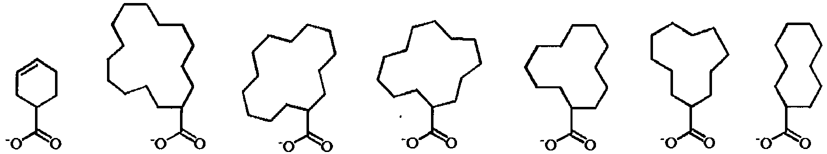

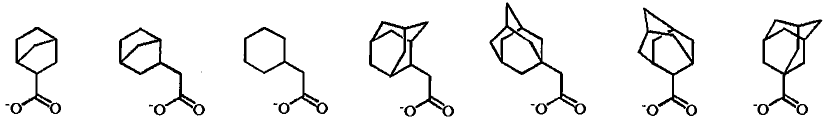

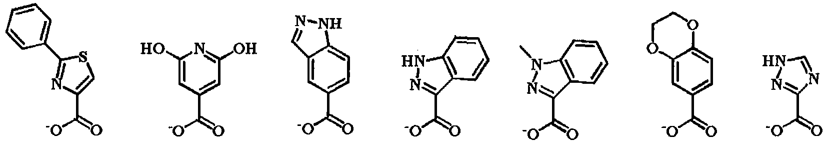

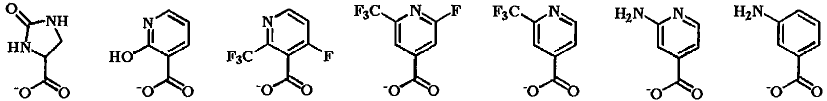

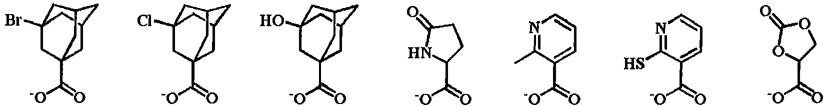

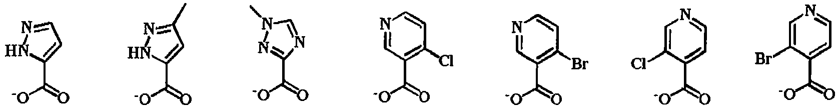

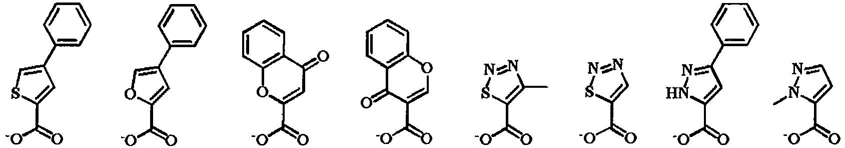

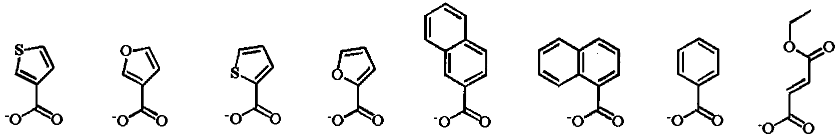

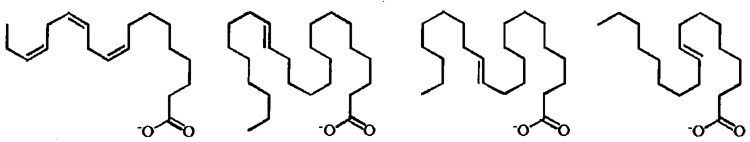

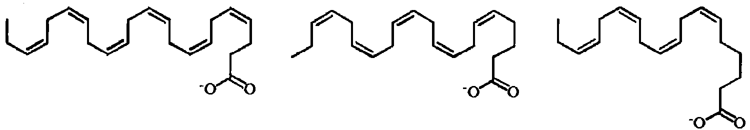

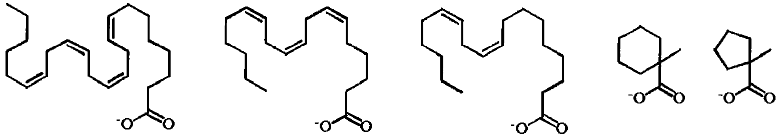

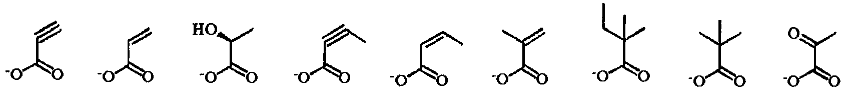

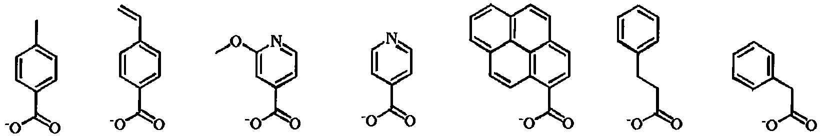

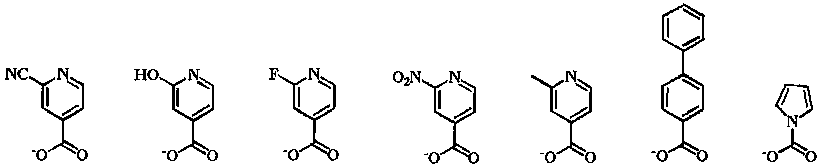

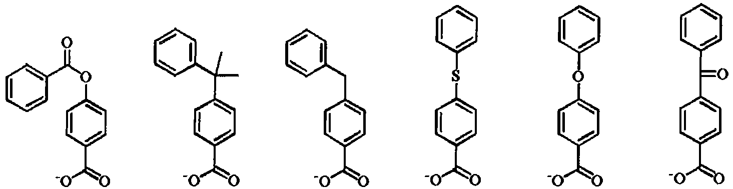

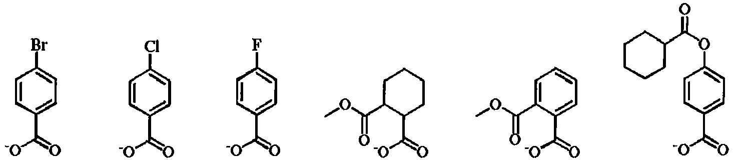

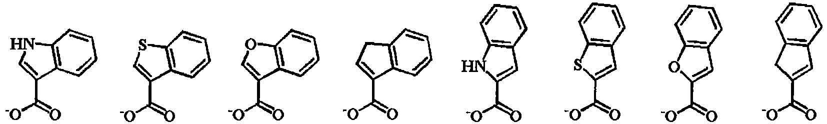

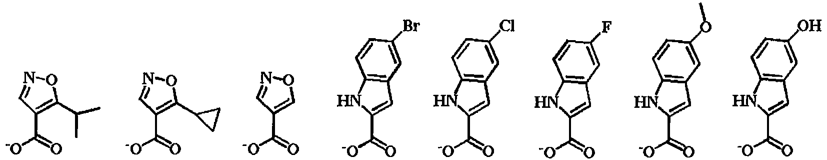

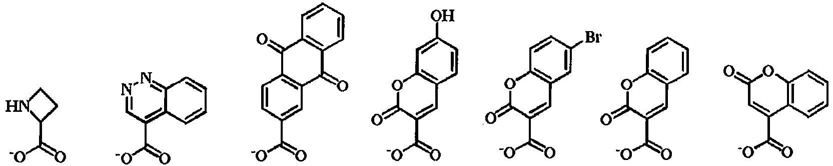

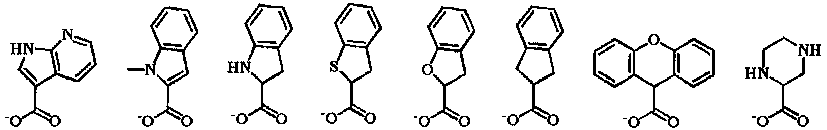

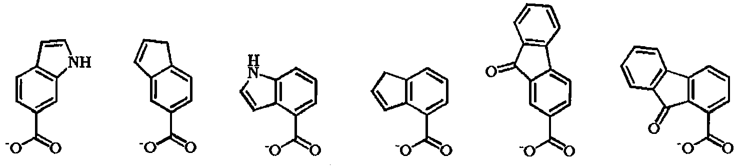

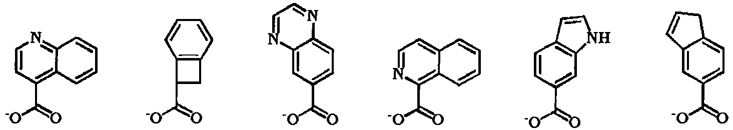

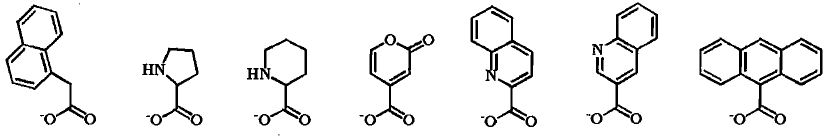

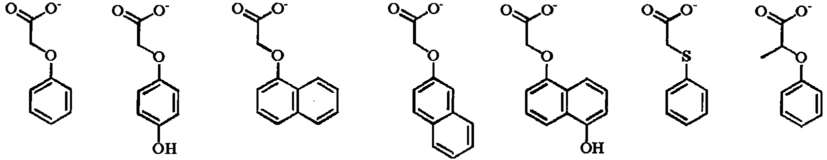

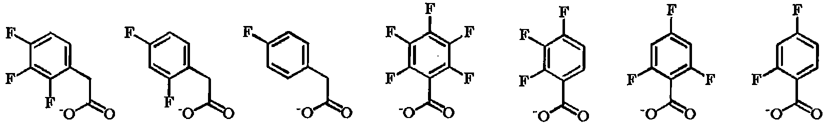

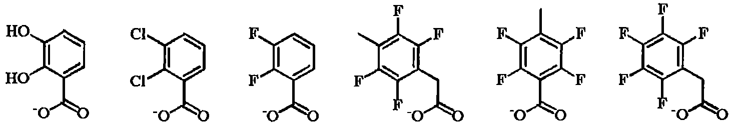

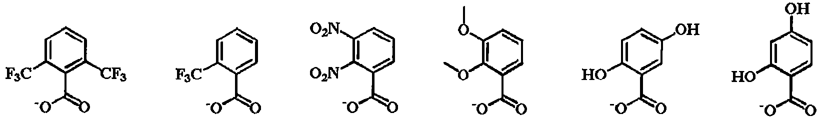

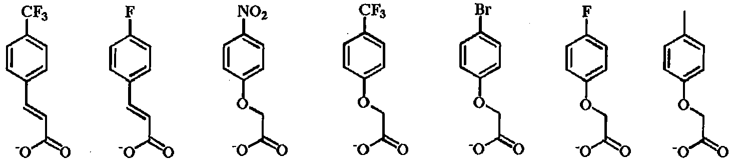

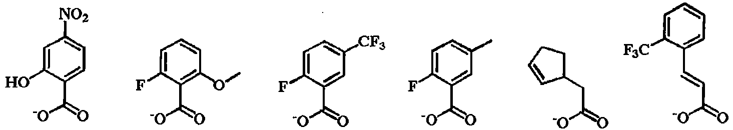

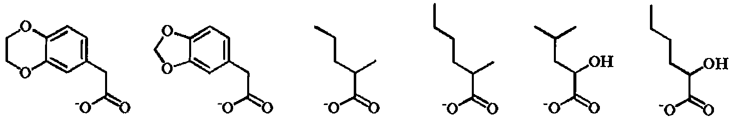

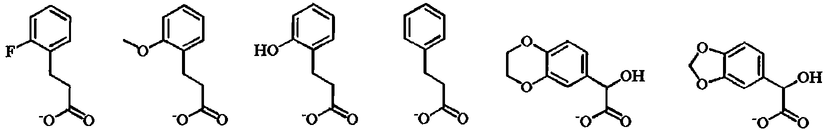

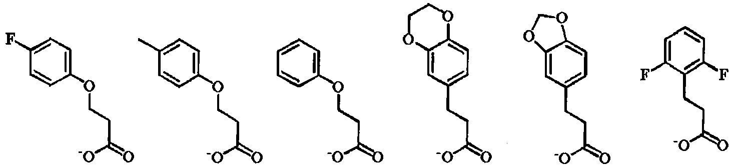

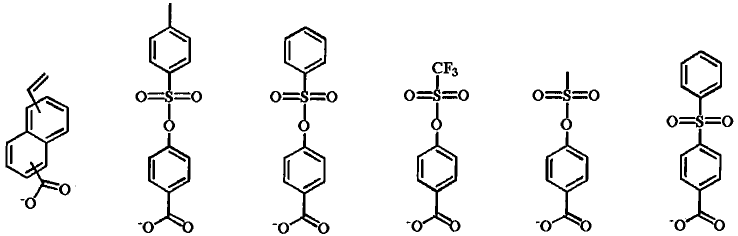

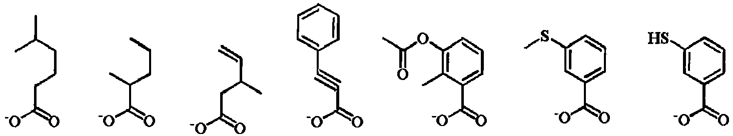

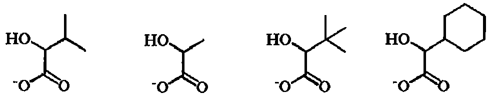

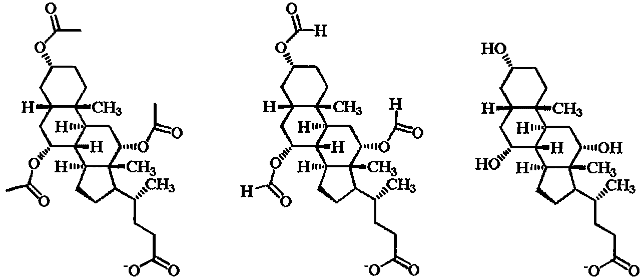

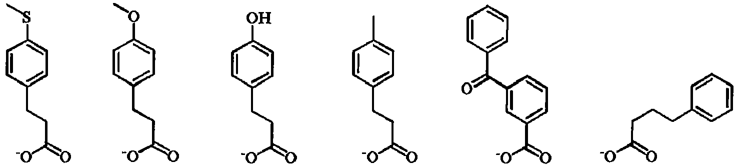

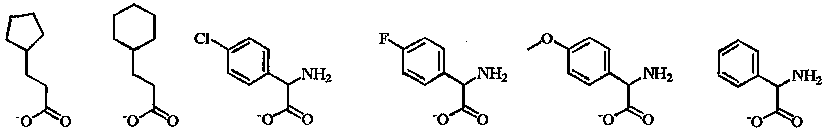

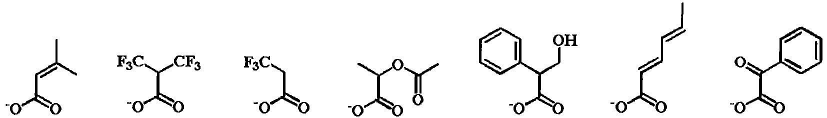

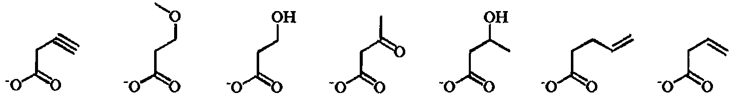

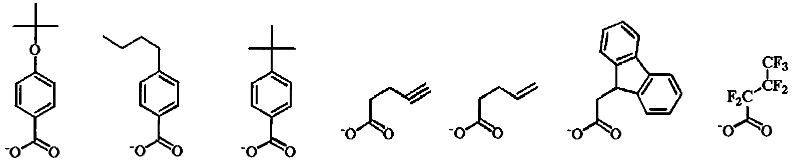

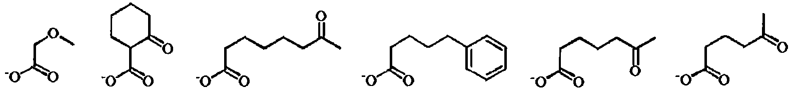

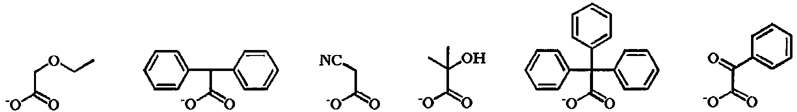

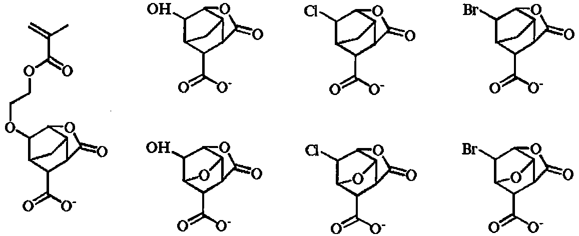

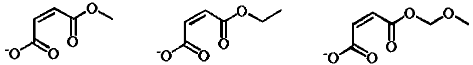

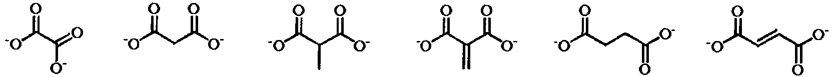

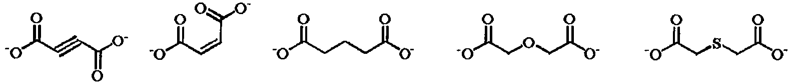

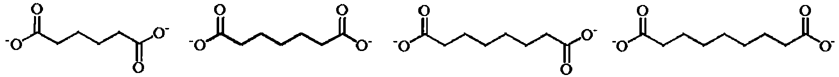

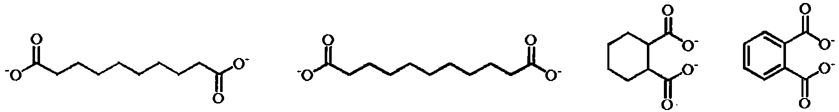

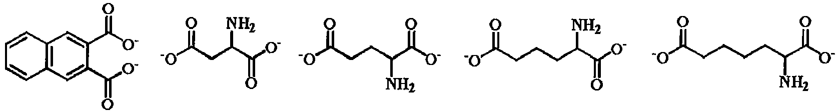

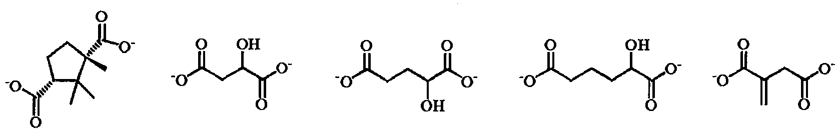

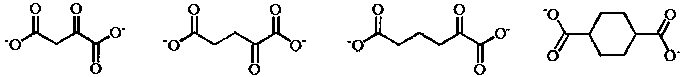

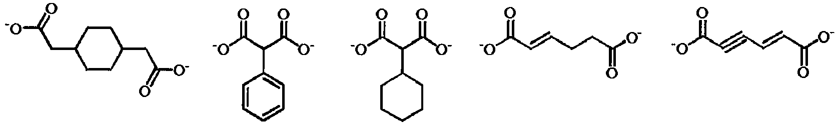

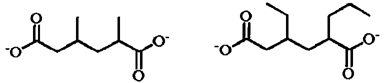

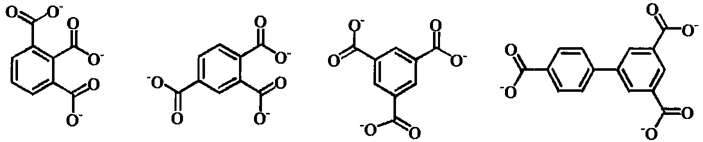

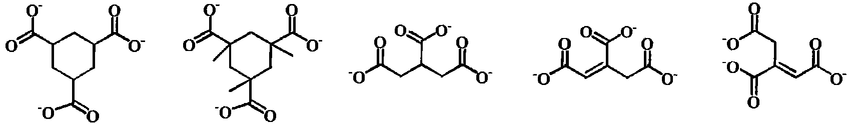

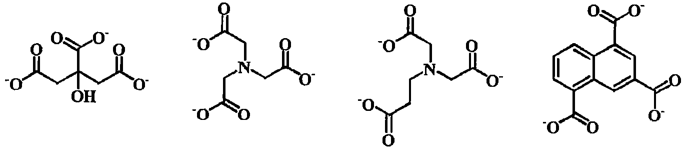

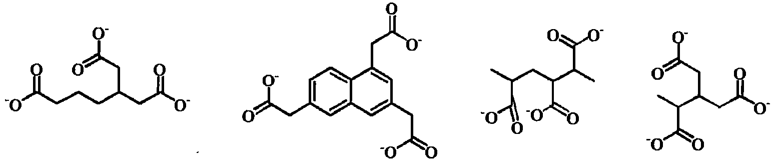

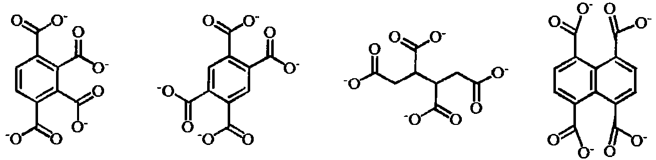

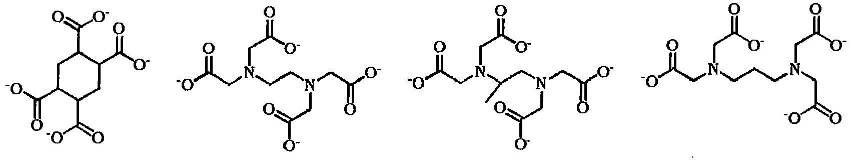

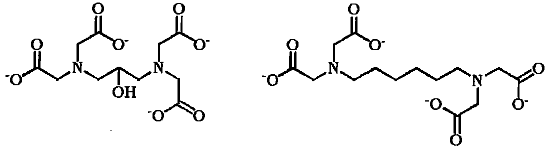

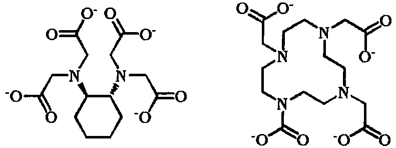

For the carboxylic acid ions for forming the carboxylic acid salt as described above, the carboxylic acid preferably has more carbon atoms as it is more easily dissolved in an organic solvent. Furthermore, if the carboxylic acid does not have too many carbon atoms, the amount of an outgas composition is reduced upon spin coating of the composition for forming a metal-containing film, a shrinking amount is also reduced upon formation of a resist film, and a favorable filling property can be obtained. From the above-described viewpoints, the carboxylic acid ion is more preferably a linear or branched alkyl group having 3 to 10 carbon atoms.

Preferred examples of the β-diketone complex are illustrated below.

| | |
|---|---|
| Ti⁴⁺ (R¹COCH₂COR²)⁻₄ | |
| Cr²⁺ (R¹COCH₂COR²)⁻₂ | Cr³⁺ (R¹COCH₂COR²)⁻₃ |
| Mn²⁺ (R¹COCH₂COR²)⁻₂ | Mn³⁺ (R¹COCH₂COR²)⁻₃ |
| Fe²⁺ (R¹COCH₂COR²)⁻₂ | Fe³⁺ (R¹COCH₂COR²)⁻₃ |
| Co²⁺ (R¹COCH₂COR²)⁻₂ | |
| Ni²⁺ (R¹COCH₂COR²)⁻₂ | |
| Cu⁺ (R¹COCH₂COR²)⁻ | Cu²⁺ (R¹COCH₂COR²)⁻₂ |
| Zn⁺ (R¹COCH₂COR²)⁻ | Zn²⁺ (R¹COCH₂COR²)⁻₂ |
| Zr⁴⁺ (R¹COCH₂COR²)⁻₄ | |
| Mo⁴⁺ (R¹COCH₂COR²)⁻₄ | |
| In³⁺ (R¹COCH₂COR²)⁻₃ | |
| Sn²⁺ (R¹COCH₂COR²)⁻₂ | Sn⁴⁺ (R¹COCH₂COR²)⁻₄ |
| Hf⁴⁺ (R¹COCH₂COR²)⁻₄ | |
| Bi³⁺ (R¹COCH₂COR²)⁻₃ | |

(In the formulae, R¹ and R² may be identical to or different from each other, and represent linear, branched, or cyclic alkyl group having 1 to 20 carbon atoms, alkenyl group having 2 to 20 carbon atoms, alkynyl group having 2 to 20 carbon atoms, or aryl group having 6 to 20 carbon atoms, each of these optionally having a hydroxy group, alkoxy group, ether group, ester group, amino group, amide group, sulfonic acid ester group, halogen atom, cyano group, nitro group, carbonate group, carbamate group, thiol group, sulfide group, thioketone group, or heteroaromatic ring.)

The β-diketone in the above general formulae is substituted or unsubstituted acetylacetone, and specific examples thereof are illustrated below.

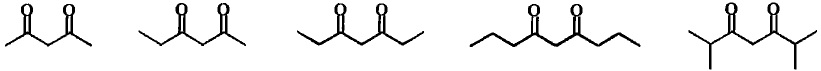

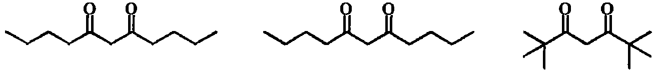

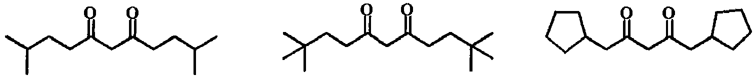

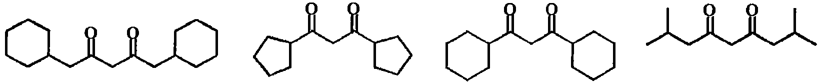

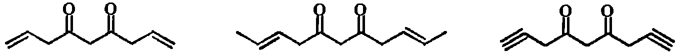

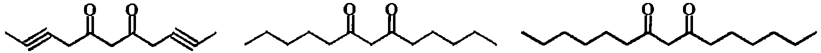

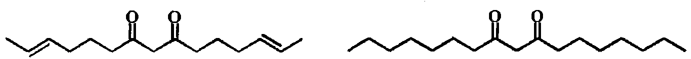

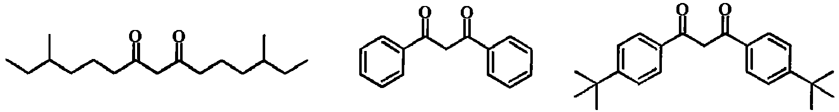

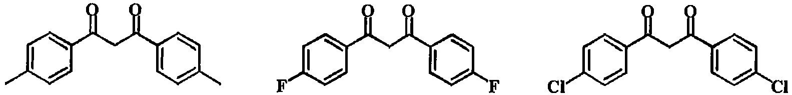

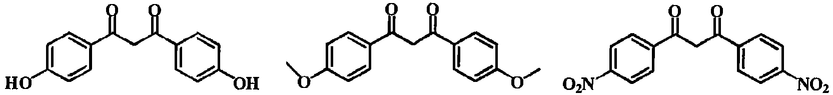

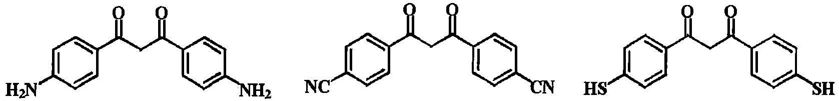

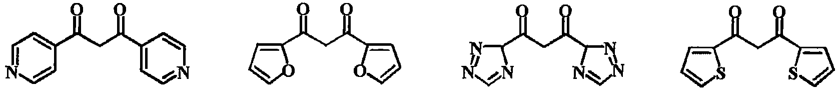

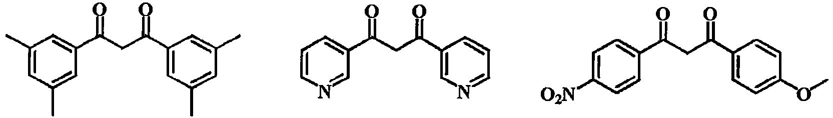

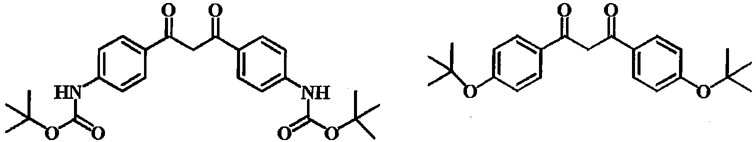

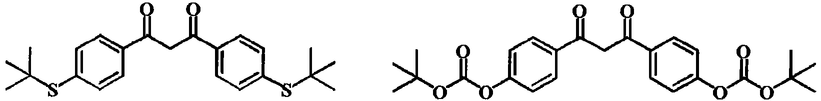

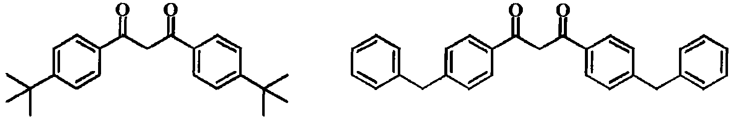

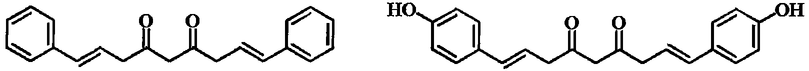

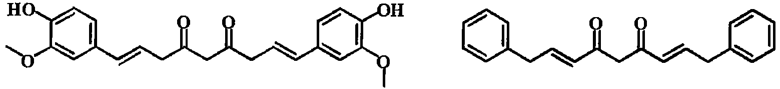

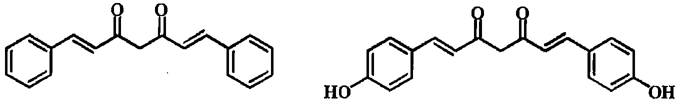

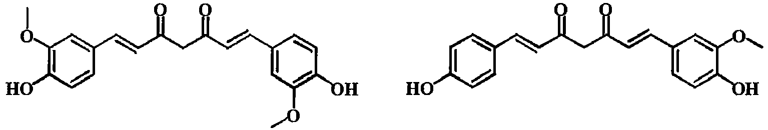

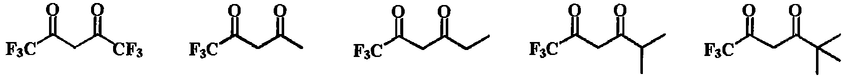

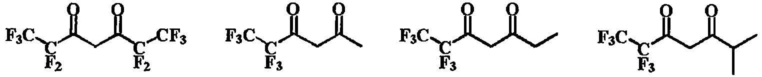

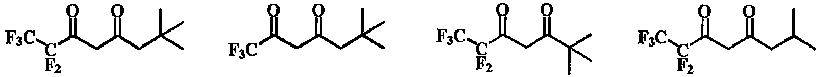

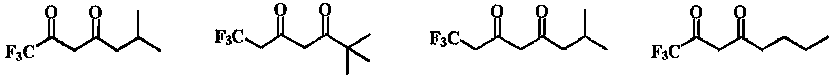

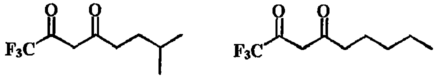

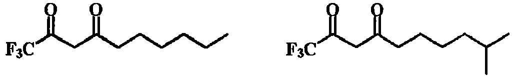

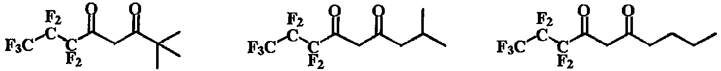

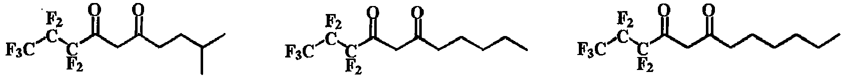

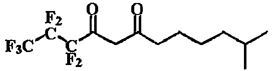

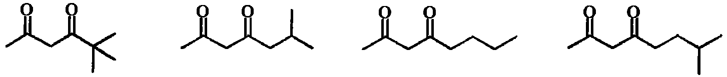

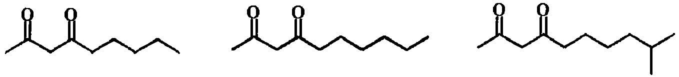

In a β-diketone, R¹ and R² are generally identical to each other. However, R¹ and R² may be different from each other as described in JP 2004-175755 A. The most common is acetylacetone in which both of R¹ and R² represent a methyl group, though it has disadvantage of poor solubility in an organic solvent. R¹ and R² preferably have a total of 3 or more carbon atoms, more preferably have a total of 4 or more carbon atoms.

It is preferable that a hydrogen atom of acetylacetone is substituted and the substituent has more carbon atoms as it is more easily dissolved in an organic solvent. On the other hand, if the substituent does not have too many carbon atoms, a shrinking amount is reduced upon formation of a resist film, and a favorable filling property can be obtained.

Acetylacetone undergoes enolization to form a complex with a metal as shown below.

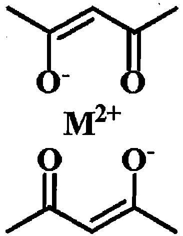

From the viewpoints of solubility in a solvent and availability of raw materials, the metal source (B) used in the composition for forming a metal-containing film of the present invention is preferably a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms. Specifically, the metal source (B) more preferably has a structure represented by the following formula (B-1), 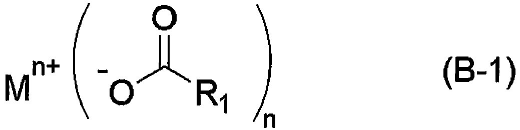 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms: and "n" represents an integer of 1 to 4.

The amount of the metal source (B) in the composition for forming a metal-containing film is preferably 5 to 1900 parts by mass, more preferably 10 to 900 parts by mass, further preferably 30 to 300 parts by mass, and extremely preferably 50 to 200 parts by mass relative to 100 parts by mass of the resin (A). When a large amount of the resin (A) is contained, thermal flowability and heat resistance of the composition for forming a metal-containing film can further be enhanced, and a resist underlayer film having excellent filling and planarizing properties can be formed. When a large amount of the metal source (B) is contained, a resist underlayer film having extremely excellent dry etching resistance can be formed. Additionally, such amount is preferable because the metal-containing film contributes more to enhancing exposure sensitivity of the resist upper layer film in EUV lithography. These can be adjusted as appropriate depending on the required properties when used in the composition for forming a metal-containing film.

From the viewpoint of enhancement of exposure sensitivity of the resist upper layer film in EUV lithography, M in the above formula (B-1) more preferably represents Ti, Hf, Sn, or Bi, and further preferably represents Sn.

### <(C) Organic Solvent>

The organic solvent (C) usable in the composition for forming a metal-containing film of the present invention is not particularly limited, as long as the resin (A) and the metal source (B) as described above, as well as (D) a crosslinking agent, (E) an acid generator, (F) a surfactant, (G) a colorant, and other additives as described later (if contained) can be dissolved or dispersed therein.

Specifically, for example, organic solvents described in paragraphs [0091] to [0092] of JP 2007-199653 A can be added. More specifically, propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more thereof is preferably used.

The blending amount of the organic solvent is preferably in the range of 200 to 10,000 parts, more preferably 250 to 5,000 parts relative to 100 parts by mass of the metal source (B).

### <(C') High-Boiling-Point Solvent>

In the composition for forming a metal-containing film of the present invention, the organic solvent (C) may contain (C') a high-boiling-point solvent.

The high-boiling-point solvent (C') can be one or more kinds of organic solvents having a boiling point of 180 degrees (°C) or higher.

For example, as the organic solvent (C), a mixture of one or more kinds of organic solvents having a boiling point of less than 180°C and one or more kinds of organic solvents having a boiling point of 180°C or higher (the high-boiling-point solvent (C')) may be used.

The high-boiling-point solvent (C') is not particularly limited to hydrocarbons, alcohols, ketones, esters, ethers, or chlorinated solvents as long as the respective components of the composition for forming a metal-containing film of the present invention can be dissolved or dispersed therein. Specific examples thereof include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, triethanolamine, and the like. These may be used alone or in mixture.

The high-boiling-point solvent (C') may appropriately be selected from, for example, those described above depending on the temperature for heat treatment of the composition for forming a metal-containing film of the present invention, etc. The high-boiling-point solvent preferably has a boiling point of 180°C to 300°C, and further preferably has a boiling point of 200°C to 300°C. Since there is no risk of too quick volatilization during baking (heat treatment) at such boiling point, it is possible to prevent defects caused by dryness during film formation. Furthermore, since the solvent having such boiling point evaporates and does not remain in the film after baking, there is no risk of a bad influence on physical properties of the film such as etching resistance.

Furthermore, the blending amount of the high-boiling-point solvent (C') (if used) is preferably 1 to 30 parts by mass relative to 100 parts by mass of the organic solvent having a boiling point of less than 180°C. Such blending amount is preferred because it enables to impart sufficient thermal flowability during baking and the solvent does not remain in the film, causing no deterioration in physical properties of the film such as etching resistance.

### <Other Components>

The above composition for forming a metal-containing film may contain at least one or more of (D) a crosslinking agent, (E) an acid generator, (F) a surfactant, and (G) a colorant as necessary.

Hereinafter, components that can be contained in the composition for forming a metal-containing film of the present invention other than the resin (A), the metal source (B), and the organic solvent (C) as described above will be described.

### (D) Crosslinking Agent

Additionally, to the composition for forming a metal-containing film of the present invention, (D) a crosslinking agent can also be added in order to enhance a curing property and further prevent intermixing with the resist upper layer film.

The crosslinking agent is not particularly limited, and known crosslinking agents of various types can widely be used. One example thereof includes melamine crosslinking agents, glycoluril crosslinking agents, benzoguanamine crosslinking agents, urea crosslinking agents, β-hydroxyalkylamide crosslinking agents, isocyanurate crosslinking agents, aziridine crosslinking agents, oxazoline crosslinking agents, and epoxy crosslinking agents.

The above crosslinking agent (D) can be used alone or in combination of two or more kinds thereof. The addition amount of the crosslinking agent (if added) is preferably 5 to 100 parts, more preferably 10 to 50 parts relative to 100 parts of the resin (A). When the addition amount is 5 parts or more, the sufficient curing property can be exhibited, thereby preventing intermixing with the resist upper layer film. On the other hand, when the addition amount is 50 parts or less, there is no risk of deteriorated dry etching resistance due to the decreased proportion of the metal source (B) in the composition.

From the viewpoint of making the metal source (B) more stable, the crosslinking agent (D) preferably contains no hydroxyl group.

Specific examples of the melamine crosslinking agents include hexamethoxymethylated melamine, hexabutoxymethylated melamine, alkoxy- and/or hydroxy-substituted derivatives thereof, and partial self-condensates thereof.

Specific examples of the glycoluril crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea crosslinking agents include dimethoxymethylated dimethoxyethyleneurea, alkoxy- and/or hydroxy-substituted derivatives thereof, and partial self-condensates thereof.

Specific examples of the β-hydroxyalkylamide crosslinking agents include N,N,N',N'-tetra(2-hydroxyethyl)adipic acid amide.

Specific examples of the isocyanurate crosslinking agents include triglycidyl isocyanurate and triallyl isocyanurate.

Specific examples of the aziridine crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline crosslinking agents include 2,2'-isopropylidenebis(4-benzyl-2-oxazoline), 2,2'-isopropylidenebis(4-phenyl-2-oxazoline), 2,2'-methylenebis-4,5-diphenyl-2-oxazoline, 2,2'-methylenebis-4-phenyl-2-oxazoline, 2,2'-methylenebis-4-tertbutyl-2-oxazoline, 2,2'-bis(2-oxazoline), 1,3-phenylenebis(2-oxazoline), 1,4-phenylenebis(2-oxazoline), and 2-isopropenyloxazoline copolymer.

Specific examples of the epoxy crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Examples of the epoxy crosslinking agents and oxetane crosslinking agents are shown below, but not limited thereto.

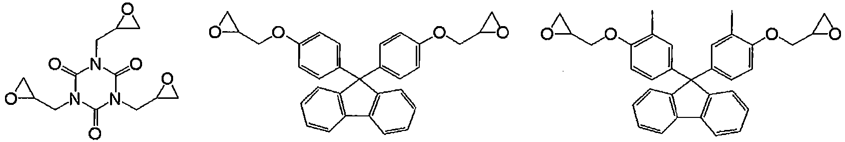

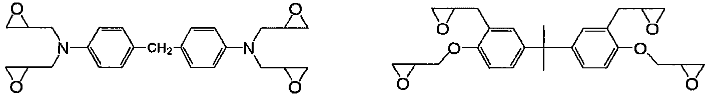

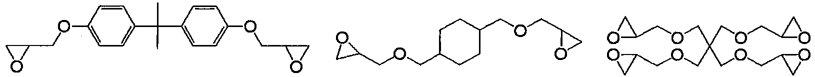

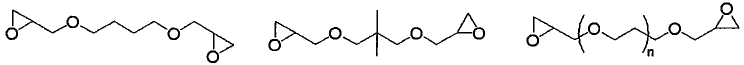

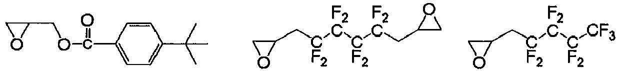

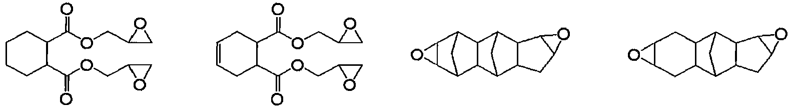

It is possible to purchase the above compounds, but it is also possible to obtain the epoxy crosslinking agents and the oxetane crosslinking agents by reacting a hydroxyl group with epibromohydrin or 3-bromomethyloxetane, etc. as in the following formula.
In the following formula, R₅ represents a substituted or unsubstituted saturated monovalent organic group having 1 to 20 carbon atoms or unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms. Additionally, it is possible that hydroxyl groups are not entirely reacted and some are left unreacted. In this case, the total number of epoxy and oxetane is preferably greater than the number of hydroxyl groups, and more preferably, the total number of epoxy and oxetane is greater than two times the number of hydroxyl groups.

Furthermore, these compounds are contained in an amount of preferably 5 to 100 parts by mass, more preferably 10 to 50 parts by mass relative to 100 parts by mass of the metal source (B).

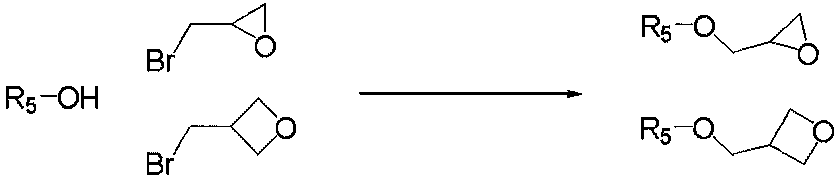

Specific examples of the compound having the hydroxyl group usable for the above reaction are shown below, but not limited thereto.

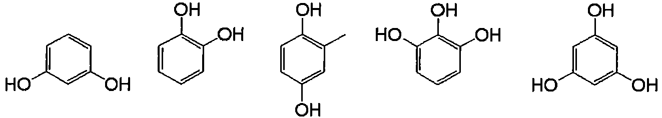

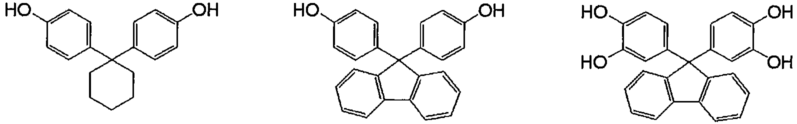

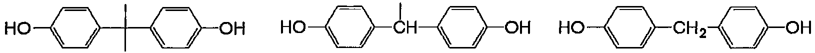

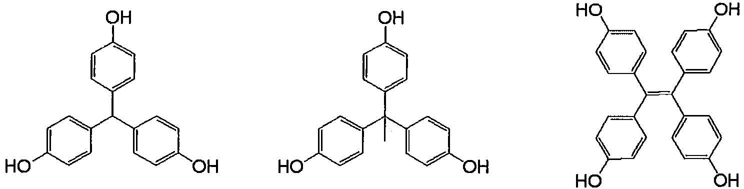

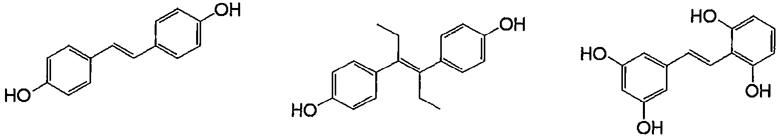

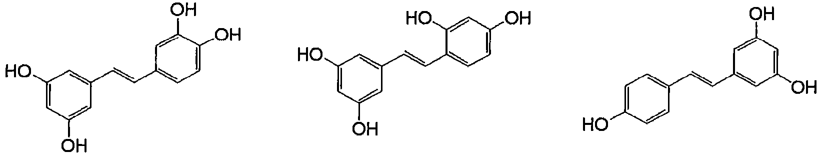

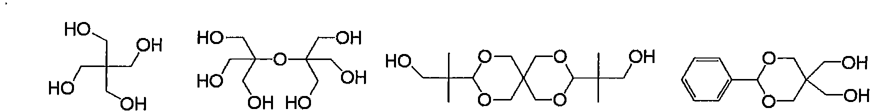

### <(E) Acid Generator>

In the composition for forming a metal-containing film of the present invention, an acid generator can be added in order to further facilitate thermal decomposition reaction of the above metal source (B). There are acid generators generating acid by thermal decomposition or generating acid by photoirradiation, any of which can be added. Specifically, materials described in paragraphs [0061] to [0085] of JP 2007-199653 A can be added, but the acid generator is not limited thereto.

The above acid generator can be used alone or in combination of two or more kinds thereof. The addition amount of the acid generator (if added) is preferably 0.05 to 50 parts, more preferably 0.1 to 10 parts, relative to 100 parts by mass of the above metal source (B) .

### <(F) Surfactant>

To the composition for forming a metal-containing film of the present invention, (E) a surfactant can be added in order to enhance application performance by spin coating. For example, those described in [0142] to [0147] of JP 2009-269953 A can be used as the surfactant. The addition amount of the surfactant (if added) is preferably 0.01 to 10 parts, more preferably 0.05 to 5 parts, relative to 100 parts by mass of the above metal source (B).

### (H) Colorant

Additionally, to the composition for forming a metal-containing film of the present invention, (H) a colorant can be added in order to further enhance resolution in patterning of multilayer lithography. The colorant is not particularly limited as long as the colorant is a compound having appropriate absorption at the exposure wavelength, and known compounds of various types can widely be used. An example thereof includes benzenes, naphthalenes, anthracenes, phenanthrenes, pyrenes, isocyanuric acids, and triazines. The addition amount of the colorant (if added) is preferably 0.01 to 10 parts by mass, more preferably 0.1 to 5 parts by mass, relative to 100 parts by mass of the above metal source (B).

Further, to the composition for forming a metal-containing film of the present invention, a basic compound can be added in order to enhance storage stability. The basic compound functions as a quencher against acid to prevent crosslinking reaction from progressing due to a trace amount of acid generated by an acid generator. Specific examples of such basic compound include those described in paragraphs (0086) to (0090) of JP 2007-199653 A.

Additionally, to the composition for forming a metal-containing film of the present invention, an additive other than the above components may be added in order to further enhance the filling/planarizing properties. The additive is not particularly limited as long as it can impart the filling/planarizing properties. For example, a liquid additive having a polyethylene glycol or polypropylene glycol structure, or a thermally decomposable polymer having a weight loss rate between 30°C to 250°C of 40% by mass or more and a weight average molecular weight of 300 to 200,000 is preferably used. This thermally decomposable polymer preferably contains a repeating unit having an acetal structure represented by the following general formula (DP1) or (DP1a). 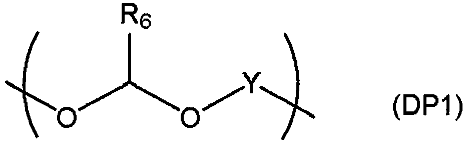 (In the formula, R₆ represents a hydrogen atom or an optionally substituted saturated or unsaturated monovalent organic group having 1 to 30 carbon atoms; and Y represents a saturated or unsaturated divalent organic group having 2 to 30 carbon atoms.) 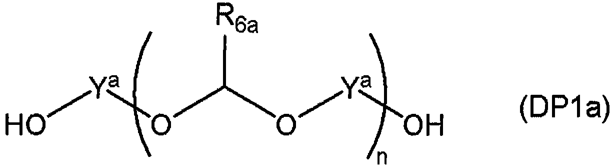 (In the formula, R₆ₐ represents an alkyl group having 1 to 4 carbon atoms; Y^{a} represents a saturated or unsaturated divalent hydrocarbon group having 4 to 10 carbon atoms and optionally containing an ether bond; and "n" represents the average number of repeating units, which is 3 to 500.)

### <Method for Forming Metal-Containing Film>

The present invention provides a method for forming a filling film using the above-described composition for forming a metal-containing film, the filling film functioning as a resist underlayer film of a multilayer resist film used for lithography.

In a method for forming a metal-containing film using the composition for forming a metal-containing film of the present invention, the above-described composition for forming a metal-containing film is coated on a substrate to be processed by a spin coat method or the like. The use of the spin coat method or the like can provide a favorable planarization property. After the spin coating, baking (heat treatment) is performed to evaporate the solvent and facilitate a crosslinking reaction to prevent mixing with the resist upper layer film. The baking is preferably performed at 100°C or higher and 600°C or lower for 10 to 600 seconds, more preferably performed at 200°C or higher and 500°C or lower for 10 to 300 seconds. Considering effects on device damage and deformation of a wafer, the upper limit of the heating temperature in a wafer process of lithography is preferably 600°C or lower and more preferably 500°C or lower.

Furthermore, in the method for forming a metal-containing film using the composition for forming a metal-containing film of the present invention, a metal-containing film can also be formed by coating the composition for forming a metal-containing film of the present invention on a substrate to be processed by a spin coat method or the like in the same manner as described above, and baking and curing the composition for forming a metal-containing film in an atmosphere with an oxygen concentration of 0.1% by volume or more and 21% by volume or less.

By baking the composition for forming a metal-containing film of the present invention in such oxygen atmosphere, it is possible to obtain a sufficiently cured film. While the atmosphere during the baking may be air, filling an inert gas such as N₂, Ar, or He to reduce the amount of oxygen is preferable to prevent oxidation of the metal-containing film. To prevent oxidation, it is necessary to control the oxygen concentration, which is preferably 1000 ppm or less and more preferably 100 ppm or less (volume basis). It is preferable to prevent oxidation of the metal-containing film during the baking so as not to cause increased absorption or reduced etching resistance.

### <Patterning Process>

As a patterning process with a two-layer resist process using the above composition for forming a metal-containing film, the present invention also provides a patterning process, including steps of:
(I-1) applying the composition for forming a metal-containing film of the present invention on a substrate to be processed and thereafter performing heat treatment to form a metal-containing film;
(I-2) forming a resist upper layer film on the metal-containing film using a photoresist material;
(I-3) forming a pattern in the resist upper layer film by developing the resist upper layer film using a developer after pattern exposure;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

Since the resist upper layer film in the above two-layer resist process has etching resistance to a chlorine gas, the dry etching of the metal-containing film while using the resist upper layer film as a mask is preferably performed by using an etching gas mainly composed of a chlorine gas in the two-layer resist process.

To secure adhesiveness to the resist upper layer film, an adhesive film may be formed between the resist upper layer film and the metal-containing film of the present invention. An organic film or a silicon-containing film containing polysiloxane can be used as the adhesive film.

The patterning process with the resist process using the composition for forming a metal-containing film of the present invention helps to enhance exposure sensitivity of the resist upper layer film. Therefore, the composition for forming a metal-containing film of the present invention is preferably used as the underlayer film close to the resist upper layer film, and more preferably used directly below the resist upper layer film. When the adhesive film is used between the resist upper layer film and the metal-containing film, film thickness of the adhesive film is preferably 20 nm or less, more preferably 15 nm or less, and further preferably 10 nm or less. The thinner film thickness of the adhesive film is preferable as it leads to greater contribution of the metal-containing film to enhancing exposure sensitivity of the resist upper layer film.

Additionally, as a patterning process with a three-layer resist process using such composition for forming a metal-containing film, the present invention provides a patterning process, including steps of:
(II-1) applying the composition for forming a metal-containing film of the present invention on a substrate to be processed and thereafter performing heat treatment to form a metal-containing film;
(II-2) forming a silicon-containing resist middle layer film on the metal-containing film;
(II-3) forming a resist upper layer film on the silicon-containing resist middle layer film using a photoresist material;
(II-4) forming a pattern in the resist upper layer film by developing the resist upper layer film using a developer after pattern exposure;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

Since the silicon-containing resist middle layer film in the above three-layer resist process has etching resistance to a chlorine gas, the dry etching of the metal-containing film while using the silicon-containing resist middle layer film as a mask is preferably performed by using an etching gas mainly composed of a chlorine gas in the three-layer resist process.

As the silicon-containing resist middle layer film in the three-layer resist process, a polysiloxane-based middle layer film is also preferably used. By providing the silicon-containing resist middle layer film with an antireflection effect, it is possible to suppress reflection. When a material containing many aromatic groups and having high etch selectivity to the substrate is used as the organic film especially for exposure at 193 nm, the k-value increase and thus the substrate reflection increase; whereas when the silicon-containing resist middle layer film absorbs light to achieve the appropriate k-value, the reflection can be suppressed, thereby reducing the substrate reflection to 0.5% or less. Preferably used as the silicon-containing resist middle layer film having the antireflection effect is polysiloxane having a pendant anthracene for exposure at 248 nm or 157 nm, or a pendant phenyl group or a pendant light-absorbing group having a silicon-silicon bond for exposure at 193 nm, where the polysiloxane is crosslinked by acid or heat.

Additionally, as a patterning process with a four-layer resist process using such composition for forming a metal-containing film, the present invention provides a patterning process including steps of: forming a metal-containing film using the above composition for forming a metal-containing film on a substrate to be processed; forming a silicon-containing resist middle layer film on the metal-containing film using a silicon-containing resist middle layer film material; forming an organic anti-reflective film (BARC) or an adhesive film on the silicon-containing resist middle layer film; forming a resist upper layer film on the BARC or the adhesive film using a photoresist material; forming a pattern in the resist upper layer film by developing the resist upper layer film using a developer after pattern exposure; transferring the pattern to the BARC or the adhesive film and the silicon-containing resist middle layer film by dry etching while using the resist upper layer film having the formed pattern as a mask; transferring the pattern to the metal-containing film by dry etching while using the silicon-containing resist middle layer film having the transferred pattern as a mask; and processing the substrate to be processed while using the metal-containing film having the formed pattern as a mask to form the pattern in the substrate to be processed.

Furthermore, an inorganic hard mask may be formed instead of the silicon-containing resist underlayer film. In this case, a semiconductor apparatus circuit pattern can be formed in a substrate, at least by: forming a metal-containing film on a workpiece using the composition for forming a metal-containing film of the present invention; forming an inorganic hard mask selected from a silicon oxide film, a silicon nitride film, and a silicon oxynitride film on the metal-containing film; forming a resist upper layer film on the inorganic hard mask using a photoresist material, and forming a circuit pattern in the resist upper layer film; etching the inorganic hard mask while using the resist upper layer film having the formed pattern as a mask; etching the metal-containing film while using the inorganic hard mask having the formed pattern as a mask; and further etching the workpiece while using the metal-containing film having the formed pattern as a mask, thereby forming the pattern in the workpiece.

In the case of forming the inorganic hard mask on the metal-containing film as described above, it is possible to form a silicon oxide film, a silicon nitride film, and a silicon oxynitride film (SiON film) by CVD or ALD or other methods. Examples of the method for forming the silicon nitride film are described in JP 2002-334869 A and WO 2004/066377 A1. The film thickness of the inorganic hard mask is preferably 5 to 200 nm, more preferably 10 to 100 nm. Additionally, as the inorganic hard mask, a SiON film which is highly effective as the anti-reflective film is most preferably used. Since a substrate temperature during forming the SiON film becomes 300 to 500°C, the metal-containing film should withstand the temperature of 300 to 500°C. The composition for forming a metal-containing film used in the present invention has high heat resistance and can withstand a high temperature of 300°C to 500°C, thereby allowing a combination of the inorganic hard mask formed by a CVD or ALD method and the metal-containing film formed by a spin coat method.

While a photoresist film may be formed on the inorganic hard mask as the resist upper layer film as described above, the organic anti-reflective film (BARC) or the adhesive film may be formed on the inorganic hard mask by spin coating, and the photoresist film may be formed thereon. Particularly, when a SiON film is used as the inorganic hard mask, the SiON film and the BARC as two layers of the anti-reflective film enables to suppress reflection even in liquid immersion exposure at high NA exceeding 1.0. Another merit of the BARC formation is an effect of reducing footing of a photoresist pattern directly above the SiON film.

In the above patterning process, the resist upper layer film may be either a positive or negative type, and the same one as a typically used photoresist composition can be used therefor. Additionally, the photoresist composition may contain a metal atom such as Sn, In, Ga, Ge, Al, Ce, La, Cs, Zr, Hf, Ti, Bi, Sb, and Zn. In a case of forming the resist upper layer film with the above photoresist composition, a spin coat method or a method using deposition processing by CVD or ALD may be applied.

When the resist upper layer film is formed by the spin coat method, prebaking is performed after resist application, preferably at 60 to 180°C for 10 to 300 seconds. Thereafter, exposure is performed according to a usual manner, followed by post exposure bake (PEB) and development, thereby obtaining a resist pattern. Note that the thickness of the resist upper layer film is not particularly limited, but preferably 10 to 500 nm and particularly preferably 20 to 400 nm.

When the resist upper layer film is formed by deposition processing by CVD or ALD, the resist composition is a metal oxide film having photosensitivity to EUV, and the metal is selected from Sn, Zr, Hf, Ti, Bi, Sb, and the like, among which Sn having excellent photosensitivity to EUV is preferable. The metal oxide-containing film may be a photosensitive organometallic oxide film such as an organotin oxide (for example, haloalkyl Sn, alkoxyalkyl Sn, or amidoalkyl Sn). Some specific examples of suitable precursors include trimethyltin chloride, dimethyltin dichloride, methyltin trichloride, tris(dimethylamino)methyltin(IV), and (dimethylamino)trimethyltin(IV).

The metal oxide film may be deposited, for example, by PECVD or PEALD using a Lam Vector^{®} tool, and in the ALD implementation, a Sn oxide precursor is separated from an O precursor/plasma. The deposition temperature is preferably in a range of 50°C to 600°C. The deposition pressure is preferably between 100 to 6000 mTorr. The flow rate of the precursor liquid for the metal oxide-containing film (for example, organotin oxide precursor) may be 0.01 to 10 cmm, and the gas flow rate (CO₂, CO, Ar, N₂) may be 100 to 10000 sccm. The plasma power may be 200 to 1000 W per 300 mm wafer station using RF plasma (for example, 13.56 MHz, 27.1 MHz or higher frequency). The deposition thickness is preferably 100 to 2000Å.

Examples of exposure light include high-energy ray having a wavelength of 300 nm or less; specifically, excimer laser of 248 nm, 193 nm, or 157 nm, soft X-ray of 3 to 20 nm, electron beam, X-ray, and the like.

As the above patterning process for the resist upper layer film, photolithography with a wavelength of 5 nm or more and 300 nm or less, direct drawing using an electron beam, nanoimprinting, or a combination thereof can be used to form a pattern. However, EUV light is the most preferable in the present invention.

Additionally, the development method in the patterning process is preferably alkaline development or development using an organic solvent.

Next, etching is performed by using the obtained resist pattern as a mask. The etching of the silicon-containing resist middle layer film and the inorganic hard mask in the three-layer resist process is performed with a chlorofluorocarbon gas while using the upper layer resist pattern as a mask. As a result, a silicon-containing resist middle layer film pattern and an inorganic hard mask pattern are formed.

Next, the metal-containing film is processed by etching while using the obtained silicon-containing resist middle layer film pattern and the inorganic hard mask pattern as a mask. The etching processing of the metal-containing film is preferably performed by using an etching gas mainly composed of a chlorine gas.

The subsequent etching of the workpiece can also be performed in a usual manner. For example, if the workpiece is a SiO₂, SiN, or silica low-dielectric insulating film, etching is performed mainly using a chlorofluorocarbon gas. When the substrate is processed by etching with a chlorofluorocarbon gas, the silicon-containing resist middle layer film pattern in the three-layer resist process is debonded simultaneously with the processing of the substrate.

The metal-containing film obtained from the composition for forming a metal-containing film of the present invention is characterized by excellent etching resistance upon such etching of the workpiece.

Note that the workpiece (substrate to be processed) is not particularly limited, and a substrate made of Si, α-Si, p-Si, SiO₂, SiN, SiON, W, TiN, Al, or the like, the substrate on which a layer to be processed is deposited, etc. are used. As the layer to be processed, various Low-k films such as those made of Si, SiO₂, SiON, SiN, p-Si, α-Si, W, W-Si, Al, Cu, Al-Si, or the like, and a stopper film thereof are used, which can be formed to have a thickness of typically 50 to 10,000 nm and particularly 100 to 5,000 nm. Note that in the case of depositing the layer to be processed, the substrate and the layer to be processed for use are made of different materials.

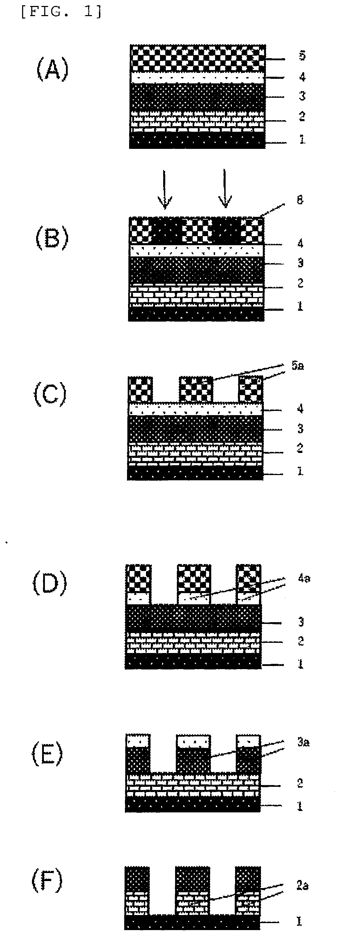

An example of the inventive patterning process with a three-layer resist method will be described herein with reference to FIGs. 1(A) to 1(F). In the case of the three-layer resist method, as illustrated in FIG. 1(A), a metal-containing film 3 is formed on a layer to be processed 2 formed on a substrate to be processed 1 using the composition for forming a metal-containing film of the present invention, a silicon-containing resist middle layer film 4 is then formed, and a resist upper layer film 5 is formed thereon. Next, an exposed portion 6 of the resist upper layer film 5 is exposed to light to perform PEB (post exposure bake) as illustrated in FIG. 1(B). Next, development is performed to form a resist upper layer film pattern 5a as illustrated in FIG. 1(C). Next, as illustrated in FIG. 1(D), the silicon-containing resist middle layer film 4 is processed by dry etching with a chlorofluorocarbon gas while using the resist upper layer film pattern 5a as a mask, thereby forming a silicon-containing resist middle layer film pattern 4a. Next, as illustrated in FIG. 1(E), the resist upper layer film pattern 5a is removed and thereafter the metal-containing film 3 is processed by dry etching with a chlorine gas while using the silicon-containing resist middle layer film pattern 4a as a mask, thereby forming a metal-containing film pattern 3a. Further, as illustrated in FIG. 1(F), the silicon-containing resist middle layer film pattern 4a is removed and thereafter the layer to be processed 2 is etched by using the metal-containing film pattern 3a as a mask, thereby forming a pattern 2a.

In the case of forming the inorganic hard mask, the silicon-containing resist middle layer film 4 may be changed to the inorganic hard mask, and in the case of forming BARC, the BARC may be formed between the silicon-containing resist middle layer film 4 and the resist upper layer film 5. Etching of the BARC may be performed consecutively prior to the etching of the silicon-containing resist middle layer film 4, or an etching apparatus may be changed after performing etching of only the BARC, and then the etching of the silicon-containing resist middle layer film 4 may be performed.

The present invention also provides a patterning process for forming a pattern in a substrate to be processed, including steps of:
(III-1) applying the composition for forming a metal-containing film of the present invention on the substrate to be processed and thereafter performing heat treatment to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film using a photoresist material;
(III-5) forming a pattern in the resist upper layer film by developing the resist upper layer film using a developer after pattern exposure;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

As a patterning process with the four-layer resist process using the composition for forming a metal-containing film as described above, the present invention further provides a patterning process, including steps of:
(IV-1) applying the composition for forming a metal-containing film of the present invention on a substrate to be processed and thereafter performing heat treatment to form a metal-containing film;
(IV-2) forming an organic middle layer film on the metal-containing film;
(IV-3) forming a silicon-containing resist middle layer film or a combination of an inorganic hard mask middle layer film selected from a silicon oxide film, a silicon nitride film, and a silicon oxynitride film and an organic thin film on the organic middle layer film;
(IV-4) forming a resist upper layer film on the silicon-containing resist middle layer film or the organic thin film using a photoresist material;
(IV-5) forming a pattern in the resist upper layer film by developing the resist upper layer film using a developer after pattern exposure;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film as a mask; and
(IV-9) processing the substrate to be processed while using the metal-containing film having the formed pattern as a mask to form the pattern in the substrate to be processed.

As one example of such patterning process with the four-layer resist process using the composition for forming a metal-containing film, a patterning process is provided, the patterning process including steps of: forming a metal-containing film on a substrate to be processed using the above composition for forming a metal-containing film; forming an organic middle layer film on the metal-containing film using an organic resist middle layer film material; forming a silicon-containing resist middle layer film on the organic middle layer film using a silicon-containing resist middle layer film material; forming an organic anti-reflective film (BARC) or an adhesive film on the silicon-containing resist middle layer film, if necessary; forming a resist upper layer film on the silicon-containing film or the BARC using a photoresist material: forming a pattern in the resist upper layer film by developing the resist upper layer film using a developer after pattern exposure; transferring the pattern to the BARC or the adhesive film and the silicon-containing resist middle layer film by dry etching while using the resist upper layer film having the formed pattern as a mask; transferring the pattern to the organic middle layer film by dry etching while using the silicon-containing resist middle layer film having the transferred pattern as a mask; transferring the pattern to the metal-containing film while using the organic middle layer film as a mask; and processing the substrate to be processed while using the metal-containing film having the formed pattern as a mask to form the pattern in the substrate to be processed.

Examples of the organic resist middle layer film material usable for the above organic middle layer film include already known underlayer films for a three-layer resist method or a two-layer resist method using a silicon resist composition, 4,4'-(9-fluorenylidene)bisphenol novolak resin (molecular weight: 11,000) described in JP 2005-128509 A, and a number of resins including novolak resins, which are known as resist underlayer film materials for the two-layer resist method or the three-layer resist method. Furthermore, when higher heat resistance than that of a typical novolak resin is desired, a polycyclic skeleton can be introduced, as in a 6,6'-(9-fluorenylidene)-di(2-naphthol) novolak resin, or a polyimide resin can also be selected (for example, JP 2004-153125 A).

The above organic middle layer film can be formed on the substrate to be processed by the spin coat method or the like using a composition solution, as with the photoresist composition. After forming the organic middle layer film by the spin coat method or the like, baking is preferably performed to evaporate the organic solvent. Preferably, the baking temperature is within a range of 80 to 400°C and baking time is within a range of 10 to 300 seconds.

Instead of the above organic resist middle layer film material, it is also possible to apply an organic hard mask formed by a CVD or ALD method.

The organic middle layer film in the above multilayer resist process has etching resistance to a chlorine gas. Accordingly, in the above multilayer resist process, the dry etching of the metal-containing film while using the organic middle layer film as a mask is preferably performed by using an etching gas mainly composed of a chlorine gas.

The present invention also provides a patterning process for forming a tone-reversal pattern in a substrate to be processed, including steps of:
(V-1) forming a resist underlayer film on the substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film using a photoresist material;
(V-4) forming a pattern in the resist upper layer film by developing the resist upper layer film using a developer after pattern exposure;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the composition for forming a metal-containing film of the present invention on the resist underlayer film having the formed pattern, and thereafter performing heat treatment to cover with the metal-containing film and fill an in-between space in the pattern of the resist underlayer film with the metal-containing film;
(V-8) etching back the metal-containing film covering over the resist underlayer film having the formed pattern by a chemical stripper or dry etching to expose an upper surface of the resist underlayer film having the formed pattern;
(V-9) removing the resist middle layer film or the hard mask middle layer film remaining on the upper surface of the resist underlayer film by dry etching;
(V-10) removing the resist underlayer film having the formed pattern with its surface exposed by dry etching to form a reverse pattern of an original pattern, the reverse pattern being formed of the metal-containing film; and
(V-11) processing the substrate to be processed while using the metal-containing film having the formed reverse pattern as a mask to form the reverse pattern in the substrate to be processed.

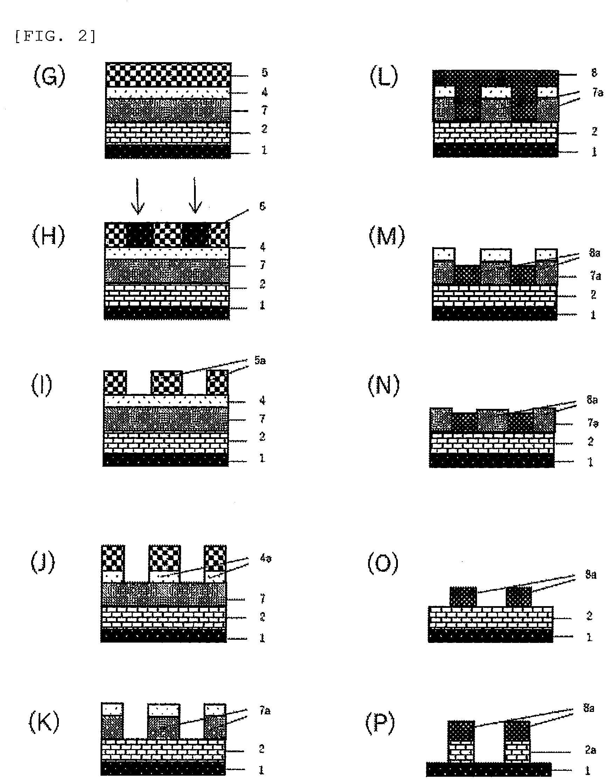

An example of the inventive tone-reversal patterning process will be described with reference to FIG. 2. The steps (V-1) to (V-6) can be performed in the same manner as in FIGs. 1(A) to 1(E), except that the metal-containing film 3 is changed to a resist underlayer film 7 made of a coating-type organic underlayer film material to form a resist underlayer film pattern 7a (FIGs. 2(G) to 2(K)). In the step (V-7), the composition for forming a metal-containing film of the present invention is applied on the resist underlayer film 7 having the formed pattern, and thereafter heat treatment is performed to cover with a metal-containing film 8 and fill an in-between space in the resist underlayer film pattern 7a with the metal containing film 8 (FIG. 2(L)). In the step (V-8), the metal-containing film 8 covering over the resist underlayer film 7 having the formed pattern is etched back by a chemical stripper or dry etching to expose an upper surface of the resist underlayer film 7 having the formed pattern (FIG. 2(M)). In the step (V-9), the resist middle layer film or the hard mask middle layer film remaining on the upper surface of the resist underlayer film 7 is removed by dry etching (FIG. 2(N)). In the step (V-10), the resist underlayer film 7 having the formed pattern with its surface exposed is removed by dry etching to form a metal-containing film pattern 8a formed of the metal-containing film 8 as a reverse pattern of the resist underlayer film pattern (FIG. 2(O)). In the step (V-11), the layer to be processed 2 is processed by using the metal-containing film 8 having the formed reverse pattern as a mask to form the pattern 2a (reverse pattern) in the substrate to be processed.

Further in the patterning process of the present invention, the pattern exposure is preferably performed using EUV light in the steps (I-3), (II-4), (III-5), (IV-5), and (V-4).

### EXAMPLE

Hereinafter, the present invention will be more specifically described with reference to Synthesis Examples, Examples, and Comparative Examples. However, the present invention is not limited by the description thereof.

### Compounds for Forming Metal-Containing Film (M-1) to (M-17)

In the compounds for forming a metal-containing film, the following metal compounds (metal salts) were used.
(M-1): titanium(IV) 2-ethylhexanoate
(M-2): tris(2,2,6,6-tetramethyl-3,5-heptanedionato)chromium(III)
(M-3): tris(2,2,6,6-tetramethyl-3,5-heptanedionato)manganese (III)
(M-4): tris(2,2,6,6-tetramethyl-3,5-heptanedionato)iron(III)
(M-5): cobalt(II) 2-ethylhexanoate
(M-6): nickel(II) bis(hexafluoroacetylacetonate)
(M-7): copper(I) 2-ethylhexanoate
(M-8): zinc(II) 4-vinyl benzoate
(M-9): tetra(2,2,6,6-tetramethyl-3,5-heptanedionato)zirconium(IV)
(M-10): molybdenum(IV) 2-ethylhexanoate
(M-11): indium(III) ethylbutyrate
(M-12): tin(II) acetate
(M-13): tin(II) 2-ethylhexanoate
(M-14): tin(II) acetylacetonate
(M-15): tin(II) 4-fluorobenzeneacetate
(M-16): hafnium(IV) carboxyethyl acrylate
(M-17): bismuth(III) 2-ethylhexanoate

### Crosslinking Agents (XL-1 to XL-2)

The crosslinking agents (XL-1) to (XL-2) used in the composition for forming a metal-containing film are shown below.

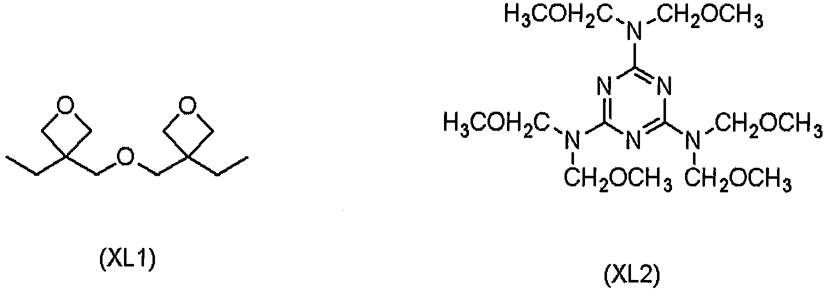

### Acid Generator (D-1)

The acid generator (D-1) used in the composition for forming a metal-containing film is shown below.

(CH₃CH₂)₃N⁺H

C₄F₉SO₃⁻ (D1)

### Flowability Accelerators (BPA-1) to (BPA-7) (Synthesis of Flowability Accelerator)

For synthesis of a flowability accelerator (resin), the following organic group raw material group g((G1) to (G7)) and a modifier H ((H1) to (H5)) were used.

The organic group raw material group g ((G1) to (G7)) is shown below.

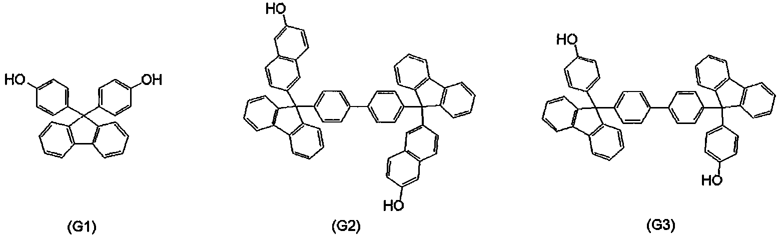

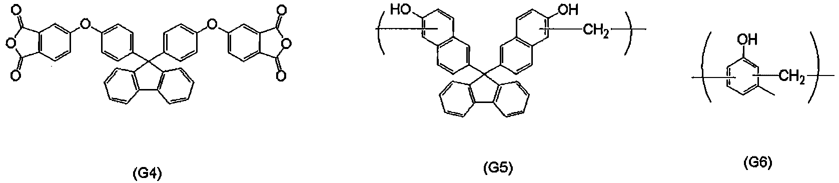

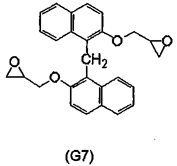

The modifier H ((H1) to (H5)) is shown below.

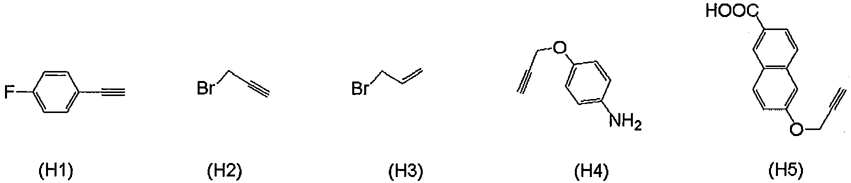

### Synthesis Example 1: Synthesis of Flowability Accelerator (BPA-1)

Under a nitrogen atmosphere, 200 g of N-methylpyrrolidone was added to 20.0 g of the compound (G1) of the raw material group, 16.4 g of the modifier (H1), and 23.3 g of potassium carbonate, and the reaction was allowed to proceed at an internal temperature of 140°C for 24 hours. After cooling to a room temperature, 300 ml of methylisobutyl ketone and 300 ml of pure water were added to the reaction solution and homogenized. Then, the separated aqueous layer was removed. Further, the organic layer was washed twice with 100 ml of 3% nitric acid aqueous solution and five times with 100 ml of pure water. Then, the organic layer was dried and solidified under reduced pressure. 100 g of THF was added to the residue to prepare a homogenous solution, and thereafter a crystal was precipitated with 350 g of methanol. The precipitated crystal was separated by filtration, washed twice with 200 g of methanol, and collected. The collected crystal was dried under vacuum at 70°C, thereby obtaining a compound for the flowability accelerator (BPA-1).

The weight average molecular weight (Mw) and dispersity (Mw/Mn) determined by GPC showed the following result.

### (BPA-1): Mw=580, Mw/Mn=1.03

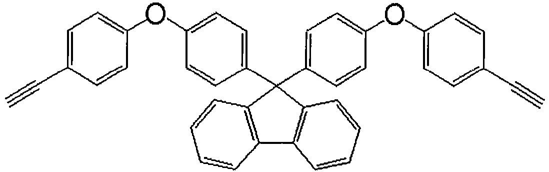

### Synthesis Example 2: Synthesis of Flowability Accelerator (BPA-2)

Under a nitrogen atmosphere, 45.5 g of the compound (G2) of the raw material group, 9.8 g of potassium carbonate, and 150 g of DMF were added to prepare a homogenous dispersion liquid at an internal temperature of 50°C. 17.6 g of the modifier (H2) was slowly added thereto, and the reaction was allowed to proceed at an internal temperature of 50°C for 24 hours. 300 ml of methylisobutyl ketone and 300 g of pure water were added to the reaction solution, and precipitated salt was dissolved. Then, the separated aqueous layer was removed. Further, the organic layer was washed 6 times with 100 g of 3% nitric acid aqueous solution and 100 g of pure water. Then, the organic layer was dried and solidified under reduced pressure, thereby obtaining a compound for the flowability accelerator (BPA-2).

The weight average molecular weight (Mw) and dispersity (Mw/Mn) determined by GPC showed the following result.

### (BPA-2): Mw=965, Mw/Mn=1.08

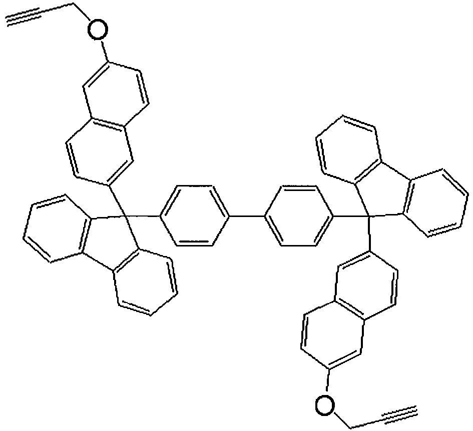

### Synthesis Example 3: Synthesis of Flowability Accelerator (BPA-3)

Under a nitrogen atmosphere, 47.2 g of the compound (G3), 11.7 g of potassium carbonate, and 150 g of DMF were added to prepare a homogenous dispersion liquid at an internal temperature of 50°C. 17.2 g of the modifier (H3) was slowly added thereto, and the reaction was allowed to proceed at an internal temperature of 50°C for 24 hours. 300 ml of methylisobutyl ketone and 300 g of pure water were added to the reaction solution, and precipitated salt was dissolved. Then, the separated aqueous layer was removed. Further, the organic layer was washed 6 times with 100 g of 3% nitric acid aqueous solution and 100 g of pure water. Then, the organic layer was dried and solidified under reduced pressure, thereby obtaining a polymer for the flowability accelerator (BPA-3).

The weight average molecular weight (Mw) and dispersity (Mw/Mn) determined by GPC showed the following result.

### (BPA-3): Mw=740, Mw/Mn=1.03

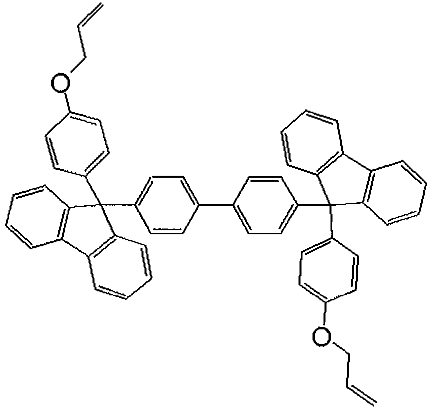

### Synthesis Example 4: Synthesis of Flowability Accelerator (BPA-4)

Under a nitrogen atmosphere, 100 g of N-methylpyrrolidone was added to 30.00 g of the compound (G4) of the raw material group to prepare a homogenous solution under the nitrogen atmosphere at an internal temperature of 40°C. Thereafter, 13.7 g of the modifier (H4) was added thereto and the reaction was allowed to proceed at an internal temperature of 40°C for 3 hours to obtain an amic acid solution. To the amic acid solution thus obtained, 200 g of o-xylene was added, and the reaction was allowed to proceed for 9 hours at an internal temperature of 150°C while removing a generated low-boiling substance and generated water from the system, thereby performing dehydrating imidization. After completion of the reaction, the resultant was cooled to a room temperature and a crystal was precipitated with 1000 g of methanol. The precipitated crystal was separated by filtration, washed twice with 500 g of methanol, and collected. The collected crystal was dried under vacuum at 70°C, thereby obtaining a compound for the flowability accelerator (BPA-4).

The weight average molecular weight (Mw) and dispersity (Mw/Mn) determined by GPC showed the following result.

### (BPA-4): Mw=930, Mw/Mn=1.01

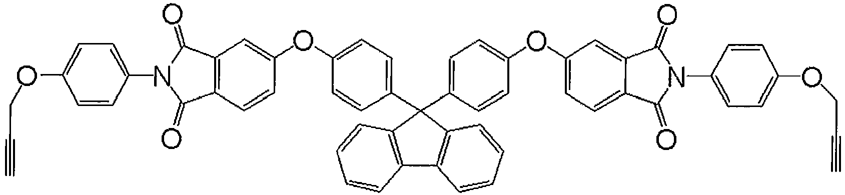

### Synthesis Example 5: Synthesis of Flowability Accelerator (BPA-5)

Under a nitrogen atmosphere, 44.7 g of the compound (G5) of the raw material group, 16.5 g of potassium carbonate, and 150 g of DMF were added to prepare a homogenous dispersion liquid at an internal temperature of 50°C. 23.5 g of the modifier (H2) was slowly added thereto, and the reaction was allowed to proceed at an internal temperature of 50°C for 24 hours. 300 ml of methylisobutyl ketone and 300 g of pure water were added to the reaction solution, and precipitated salt was dissolved. Then, the separated aqueous layer was removed. Further, the organic layer was washed 6 times with 100 g of 3% nitric acid aqueous solution and 100 g of pure water. Then, the organic layer was dried and solidified under reduced pressure, thereby obtaining a polymer for the flowability accelerator (BPA-5).

The weight average molecular weight (Mw) and dispersity (Mw/Mn) determined by GPC showed the following result.

### (BPA-5): Mw=2700, Mw/Mn=3.20

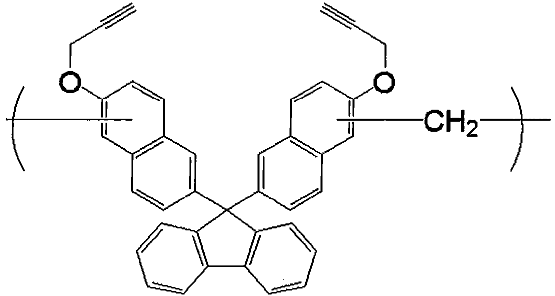

### Synthesis Example 6: Synthesis of Flowability Accelerator (BPA-6)

Under a nitrogen atmosphere, 20.0 g of the compound (G6) of the raw material group, 34.5 g of potassium carbonate, and 100 g of DMF were added to prepare a homogenous dispersion liquid at an internal temperature of 50°C. 23.8 g of the modifier (H2) was slowly added thereto, and the reaction was allowed to proceed at an internal temperature of 50°C for 24 hours. 300 ml of methylisobutyl ketone and 300 g of pure water were added to the reaction solution, and precipitated salt was dissolved. Then, the separated aqueous layer was removed. Further, the organic layer was washed 6 times with 100 g of 3% nitric acid aqueous solution and 100 g of pure water. Then, the organic layer was dried and solidified under reduced pressure, thereby obtaining a resin (BPA-6).

The weight average molecular weight (Mw) and dispersity (Mw/Mn) determined by GPC showed the following result.

### (BPA-6): Mw=9,400, Mw/Mn=3.59

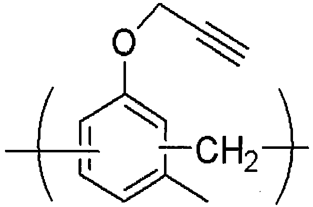

### Synthesis Example 7: Synthesis of Flowability Accelerator (BPA-7)

Using 80.0 g of the epoxy compound (G7), 51.0 g of the modifier (H5), and 600 g of 2-methoxy-1-propanol under a nitrogen atmosphere, a homogenous solution was prepared at an internal temperature of 100°C. Then, 5.7 g of benzyltriethylammonium chloride was added thereto and stirred at an internal temperature of 120°C for 12 hours. After cooling to a room temperature, 1,500 g of methylisobutyl ketone was added thereto, and the organic layer was washed five times with 300 g of pure water. The organic layer was dried and solidified under reduced pressure, thereby obtaining a compound for the flowability accelerator (BPA-7).

The weight average molecular weight (Mw) and dispersity (Mw/Mn) determined by GPC showed the following result.

### (BPA-7): Mw=900, Mw/Mn=1.04

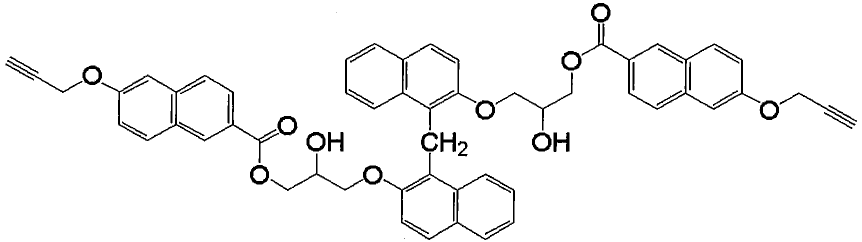

Tables 1 and 2 show the structure, weight average molecular weight (Mw), and dispersity (Mw/Mn) of the obtained compounds and polymers used for the flowability accelerator. For the comparative polymer (R-1), (G5) of the raw material group G used as the raw material in Synthesis Example was used.

**[Table 1]**

| Synthesis Example | Compound or Polymer | | Mw | Mw/Mn |
|---|---|---|---|---|
| 1 | (BPA-1) | 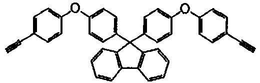 | 580 | 1.03 |
| 2 | (BPA-2) | 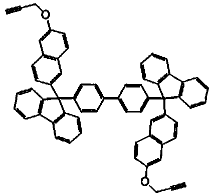 | 965 | 1.08 |
| 3 | (BPA-3) | 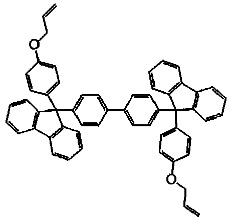 | 740 | 1.03 |
| 4 | (BPA-4) | 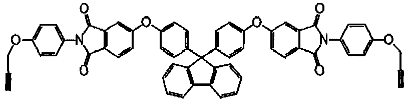 | 930 | 1.01 |
| 5 | (BPA-5) | 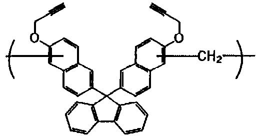 | 2700 | 3.2 |
| 6 | (BPA-6) | 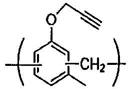 | 9400 | 3.59 |
| 7 | (BPA-7) | 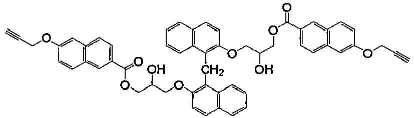 | 900 | 1.04 |

**[Table 2]**

| Synthesis Example | Compound or Polymer | | Mw | Mw/Mn |
|---|---|---|---|---|
| - | (R-1) | 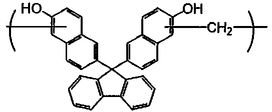 | 3700 | 2.82 |

### Synthesis of Compound for Forming Metal-Containing Film (RM-1) for Comparative Example

8.0 g of butyltin trichloride was stirred at a room temperature, and 10 g of acrylic acid was added dropwise. After the dropwise addition, the temperature was raised to 80°C and stirring was performed for 7 hours. After completion of the reaction, the acrylic acid was removed under reduced pressure, thereby obtaining (RM-1).

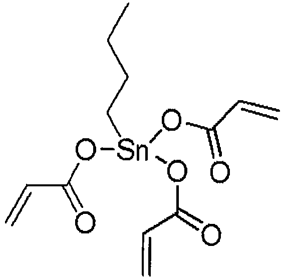

### Composition for Forming Metal-Containing Film UDL-1

The resin BPA-1 and the metal salt (M-13) were dissolved in a mixed solvent of propylene glycol monomethyl ether acetate (PGMEA) containing 0.5% by mass of the surfactant FC-4430 (available from 3M Japan Limited) in the proportions shown in Table 3, and filtered through a 0.02 um membrane filter, thereby preparing the composition for forming a metal-containing film (UDL-1).

### Preparation of Compositions for Forming Metal-Containing Film (UDL-2 to 27) and Compositions for Forming Metal-Containing Film for Comparative Examples (Comparative Examples UDL-1 to 5)

The respective chemical solutions were prepared by the same operation as in UDL-1, except that the kinds and amounts of the respective components were as shown in Table 3. Note that in Table 3, "-" indicates that the corresponding component was not used. Ethylene glycol dibenzyl ether (boiling point: 364°C) was used as the high-boiling-point solvent (F-1). ZrO₂ nanoparticles (5 nm core, 915505, Sigma-Aldrich Corp) were used as the metal nanoparticles (NP-1).

**[Table 3]**

| Composition for forming metal-containing film | Resin | Compound for forming metal-containing film | Additive | Solvent |
|---|---|---|---|---|
| | (parts by mass) | (parts by mass) | (parts by mass) | (parts by mass) |
| UDL-1 | BPA-1 (5) | M-13 (5) | - | PGMEA (100) |
| UDL-2 | BPA-2 (5) | M-13 (5) | - | PGMEA (100) |
| UDL-3 | BPA-3 (5) | M-13 (5) | - | PGMEA (100) |
| UDL-4 | BPA-4 (5) | M-13 (5) | - | PGMEA (100) |
| UDL-5 | BPA-5 (5) | M-13 (5) | - | PGMEA (100) |
| UDL-6 | BPA-6 (5) | M-13 (5) | - | PGMEA (100) |
| UDL-7 | BPA-7 (5) | M-13 (5) | - | PGMEA (100) |
| UDL-8 | BPA-2 (5) | M-13 (5) | F-1 (1) | PGMEA (100) |
| UDL-9 | BPA-2 (5) | M-13 (5) | XL-1 (1) | PGMEA (100) |
| UDL-10 | BPA-2 (5) | M-13 (5) | XL-2 (1) | PGMEA (100) |
| | | | D-1 (0.5) | |
| UDL-11 | BPA-1 (5) | M-1 (5) | - | PGMEA (100) |
| UDL-12 | BPA-2 (5) | M-2 (5) | - | PGMEA (100) |
| UDL-13 | BPA-3 (5) | M-3 (5) | - | PGMEA (100) |
| UDL-14 | BPA-4 (5) | M-4 (5) | - | PGMEA (100) |
| UDL-15 | BPA-5 (5) | M-5 (5) | - | PGMEA (100) |
| UDL-16 | BPA-6 (5) | M-6 (5) | - | PGMEA (100) |
| UDL-17 | BPA-7 (5) | M-7 (5) | - | PGMEA (100) |
| UDL-18 | BPA-1 (5) | M-8 (5) | - | PGMEA (100) |
| UDL-19 | BPA-2 (5) | M-9 (5) | - | PGMEA (100) |
| UDL-20 | BPA-3 (5) | M-10 (5) | - | PGMEA (100) |
| UDL-21 | BPA-4 (5) | M-11 (5) | - | PGMEA (100) |
| UDL-22 | BPA-5 (5) | M-12 (5) | - | PGMEA (100) |
| UDL-23 | BPA-6 (5) | M-13 (5) | - | PGMEA (100) |
| UDL-24 | BPA-7 (5) | M-14 (5) | - | PGMEA (100) |
| UDL-25 | BPA-1 (5) | M-15 (5) | - | PGMEA (100) |
| UDL-26 | BPA-2 (5) | M-16 (5) | - | PGMEA (100) |
| UDL-27 | BPA-3 (5) | M-17 (5) | - | PGMEA (100) |
| Comp. Ex. UDL-1 | BPA-3 (5) | - | - | PGMEA (100) |
| Comp. Ex. UDL-2 | - | M-13 (10) | - | PGMEA (100) |
| Comp. Ex. UDL-3 | BPA-3 (5) | - | NP-1 (5) | PGMEA (100) |
| Comp Ex. UDL-4 | BPA-3 (5) | RM-1 (5) | - | PGMEA (100) |
| Comp. Ex. UDL-5 | R-1 (5) | M-13 (5) | - | PGMEA (100) |

Of the compositions for forming a metal-containing film prepared as above, generation of precipitates was observed in Comparative Example UDL-5 using the resin containing a phenolic hydroxyl group, and thus subsequent evaluation thereof was cancelled. On the other hand, in the compositions for forming a metal-containing film of the present invention UDL-1 to 27, generation of precipitates was not observed. This is presumably because the resin used as the flowability accelerator did not contain a phenolic hydroxyl group.

### Examples 1-1 to 1-27, Comparative Examples 1-1 to 1-4: Etching Resistance

The composition for forming a metal-containing film (UDL-1 to 27 and Comparative Example UDL-1 to 4) was applied onto a silicon substrate and heated at 350°C for 60 seconds using a hot plate, thereby forming a metal-containing film having a film thickness of 80 nm. Film thickness A was measured. Next, etching with CF₄ gas was performed for 30 seconds under the following conditions using a dry etching system TE-8500 produced by Tokyo Electron Limited, and film thickness B was measured. Film thickness etched in 30 seconds (film thickness B - film thickness A) was calculated as etching resistance.

For the etching with CF₄ gas, when difference between the film thickness B and A was less than 30 nm, it was evaluated as "A" (very good). When the difference was 30 nm or more and less than 50 nm, it was evaluated as "B" (good). When the difference was 50 nm or more, it was evaluated as "C" (poor). The results are shown in Table 4.

Dry etching conditions with CF₄ gas
Chamber pressure: 100 mT
RF power (upper portion): 500 W
RF power (lower portion): 400 W
CF₄ gas flow rate: 300 sccm
Time: 30 sec

**[Table 4]**

| Example | Composition for forming metal-containing film | Etching resistance |
|---|---|---|
| | | CF₄ |
| Example 1-1 | UDL-1 | A |
| Example 1-2 | UDL-2 | A |
| Example 1-3 | UDL-3 | A |
| Example 1-4 | UDL-4 | A |
| Example 1-5 | UDL-5 | A |
| Example 1-6 | UDL-6 | B |
| Example 1-7 | UDL-7 | B |
| Example 1-8 | UDL-8 | A |
| Example 1-9 | UDL-9 | A |
| Example 1-10 | UDL-10 | A |
| Example 1-11 | UDL-11 | A |
| Example 1-12 | UDL-12 | A |
| Example 1-13 | UDL-13 | A |
| Example 1-14 | UDL-14 | A |
| Example 1-15 | UDL-15 | A |
| Example 1-16 | UDL-16 | B |
| Example 1-17 | UDL-17 | B |
| Example 1-18 | UDL-18 | A |
| Example 1-19 | UDL-19 | A |
| Example 1-20 | UDL-20 | A |
| Example 1-21 | UDL-21 | A |
| Example 1-22 | UDL-22 | A |
| Example 1-23 | UDL-23 | B |
| Example 1-24 | UDL-24 | B |
| Example 1-25 | UDL-25 | A |
| Example 1-26 | UDL-26 | A |
| Example 1-27 | UDL-27 | A |
| Comp. Ex. 1-1 | Comp. Ex. UDL-1 | C |
| Comp. Ex. 1-2 | Comp. Ex. UDL-2 | A |
| Comp. Ex. 1-3 | Comp. Ex. UDL-3 | A |
| Comp. Ex. 1-4 | Comp. Ex. UDL-4 | B |

As shown in Table 4, it was found that in Examples 1-1 to 1-27 each using the composition for forming a metal-containing film of the present invention, good etching resistance to CF₄ gas was demonstrated. Particularly, the compositions for forming a metal-containing film using the flowability accelerator (BPA-1 to 5) containing a cardo structure demonstrated excellent dry etching resistance.

On the other hand, Comparative Example UDL-1 containing no metal source (B) demonstrated insufficient dry etching resistance. Additionally, in Comparative Example UDL-4 using, as the metal source, the organotin compound (RM-1) which was not a carboxylic acid salt or a complex with a β-diketone, enhanced dry etching resistance was observed as compared with Comparative Example UDL-1 using only the flowability accelerator; but presumably because of the insufficient heat resistance and curing property of the organotin compound (RM-1), the resist underlayer film contained a small proportion of the metal oxide and dry etching resistance was not enhanced enough.

### Examples 2-1 to 2-27, Comparative Examples 2-1 to 2-4: Evaluation of Filling and Planarizing Properties

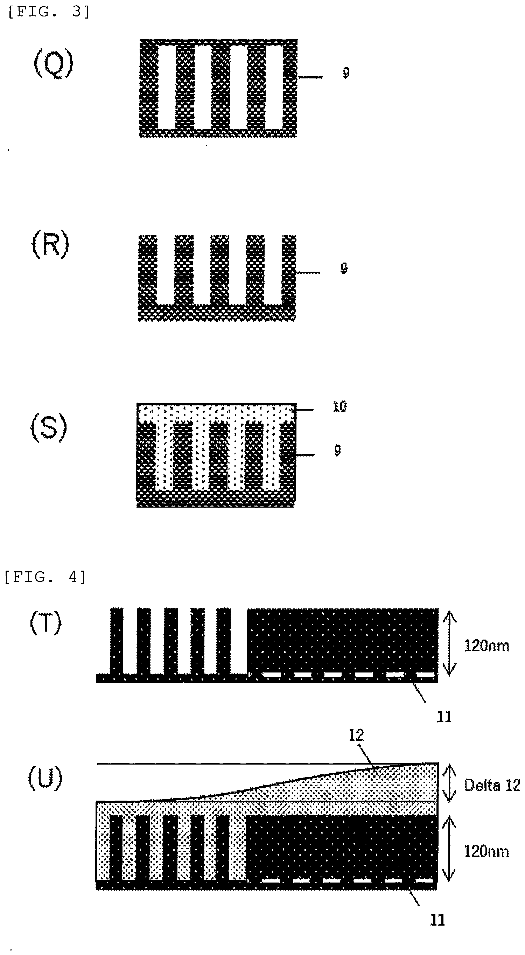

Each of the above-described compositions for forming a metal-containing film (UDL-1 to 27, Comparative Example UDL-1 to 4) was applied onto a SiOz wafer substrate having a dense line-and-space pattern (line width: 60 nm, line depth: 100 nm, distance between the centers of two adjacent lines: 120 nm), heated at the temperature shown in Table 5 for 60 seconds using a hot plate, thereby forming a metal-containing film having a film thickness of 80 nm. The used substrate was a base substrate 9 (SiO₂ wafer substrate) having a dense line-and-space pattern as illustrated in FIGs. 3(Q) (overhead view) and 3(R) (cross-sectional view).

The cross-sectional shape of each wafer substrate thus obtained was observed using an electron microscope (S-4700) produced by Hitachi Ltd., and whether a stepped substrate could be filled was confirmed. The results are shown in Table 5.

When the composition for forming a metal-containing film having a poor filling property is used, the stepped substrate cannot be successfully filled in this evaluation. When the composition for forming a metal-containing film having a good filling property is used, a metal-containing resist underlayer film 10 can fill the space between lines of the base substrate 9 having the dense line-and-space pattern without gaps, as illustrated in FIG. 3(S) in this evaluation. "Good" means that filling can be done without large voids, and "poor" means that filling is impossible.

Furthermore, as shown in FIG. 4, the cross-sectional shape of each wafer substrate 11 obtained in the above filling evaluation was observed using a scanning electron microscope (SEM), and the step (Delta 12 in FIG. 4(U)) between the dense line-and-pattern portion and the non-line pattern portion of the filling film (metal-containing resist underlayer film 12) was observed using an electron microscope (S-4700) produced by Hitachi Ltd. The results are shown in Table 5. In this evaluation, it can be deemed that the smaller the step, the better the planarizing property.

**[Table 5]**

| Example | Composition for forming metal-containing film | Filling property | Planarizing property | Bake temperature |
|---|---|---|---|---|
| | | 60LS | nm | °C |
| Example 2-1 | UDL-1 | Good | 30 | 350 |
| Example 2-2 | UDL-2 | Good | 28 | 350 |
| Example 2-3 | UDL-3 | Good | 30 | 350 |
| Example 2-4 | UDL-4 | Good | 32 | 350 |
| Example 2-5 | UDL-5 | Good | 33 | 350 |
| Example 2-6 | UDL-6 | Good | 29 | 350 |
| Example 2-7 | UDL-7 | Good | 28 | 350 |
| Example 2-8 | UDL-8 | Good | 26 | 350 |
| Example 2-9 | UDL-9 | Good | 28 | 350 |
| Example 2-10 | UDL-10 | Good | 29 | 350 |
| Example 2-11 | UDL-11 | Good | 31 | 350 |
| Example 2-12 | UDL-12 | Good | 29 | 350 |
| Example 2-13 | UDL-13 | Good | 30 | 350 |
| Example 2-14 | UDL-14 | Good | 32 | 350 |
| Example 2-15 | UDL-15 | Good | 33 | 350 |
| Example 2-16 | UDL-16 | Good | 30 | 350 |
| Example 2-17 | UDL-17 | Good | 29 | 350 |
| Example 2-18 | UDL-18 | Good | 30 | 350 |
| Example 2-19 | UDL-19 | Good | 29 | 350 |
| Example 2-20 | UDL-20 | Good | 30 | 350 |
| Example 2-21 | UDL-21 | Good | 31 | 350 |
| Example 2-22 | UDL-22 | Good | 33 | 350 |
| Example 2-23 | UDL-23 | Good | 30 | 350 |
| Example 2-24 | UDL-24 | Good | 28 | 350 |
| Example 2-25 | UDL-25 | Good | 32 | 350 |
| Example 2-26 | UDL-26 | Good | 30 | 350 |
| Example 2-27 | UDL-27 | Good | 30 | 350 |
| Comp. Ex. 2-1 | Comp. Ex. UDL-1 | Good | 29 | 350 |
| Comp. Ex. 2-2 | Comp. Ex. UDL-2 | Poor | 33 | 350 |
| Comp. Ex. 2-3 | Comp. Ex. UDL-3 | Good | 29 | 350 |
| Comp. Ex. 2-4 | Comp. Ex. UDL-4 | poor | 34 | 350 |

As shown in Table 5, it was confirmed that in Examples 2-1 to 2-27 each using the composition for forming a metal-containing film of the present invention, it was possible to fill the dense line-and-space pattern without generating voids when baking was performed at 350°C, and a good filling property was exhibited. Focusing on the flowability accelerator contained in the composition for forming a metal-containing film, the results show that Examples using the resin (BPA-2, 4 to 7) containing a propargyl group exhibited the excellent planarizing property. Particularly, Examples using BPA-6 or 7 with a compact structure of the resin demonstrated the excellent planarizing property. Furthermore, Example 2-8 using the high-boiling-point solvent (F-1) resulted in the more excellent planarizing property.

On the other hand, in Comparative Example 2-2 using Comparative Example UDL-2 containing no flowability accelerator (resin), voids were observed at the bottom of the pattern. This is presumably because volume shrinkage of the metal compound during baking caused the voids.

Furthermore, in Comparative Example 2-4 using Comparative Example UDL-4 containing the comparative compound (RM-1) as the monomolecular tin compound, voids were observed at the bottom of the pattern. This is presumably because of the insufficient heat resistance and curing property of the compound (RM-1).

### Examples 3-1 to 3-10, Comparative Examples 3-1 to 3-4: Patterning Process

On a Si substrate with 100 nm of SiO₂ film deposited thereon, the above composition for forming a metal-containing film (UDL-1 to 10 and Comparative Example UDL-1 to 4) was applied by spin coating and baked at 350°C for 60 seconds, thereby fabricating a resist underlayer film having a film thickness of 80 nm. A silicon atom-containing resist middle layer material (SOG-1) was applied thereon and baked at 220°C for 60 seconds, thereby forming a resist middle layer film having a film thickness of 30 nm. Then, a single-layer resist for ArF as a resist upper layer film material was applied thereon and baked at 105°C for 60 seconds, thereby forming a photoresist film having a film thickness of 100 nm. A liquid immersion topcoat material (TC-1) was applied onto the photoresist film and baked at 90°C for 60 seconds, thereby forming a topcoat having a film thickness of 50 nm.

The silicon atom-containing resist middle layer material (SOG-1) was prepared by dissolving a polymer denoted by an ArF silicon-containing middle layer film polymer (SiP1) and a crosslinking catalyst (CAT1) in an organic solvent containing 0.1% by mass of FC-4430 (produced by 3M Japan Limited) in the proportions shown in Table 6, and filtering through a filter made of a fluororesin having a pore size of 0.1 µm.

**[Table 6]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The resist upper layer film material (single-layer resist for ArF) was prepared by dissolving a polymer (RP1), an acid generator (PAG1), and a basic compound (Amine1) in a solvent containing 0.1% by mass of a surfactant FC-4430 (produced by 3M Japan Limited) in the proportions shown in Table 7, and filtering through a 0.1 µm filter made of a fluororesin.

**[Table 7]**

| | Polymer (parts by mass) | Acid generator (parts by mass) | Basic compound (parts by mass) | Solvent (parts by mass) |
|---|---|---|---|---|
| Single-layer resist for ArF | RP1 (100) | PAG1 (6.6) | Amine1 (0.8) | PGMEA (2,500) |

The polymer (RP1), the acid generator (PAG1), and the basic compound (Amine1) used in the resist upper layer film material (single-layer resist for ArF) are shown below.

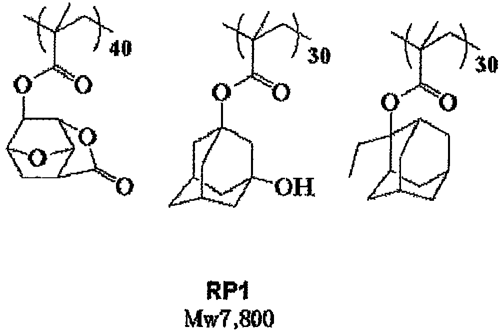

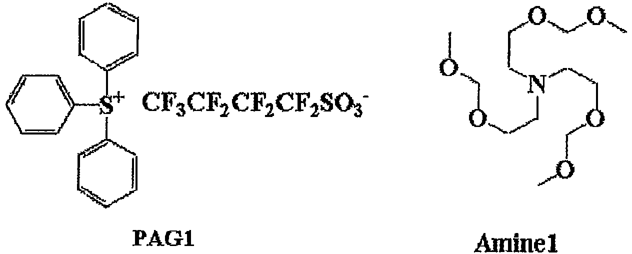

The liquid immersion topcoat material (TC-1) was prepared by dissolving a topcoat polymer (PP1) in an organic solvent in the proportion shown in Table 8 and filtering through a 0.1 µm filter made of a fluororesin.

**[Table 8]**

| | Topcoat polymer (parts by mass) | Organic solvent (parts by mass) |
|---|---|---|
| TC-1 | PP1 (100) | Diisoamyl ether (2,700) |
| | | 2-methyl-1-butanol (270) |

The topcoat polymer (PP1) used in the liquid immersion topcoat material (TC-1) is shown below.

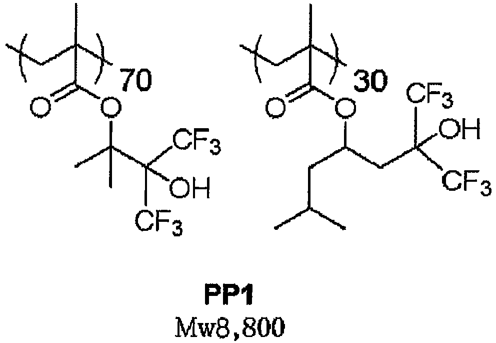

Next, exposure was performed using an ArF immersion lithography system (produced by Nikon Corporation; NSR-S610C, NA1.30, σ0.98/0.78, 35° s-polarized dipole illumination, 6% half-tone phase-shifting mask), followed by baking (PEB) at 100°C for 60 seconds and development for 30 seconds using a 2.38% by mass tetramethylammonium hydroxide (TMAH) aqueous solution, thereby obtaining a 50 nm 1:1 positive line-and-space pattern (resist upper layer film pattern).

Next, the silicon-containing resist middle layer film was processed by dry etching using an etching system CE-300I produced by ULVAC Inc. while using the resist upper layer film pattern as a mask, thereby forming a resist middle layer film pattern. The resist underlayer film was etched by using the resist middle layer film pattern thus obtained as a mask to form a pattern, and the SiO₂ film was processed by etching while using the resist underlayer film pattern thus obtained as a mask. Etching conditions are as described below.

The cross section of the pattern was observed using S-4700 (electron microscope produced by Hitachi Ltd.). Additionally, the length of the line dimension after the processing was measured using a CD-SEM (S9200) produced by Hitachi High-Tech Corporation, and LWR was observed. The results are shown in Table 9.

Conditions for transferring the resist upper layer film pattern to the silicon-containing resist middle layer film.
Dry etching conditions with CF₄ gas
Pressure: 1 Pa
Antenna RF power: 100 W
Bias RF power: 15 W
CF₄ gas flow rate: 15 sccm
Time: 20 sec

Conditions for transferring from the silicon-containing resist middle layer film to the resist underlayer film.
Dry etching conditions with Cl₂ gas
Pressure: 1 Pa
Antenna RF power: 320 W
Bias RF power: 30 W
Cl₂ gas flow rate: 25 sccm
Time: 60 sec

Conditions for transferring the resist underlayer film pattern to the SiO₂ film.
Dry etching conditions with CF₄ gas
Pressure: 1 Pa
Antenna RF power: 100 W
Bias RF power: 15 W
CF₄ gas flow rate: 15 sccm
Time: 60 sec

**[Table 9]**

| Example | Composition for forming metal-containing film | Pattern shape after substrate processing | |
|---|---|---|---|
| | | Cross-sectional shape | LWR |
| Example 3-1 | UDL-1 | Vertical profile | 2.4 |
| Example 3-2 | UDL-2 | Vertical profile | 2.3 |
| Example 3-3 | UDL-3 | Vertical profile | 2.3 |
| Example 3-4 | UDL-4 | Vertical profile | 2.4 |
| Example 3-5 | UDL-5 | Vertical profile | 2.3 |
| Example 3-6 | UDL-6 | Vertical profile | 2.6 |
| Example 3-7 | UDL-7 | Vertical profile | 2.5 |
| Example 3-8 | UDL-8 | Vertical profile | 2.3 |
| Example 3-9 | UDL-9 | Vertical profile | 2.3 |
| Example 3-10 | UDL-10 | Vertical profile | 2.4 |
| Comp. Ex. 3-1 | Comp. Ex. UDL-1 | Tapered profile | 3.6 |
| Comp. Ex. 3-2 | Comp. Ex. UDL-2 | Vertical profile | 2.4 |
| Comp. Ex. 3-3 | Comp. Ex. UDL-3 | Vertical profile | 3.3 |
| Comp. Ex. 3-4 | Comp. Ex. UDL-4 | Tapered profile | 3.4 |

As shown in Table 9, regarding all the compositions for forming a metal-containing film of the present invention (UDL-1 to 10), the resist upper layer film pattern was successively transferred to the substrate in the end, and it was confirmed that the compositions are suitable for use for fine processing by a multilayer resist method. Particularly, in Examples using the composition for forming a metal-containing film that contained the flowability accelerator (BPA-1 to 5) containing a cardo structure and exhibited excellent dry etching resistance in the above evaluation, excellent LWR was demonstrated.

On the other hand, in Comparative Example 3-1 using Comparative Example UDL-1 containing no metal source (B), the cross section of the pattern after processing the substrate did not have a vertical profile, and degraded LWR was observed in the pattern when seen from the air. In Comparative Example 3-3 using Comparative Example UDL-3 containing the metal nanoparticles, the cross section of the pattern after processing the substrate had a vertical profile, but degraded LWR was observed in the pattern when seen from the air. In Comparative Example 3-4 using Comparative Example UDL-4 containing the comparative compound (RM-1) as the organotin compound, the cross section of the pattern after processing the substrate did not have a vertical profile, and degraded LWR was observed in the pattern when seen from the air. This is presumably because the insufficient heat resistance and curing property of the organotin compound (RM-1) lead to a small proportion of the metal oxide contained in the resist underlayer film, as well as the dry etching resistance not enhanced enough.

Accordingly, the composition for forming a metal-containing film of the present invention can yield a resist underlayer film with a high metal content, and thus exhibits excellent dry etching resistance as compared with conventional organic resist underlayer films. Furthermore, it can provide a resist underlayer film material having both of high filling/planarizing properties, which is difficult to obtain by conventional metal-containing resist underlayer films, and is extremely useful as the resist underlayer film material used for a multilayer resist method.

The present description encompasses the following inventions.
[1]: A composition for forming a metal-containing film, comprising (A) a resin, (B) a metal source, and (C) an organic solvent, wherein the resin (A) contains no phenolic hydroxyl group, and the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.
[2]: The composition for forming a metal-containing film according to [1], wherein the resin (A) contains one or more crosslinking groups selected from a substituted or unsubstituted vinyl group, allyl group, allyloxy group, ethynyl group, propargyl group, propargyloxy group, epoxy group, or oxetanyl group.
[3]: The composition for forming a metal-containing film according to [1] or [2], wherein the resin (A) contains an aromatic ring, an alicyclic hydrocarbon, or a heteroaromatic ring, and contains any crosslinking group represented by the following formulae (1), 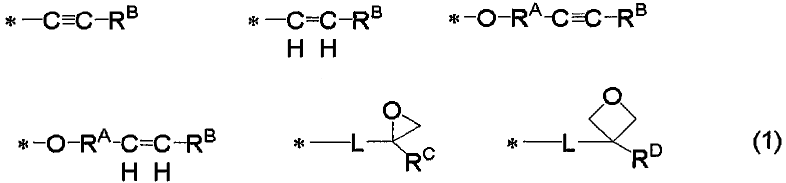 wherein * represents a bonding position to the aromatic ring, the alicyclic hydrocarbon, or the heteroaromatic ring; R^{A} represents a divalent organic group having 1 to 10 carbon atoms; R^{B} represents a hydrogen atom or a monovalent organic group having 1 to 10 carbon atoms; R^{C} and R^{D} represent any of a hydrogen atom, a hydroxyl group, an alkyl group having 1 to 10 carbon atoms, an aryl group having 1 to 10 carbon atoms, and an alkoxy group having 1 to 10 carbon atoms; and L represents a divalent organic group having 1 to 10 carbon atoms.
[4]: The composition for forming a metal-containing film according to any one of [1] to [3], wherein the metal source (B) is a salt of the metal with a monovalent to tetravalent carboxylic acid having 1 to 30 carbon atoms.
[5]: The composition for forming a metal-containing film according to any one of [1] to [4], wherein the metal source (B) has a structure represented by the following formula (B-1), 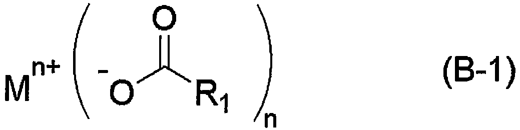 wherein M is selected from any of Ti, Cr, Mn, Fe, Co, Ni, Cu, Zn, Zr, Mo, In, Sn, Hf, and Bi; R₁ represents a monovalent organic group having 1 to 30 carbon atoms; and "n" represents an integer of 1 to 4.
[6]: The composition for forming a metal-containing film according to any one of [1] to [5], wherein the metal of the metal source (B) is Sn.
[7]: The composition for forming a metal-containing film according to any one of [1] to [6], wherein the resin (A) contains at least one of constitutional units represented by the following general formulae (G-1) to (G-5), 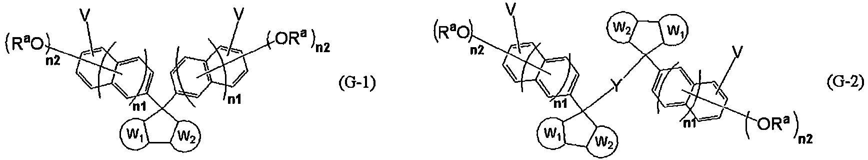 wherein W₁ and W₂ each independently represents a benzene ring or a naphthalene ring, a hydrogen atom in the benzene ring and the naphthalene ring optionally being substituted with a hydrocarbon group having 1 to 6 carbon atoms; R^{a} is represented by the following general formulae (Z-1); Y represents any group represented by the following general formulae (Z-2); "m" represents 0 or 1; "n₂" represents 1 or 2; and V each independently represents a hydrogen atom or an attachment point; 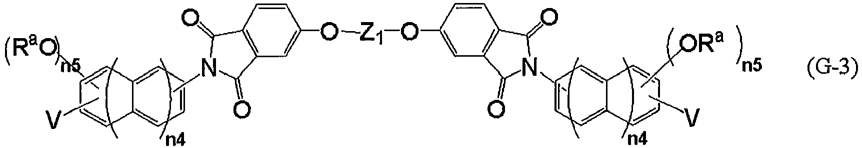 wherein Z₁ represents any group represented by the following general formulae (Z-3); R^{a} is represented by the following general formulae (Z-1); "n₄" represents 0 or 1; "n₅" represents 1 or 2; and V each independently represents a hydrogen atom or an attachment point; 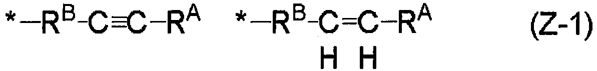 wherein * represents a bonding position to an oxygen atom; R^{B} represents a divalent organic group having 1 to 10 carbon atoms; and R^{A} represents a hydrogen atom or a monovalent organic group having 1 to 10 carbon atoms; 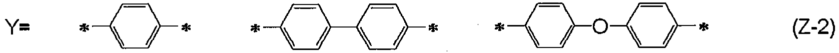 wherein * represents a bonding arm; 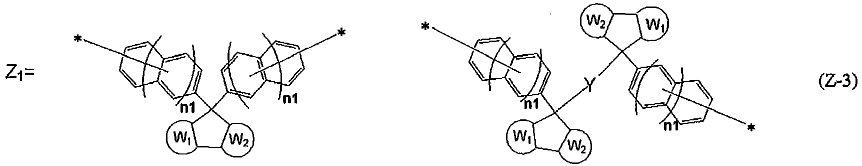 wherein * represents a bonding arm; and W₁, W₂, Y, and "n₁" are as defined above; 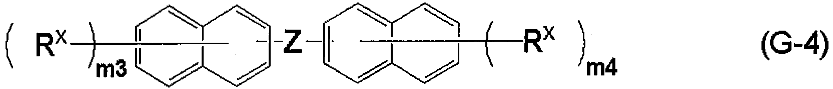 wherein "m₃" and "m₄" represent 1 or 2; Z represents a single bond or any structure represented by the following general formulae (Z-4); and R^{x} represents any structure represented by the following general formulae (Z-5); 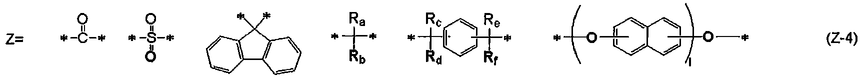 wherein * represents a bonding arm; "l" represents an integer of 0 to 3; Rₐ to R_{f} each independently represents a hydrogen atom or an optionally fluorinated alkyl group having 1 to 10 carbon atoms, phenyl group, or phenylethyl group, where Rₐ and R_{b} optionally bond together to form a cyclic compound; 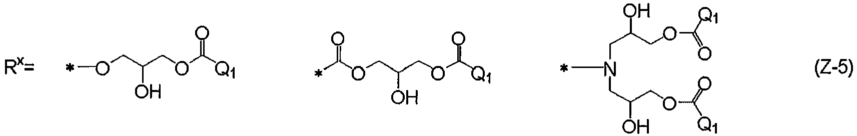 wherein * represents a bonding position to an aromatic ring; and Q₁ represents a linear saturated hydrocarbon group having 1 to 30 carbon atoms, or a structure represented by the following general formula (Z-6) ; 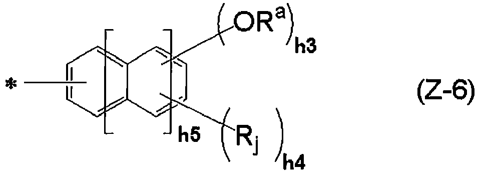 wherein * represents a bonding position to a carbonyl group; R^{a} is represented by the general formulae (Z-1); Rⱼ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; "h₃" and "h₄" represent the number of substituents on an aromatic ring, and each represents an integer of 0 to 7, provided that h₃+h₄ is 0 or more and 7 or less; and "h₅" represents 0 to 2; 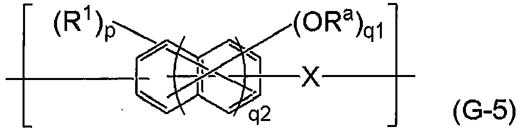 wherein R¹ represents a saturated monovalent organic group having 1 to 30 carbon atoms, or an unsaturated monovalent organic group having 2 to 30 carbon atoms; X represents a divalent organic group having 1 to 30 carbon atoms; R^{a} is represented by the general formulae (Z-1); "p" represents an integer of 0 to 5, "q₁" represents an integer of 1 to 6, and p+q₁ equals an integer of 1 or more and 6 or less; and "q₂" represents 0 or 1.
[8]: The composition for forming a metal-containing film according to any one of [1] to [7], further comprising one or more of (D) a crosslinking agent, (E) an acid generator, (F) a surfactant, and (G) a colorant.
[9]: The composition for forming a metal-containing film according to any one of [1] to [8], wherein the organic solvent (C) is a mixture of one or more kinds of organic solvents having a boiling point of less than 180°C and one or more kinds of organic solvents having a boiling point of 180°C or higher ((C') a high-boiling-point solvent).
[10] : A patterning process for forming a pattern in a substrate to be processed, comprising steps of: (I-1) applying the composition for forming a metal-containing film according to any one of [1] to [9] on the substrate to be processed and thereafter performing heat treatment to form a metal-containing film; (I-2) forming a resist upper layer film on the metal-containing film using a photoresist material; (I-3) forming a pattern in the resist upper layer film by developing the resist upper layer film using a developer after pattern exposure; (I-4) transferring the pattern to the metal-containing film by dry etching while using the resist upper layer film having the formed pattern as a mask; and (I-5) processing the substrate to be processed while using the metal-containing film having the formed pattern as a mask to form the pattern in the substrate to be processed.
[11]: A patterning process for forming a pattern in a substrate to be processed, comprising steps of: (II-1) applying the composition for forming a metal-containing film according to any one of [1] to [9] on the substrate to be processed and thereafter performing heat treatment to form a metal-containing film; (II-2) forming a silicon-containing resist middle layer film on the metal-containing film; (II-3) forming a resist upper layer film on the silicon-containing resist middle layer film using a photoresist material; (II-4) forming a pattern in the resist upper layer film by developing the resist upper layer film using a developer after pattern exposure; (II-5) transferring the pattern to the silicon-containing resist middle layer film by dry etching while using the resist upper layer film having the formed pattern as a mask; (II-6) transferring the pattern to the metal-containing film by dry etching while using the silicon-containing resist middle layer film having the transferred pattern as a mask; and (II-7) processing the substrate to be processed while using the metal-containing film having the formed pattern as a mask to form the pattern in the substrate to be processed.
[12] : A patterning process for forming a pattern in a substrate to be processed, comprising steps of: (III-1) applying the composition for forming a metal-containing film according to any one of [1] to [9] on the substrate to be processed and thereafter performing heat treatment to form a metal-containing film; (III-2) forming an inorganic hard mask middle layer film selected from a silicon oxide film, a silicon nitride film, and a silicon oxynitride film on the metal-containing film; (III-3) forming an organic thin film on the inorganic hard mask middle layer film; (III-4) forming a resist upper layer film on the organic thin film using a photoresist material; (III-5) forming a pattern in the resist upper layer film by developing the resist upper layer film using a developer after pattern exposure; (III-6) transferring the pattern to the organic thin film and the inorganic hard mask middle layer film by dry etching while using the resist upper layer film having the formed pattern as a mask; (III-7) transferring the pattern to the metal-containing film by dry etching while using the inorganic hard mask middle layer film having the transferred pattern as a mask; and (III-8) processing the substrate to be processed while using the metal-containing film having the formed pattern as a mask to form the pattern in the substrate to be processed.
[13] : A patterning process for forming a pattern in a substrate to be processed, comprising steps of: (IV-1) applying the composition for forming a metal-containing film according to any one of [1] to [9] on the substrate to be processed and thereafter performing heat treatment to form a metal-containing film; (IV-2) forming an organic middle layer film on the metal-containing film; (IV-3) forming a silicon-containing resist middle layer film or a combination of an inorganic hard mask middle layer film selected from a silicon oxide film, a silicon nitride film, and a silicon oxynitride film and an organic thin film on the organic middle layer film; (IV-4) forming a resist upper layer film on the silicon-containing resist middle layer film or the organic thin film using a photoresist material; (IV-5) forming a pattern in the resist upper layer film by developing the resist upper layer film using a developer after pattern exposure; (IV-6) transferring the pattern to the silicon-containing resist middle layer film or the organic thin film and the inorganic hard mask middle layer film by dry etching while using the resist upper layer film having the formed pattern as a mask; (IV-7) transferring the pattern to the organic middle layer film by dry etching while using the silicon-containing resist middle layer film or the inorganic hard mask middle layer film having the transferred pattern as a mask; (IV-8) transferring the pattern to the metal-containing film by dry etching while using the organic middle layer film as a mask; and (IV-9) processing the substrate to be processed while using the metal-containing film having the formed pattern as a mask to form the pattern in the substrate to be processed.
[14]: A patterning process for forming a tone-reversal pattern in a substrate to be processed, comprising steps of: (V-1) forming a resist underlayer film on the substrate to be processed; (V-2) forming a resist middle layer film or a combination of an inorganic hard mask middle layer film selected from a silicon oxide film, a silicon nitride film, and a silicon oxynitride film and an organic thin film on the resist underlayer film; (V-3) forming a resist upper layer film on the resist middle layer film or the combination of the inorganic hard mask middle layer film and the organic thin film using a photoresist material; (V-4) forming a pattern in the resist upper layer film by developing the resist upper layer film using a developer after pattern exposure; (V-5) transferring the pattern to the resist middle layer film or the organic thin film and the inorganic hard mask middle layer film by dry etching while using the resist upper layer film having the formed pattern as a mask; (V-6) transferring the pattern to the resist underlayer film by dry etching while using the resist middle layer film or the inorganic hard mask middle layer film having the transferred pattern as a mask; (V-7) applying the composition for forming a metal-containing film according to any one of [1] to [9] on the resist underlayer film having the formed pattern, and thereafter performing heat treatment to cover with the metal-containing film and fill an in-between space in the pattern of the resist underlayer film with the metal-containing film; (V-8) etching back the metal-containing film covering over the resist underlayer film having the formed pattern by a chemical stripper or dry etching to expose an upper surface of the resist underlayer film having the formed pattern; (V-9) removing the resist middle layer film or the hard mask middle layer film remaining on the upper surface of the resist underlayer film by dry etching; (V-10) removing the resist underlayer film having the formed pattern with its surface exposed by dry etching to form a reverse pattern of an original pattern, the reverse pattern being formed of the metal-containing film; and (V-11) processing the substrate to be processed while using the metal-containing film having the formed reverse pattern as a mask to form the reverse pattern in the substrate to be processed.
[15]: The patterning process according to [10], wherein the pattern exposure is performed using EUV light in the step (I-3).
[16]: The patterning process according to [11], wherein the pattern exposure is performed using EUV light in the step (II-4).
[17]: The patterning process according to [12], wherein the pattern exposure is performed using EUV light in the step (III-5).
[18]: The patterning process according to [13], wherein the pattern exposure is performed using EUV light in the step (IV-5).
[19]: The patterning process according to [14], wherein the pattern exposure is performed using EUV light in the step (V-4).

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A composition for forming a metal-containing film, comprising (A) a resin, (B) a metal source, and (C) an organic solvent,
wherein the resin (A) contains no phenolic hydroxyl group, and
the metal source (B) is a salt of a metal selected from Ti, Cr, Mn, Fe, Co, Ni, Cu, Zn, Zr, Mo, In, Sn, Hf, and Bi with a monovalent to tetravalent carboxylic acid having 1 to 30 carbon atoms, or a complex of the metal with a β-diketone.

2. The composition for forming a metal-containing film according to claim 1, wherein the resin (A) contains one or more crosslinking groups selected from a substituted or unsubstituted vinyl group, allyl group, allyloxy group, ethynyl group, propargyl group, propargyloxy group, epoxy group, or oxetanyl group.

3. The composition for forming a metal-containing film according to claim 1, wherein the resin (A) contains an aromatic ring, an alicyclic hydrocarbon, or a heteroaromatic ring, and contains any crosslinking group represented by the following formulae (1), 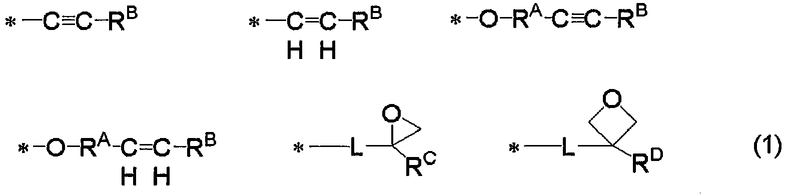 wherein * represents a bonding position to the aromatic ring, the alicyclic hydrocarbon, or the heteroaromatic ring; R^{A} represents a divalent organic group having 1 to 10 carbon atoms; R^{B} represents a hydrogen atom or a monovalent organic group having 1 to 10 carbon atoms; R^{C} and R^{D} represent any of a hydrogen atom, a hydroxyl group, an alkyl group having 1 to 10 carbon atoms, an aryl group having 1 to 10 carbon atoms, and an alkoxy group having 1 to 10 carbon atoms; and L represents a divalent organic group having 1 to 10 carbon atoms.

4. The composition for forming a metal-containing film according to claim 1, wherein the metal source (B) is a salt of the metal with a monovalent to tetravalent carboxylic acid having 1 to 30 carbon atoms.

5. The composition for forming a metal-containing film according to claim 1, wherein the metal source (B) has a structure represented by the following formula (B-1), 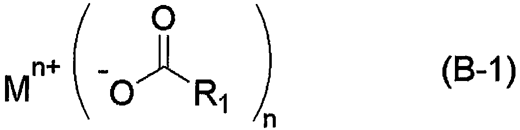 wherein M is selected from any of Ti, Cr, Mn, Fe, Co, Ni, Cu, Zn, Zr, Mo, In, Sn, Hf, and Bi; R¹ represents a monovalent organic group having 1 to 30 carbon atoms; and "n" represents an integer of 1 to 4.

6. The composition for forming a metal-containing film according to claim 1, wherein the metal of the metal source (B) is Sn.

7. The composition for forming a metal-containing film according to claim 1, wherein the resin (A) contains at least one of constitutional units represented by the following general formulae (G-1) to (G-5), 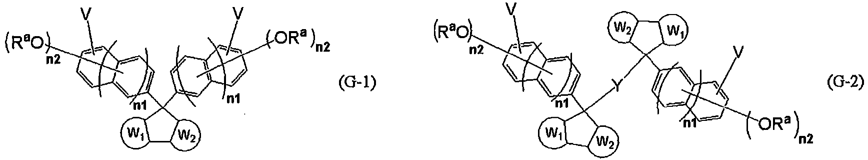 wherein W₁ and W₂ each independently represents a benzene ring or a naphthalene ring, a hydrogen atom in the benzene ring and the naphthalene ring optionally being substituted with a hydrocarbon group having 1 to 6 carbon atoms; R^{a} is represented by the following general formulae (Z-1); Y represents any group represented by the following general formulae (Z-2); "n₁" represents 0 or 1; "n₂" represents 1 or 2; and V each independently represents a hydrogen atom or an attachment point; 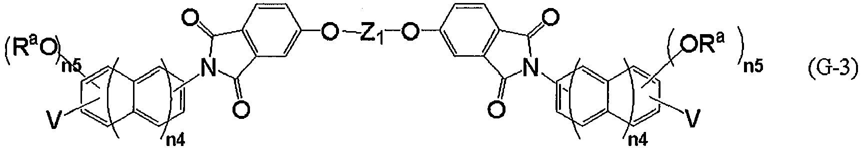 wherein Z₁ represents any group represented by the following general formulae (Z-3); R^{a} is represented by the following general formulae (Z-1); "n₄" represents 0 or 1; "n₅" represents 1 or 2; and V each independently represents a hydrogen atom or an attachment point; 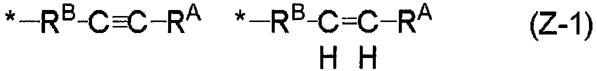 wherein * represents a bonding position to an oxygen atom; R^{B} represents a divalent organic group having 1 to 10 carbon atoms; and R^{A} represents a hydrogen atom or a monovalent organic group having 1 to 10 carbon atoms; 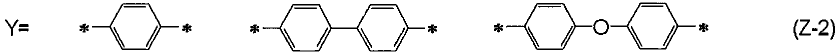 wherein * represents a bonding arm; 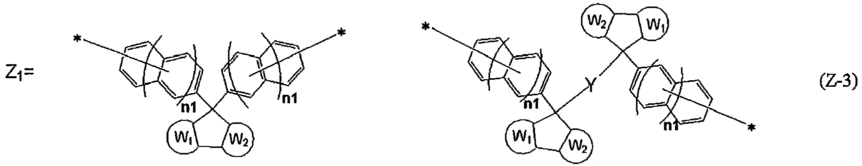 wherein * represents a bonding arm; and W₁, W₂, Y, and "n₁" are as defined above; 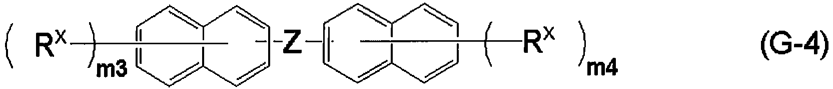 wherein "m₃" and "m₄" represent 1 or 2; Z represents a single bond or any structure represented by the following general formulae (Z-4); and R^{x} represents any structure represented by the following general formulae (Z-5); 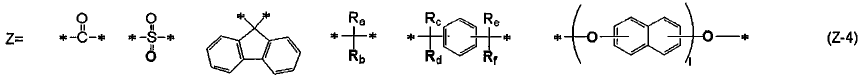 wherein * represents a bonding arm; "l" represents an integer of 0 to 3; Rₐ to R_{f} each independently represents a hydrogen atom or an optionally fluorinated alkyl group having 1 to 10 carbon atoms, phenyl group, or phenylethyl group, where Rₐ and R_{b} optionally bond together to form a cyclic compound; 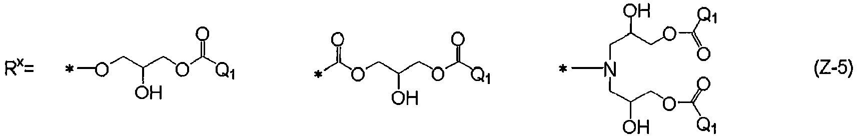 wherein * represents a bonding position to an aromatic ring; and Q₁ represents a linear saturated hydrocarbon group having 1 to 30 carbon atoms, or a structure represented by the following general formula (Z-6) ; 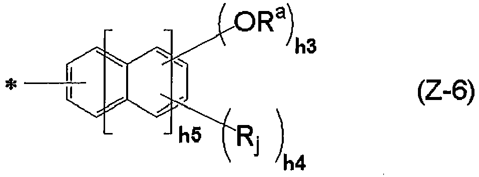 wherein * represents a bonding position to a carbonyl group; R^{a} is represented by the general formulae (Z-1); Rⱼ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; "h₃" and "h₄" represent the number of substituents on an aromatic ring, and each represents an integer of 0 to 7, provided that h₃+h₄ is 0 or more and 7 or less; and "h₅" represents 0 to 2; 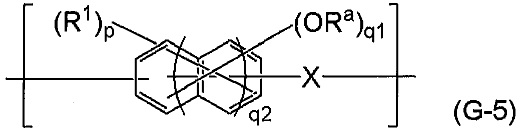 wherein R¹ represents a saturated monovalent organic group having 1 to 30 carbon atoms, or an unsaturated monovalent organic group having 2 to 30 carbon atoms; X represents a divalent organic group having 1 to 30 carbon atoms; R^{a} is represented by the general formulae (Z-1); "p" represents an integer of 0 to 5, "q₁" represents an integer of 1 to 6, and p+q₁ equals an integer of 1 or more and 6 or less; and "q₂" represents 0 or 1.

8. The composition for forming a metal-containing film according to claim 1, further comprising one or more of (D) a crosslinking agent, (E) an acid generator, (F) a surfactant, and (G) a colorant.

9. The composition for forming a metal-containing film according to claim 1, wherein the organic solvent (C) is a mixture of one or more kinds of organic solvents having a boiling point of less than 180°C and one or more kinds of organic solvents having a boiling point of 180°C or higher ((C') a high-boiling-point solvent).

10. A patterning process for forming a pattern in a substrate to be processed, comprising steps of:
(I-1) applying the composition for forming a metal-containing film according to any one of claims 1 to 9 on the substrate to be processed and thereafter performing heat treatment to form a metal-containing film;
(I-2) forming a resist upper layer film on the metal-containing film using a photoresist material;
(I-3) forming a pattern in the resist upper layer film by developing the resist upper layer film using a developer after pattern exposure;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed, preferably,
wherein the pattern exposure is performed using EUV light in the step (I-3).

11. A patterning process for forming a pattern in a substrate to be processed, comprising steps of:
(II-1) applying the composition for forming a metal-containing film according to any one of claims 1 to 9 on the substrate to be processed and thereafter performing heat treatment to form a metal-containing film;
(II-2) forming a silicon-containing resist middle layer film on the metal-containing film;
(II-3) forming a resist upper layer film on the silicon-containing resist middle layer film using a photoresist material;
(II-4) forming a pattern in the resist upper layer film by developing the resist upper layer film using a developer after pattern exposure;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed, preferably,
wherein the pattern exposure is performed using EUV light in the step (II-4).

12. A patterning process for forming a pattern in a substrate to be processed, comprising steps of:
(III-1) applying the composition for forming a metal-containing film according to any one of claims 1 to 9 on the substrate to be processed and thereafter performing heat treatment to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film using a photoresist material;
(III-5) forming a pattern in the resist upper layer film by developing the resist upper layer film using a developer after pattern exposure;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed, preferably,
wherein the pattern exposure is performed using EUV light in the step (III-5).

13. A patterning process for forming a pattern in a substrate to be processed, comprising steps of:
(IV-1) applying the composition for forming a metal-containing film according to any one of claims 1 to 9 on the substrate to be processed and thereafter performing heat treatment to form a metal-containing film;
(IV-2) forming an organic middle layer film on the metal-containing film;
(IV-3) forming a silicon-containing resist middle layer film or a combination of an inorganic hard mask middle layer film selected from a silicon oxide film, a silicon nitride film, and a silicon oxynitride film and an organic thin film on the organic middle layer film;
(IV-4) forming a resist upper layer film on the silicon-containing resist middle layer film or the organic thin film using a photoresist material;
(IV-5) forming a pattern in the resist upper layer film by developing the resist upper layer film using a developer after pattern exposure;
(IV-6) transferring the pattern to the silicon-containing resist middle layer film or the organic thin film and the inorganic hard mask middle layer film by dry etching while using the resist upper layer film having the formed pattern as a mask;
(IV-7) transferring the pattern to the organic middle layer film by dry etching while using the silicon-containing resist middle layer film or the inorganic hard mask middle layer film having the transferred pattern as a mask;
(IV-8) transferring the pattern to the metal-containing film by dry etching while using the organic middle layer film as a mask; and
(IV-9) processing the substrate to be processed while using the metal-containing film having the formed pattern as a mask to form the pattern in the substrate to be processed, preferably
wherein the pattern exposure is performed using EUV light in the step (IV-5).

14. A patterning process for forming a tone-reversal pattern in a substrate to be processed, comprising steps of:
(V-1) forming a resist underlayer film on the substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film using a photoresist material;
(V-4) forming a pattern in the resist upper layer film by developing the resist upper layer film using a developer after pattern exposure;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the composition for forming a metal-containing film according to any one of claims 1 to 9 on the resist underlayer film having the formed pattern, and thereafter performing heat treatment to cover with the metal-containing film and fill an in-between space in the pattern of the resist underlayer film with the metal-containing film;
(V-8) etching back the metal-containing film covering over the resist underlayer film having the formed pattern by a chemical stripper or dry etching to expose an upper surface of the resist underlayer film having the formed pattern;
(V-9) removing the resist middle layer film or the hard mask middle layer film remaining on the upper surface of the resist underlayer film by dry etching;
(V-10) removing the resist underlayer film having the formed pattern with its surface exposed by dry etching to form a reverse pattern of an original pattern, the reverse pattern being formed of the metal-containing film; and
(V-11) processing the substrate to be processed while using the metal-containing film having the formed reverse pattern as a mask to form the reverse pattern in the substrate to be processed, preferably,
wherein the pattern exposure is performed using EUV light in the step (V-4).
